(19) Europäisches Patentamt
European Patent Office
Office européen des brevets

(11) EP 4 393 720 A1

(12) **EUROPEAN PATENT APPLICATION**

(43) Date of publication:
**03.07.2024 Bulletin 2024/27**

(21) Application number: **22307068.1**

(22) Date of filing: **30.12.2022**

(51) International Patent Classification (IPC):
***B41M 7/00*** *(2006.01)* ***C08F 2/00*** *(2006.01)*
***C08K 5/00*** *(2006.01)* ***C09D 11/38*** *(2014.01)*
***G03F 7/00*** *(2006.01)* ***C07F 9/53*** *(2006.01)*
***C07F 9/6509*** *(2006.01)* ***C07F 9/6533*** *(2006.01)*

(52) Cooperative Patent Classification (CPC):
**C07F 9/5337; C07F 9/650952; C07F 9/6533; C08F 2/50; C08K 5/00; C09D 11/101; C09D 11/38; G03F 7/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ARKEMA FRANCE**
**92700 Colombes (FR)**

(72) Inventors:
- **JEPSON, David**
  **WETHERBY (GB)**
- **SQUIRES, Kelly**
  **WETHERBY (GB)**
- **SEHNAL, Petr**
  **WETHERBY (GB)**
- **PLENDERLEITH, Richard**
  **WETHERBY (GB)**
- **LIU, Sen**
  **WETHERBY (GB)**
- **QUEK, Sophie**
  **WETHERBY (GB)**
- **REN, Kangtai**
  **EXTON (US)**
- **MACNEILL, Christopher**
  **EXTON (US)**
- **CALDERLEY, Nicholas**
  **WETHERBY (GB)**

(74) Representative: **Arkema Patent**
**Arkema France**
**DRD-DPI**
**420, rue d'Estienne d'Orves**
**92705 Colombes Cedex (FR)**

# (54) PHOSPHINE OXIDE-BASED PHOTOINITIATORS

(57) The present invention relates to a phosphine oxide-based photoinitiator, to a process for preparing said photoinitiator and to a precursor that may be used to prepare said photoinitiator. The present invention further relates to a photoinitiator composition, to a curable composition, to a process for the preparation of a cured product, to a process of inkjet printing, to a process of 3D printing and to a process for coating a nail. The invention also relates to precursors of the photoinitiator or the photoinitiator composition. The invention also relates to the use of the photoinitiator or the photoinitiator composition.

EP 4 393 720 A1

## Description

### TECHNICAL FIELD

The present invention relates to a phosphine oxide-based photoinitiator, to a process for preparing said photoinitiator and to a precursor that may be used to prepare said photoinitiator. The present invention further relates to a photoinitiator composition, to a curable composition, to a process for the preparation of a cured product, to a process of inkjet printing, to a process of 3D printing and to a process for coating a nail. The invention also relates to precursors of the photoinitiator or the photoinitiator composition. The invention also relates to the use of the photoinitiator or the photoinitiator composition.

### TECHNICAL BACKGROUND

Radiation curable compositions containing ethylenically unsaturated compounds can be polymerized by exposure to radiation, such as ultraviolet (UV) light. For rapid and effective curing, a photoinitiator is often used. The photoinitiator forms radical species upon irradiation with photons and initiates free-radical polymerization of unsaturated groups, leading to hardening (curing) of the material.

Free radical photoinitiators can adopt two different modes of action, and are classified by mode of action as Norrish Type I and Norrish Type II Photoinitiators. Norrish Type I photoinitiators cleave upon exposure to radiation, producing radical species which are capable of initiating the polymerization of unsaturated compounds. Norrish Type II photoinitiators are compounds which do not fragment upon exposure to radiation and so will not typically initiate radical-chain polymerization unless a co-initiator is present. Upon exposure to radiation, interaction between the Type II photoinitiator and the co-initiator leads to the generation of radical species which can initiate the polymerization of UV-curable resins.

In the field of photocured 3D printing there is a growing predominance of printing equipment that use longer wavelength (above 385 nm) light sources to effect curing of the photoactive resin. In formulations designed for use on these printers, phosphine oxide derivatives such as acylphosphine oxides are the preferred class of photoinitiators because of their strong absorbance in the wavelength range of interest. Acylphosphine oxides are classified as Norrish Type I initiators and include the following compounds:

(a) Laromer 819 (also known as Irgacure, 819, Speedcure BPO, or BAPO, namely bis-(2,4,6-trimethylbenzoyl)phenyl phosphine oxide) which has the following structure:

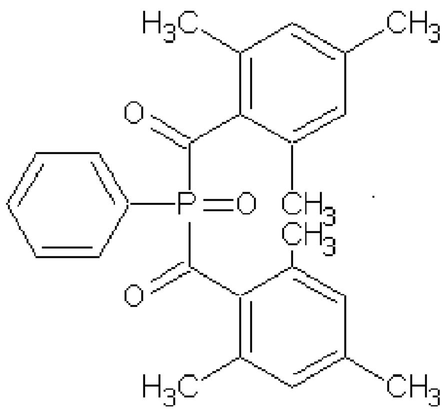

(b) Speedcure TPO (also known as 2,4,6- trimethylbenzoyl diphenyl phosphine oxide) which has the following structure:

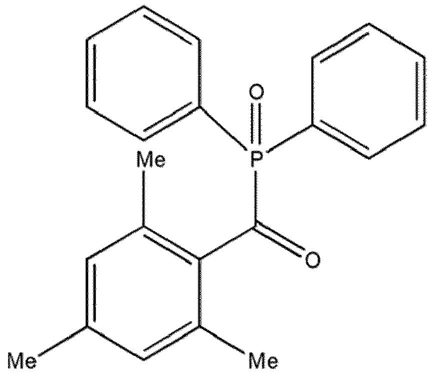

(c) Speedcure TPO-L (also known as Ethyl (2,4,6-trimethylbenzoyl)phenyl phosphinate) which has the following structure:

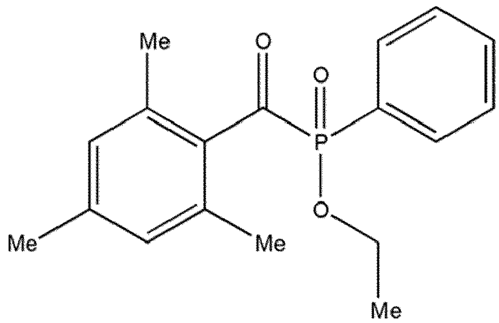

However, TPO has recently been classified as a Class 1B Reprotoxin based on new toxicology testing. This limits its use in many applications. TPO-L and BAPO are expected to be similarly re-classified.

In addition, mesitaldehyde (2,4,6-trimethylbenzaldehyde), which is a compound normally released from TPO under UV light, can migrate from the cured product and contaminate any adjacent materials. In the case of foodstuffs, migration of small molecule fragments can lead to problems with off-taste and odour. Furthermore, mesitaldehyde is classed as a skin irritant, so migration from cured articles may pose a health hazard. Low molecular-weight photoinitiators such as TPO, TPO-L and BPO may also migrate from the cured products and can also pose a hazard to health.

Biocompatible 3D-printing materials consumption is increasing due to a reduction in production time and formulation of specially designed goods. These materials are particularly sought for in new medical applications, such as implants, prosthesis, surgical guides, tissue engineered products, hearing aids, dental products as well as wearable devices (shoes, jewelry, ear buds and glasses). The development of FDA-approved 3D printing biomaterials and the creation of low-cost 3D printing materials are two major challenges facing the sector. Given that UV-curable 3D printing material will be in contact with human bodies, biocompatible resins must be subjected to biological evaluation and testing for cytotoxicity, genotoxicity, or delayed hypersensitivity, etc. The attention is mainly focused on developing UV curable resins to make 3D parts free of residual monomers or low molecular weight additives in order to meet health and safety standards, create durable and high performance of biomedical devices without fear of toxicity or side effects.

3D printers equipped with longer wavelength irradiation, such as LED lamps, are tremendously growing for reasons of high penetration depth of the UV-A LED light, lower biohazard, and cost efficiency. Acylphosphine oxides have a red shift of the absorption band from 350~420nm and are thus efficient photoinitiators for many LED light emission ranges. Unfortunately, acylphosphine oxides of low molecular weight can lead to undesirable residues and photoproducts (such as mesitaldehyde) and will be prone to migration through cured 3D parts to the surface. High molecular weight polymeric photoinitiators thus appear more advantageous as they do not generate small molecular photoproducts and hence pose less toxicological concern.

Document EP 3378875 relates to a photopolymerization initiator which is a compound having a structure in which one or more carbonyl groups that link to a carbon atom are further directly bonded to an aromatic ring of an aromatic acyl group that bonds to a phosphorus atom in an acylphosphine oxide structure.

Document US 10590264 discloses a photopolymerization initiator which is an acyl phosphine oxide.

EP3149013 discloses multifunctional mono- and bis-acyl phosphine oxides which are useful as photoinitiators, and to photocurable compositions.

There is thus a need for cost effective and efficient photoinitiators for the manufacture of radiation curable

adhesives and coating formulations, that present high curing activity, lower toxicity and reduced migration from coated articles.

The present invention enables to meet the abovementioned need. In particular the invention provides cost effective and efficient photoinitiators for the manufacture of curable compositions, that present high curing activity, lower toxicity and reduced migration from coated articles.

This is achieved by the (phosphine oxide-based) photoinitiator according to the present invention.

The photoinitiator according to the invention may advantageously have a high molecular weight (i.e. a molecular weight of greater than 500 Daltons) and hence exhibit a lower tendency to migrate and lower bioavailability (reduced propensity to be absorbed through the skin or through the gastrointestinal tract) compared to smaller molecules such as TPO, TPO-L and BPO.

Accordingly, such photoinitiators may mimic the good curing properties of the classic TPO/BPO initiators with reduced toxicity issues.

Finally, the photoinitiator according to the present invention may be prepared from inexpensive and readily-available materials, which makes it possible to obtain such initiators in a cost-effective manner.

## SUMMARY OF THE INVENTION

It is a first object of the invention to provide a photoinitiator according to formula (1) or (2):

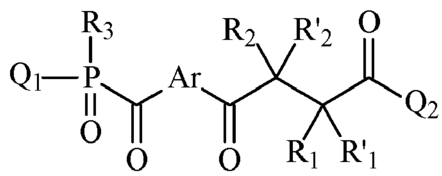

(1)

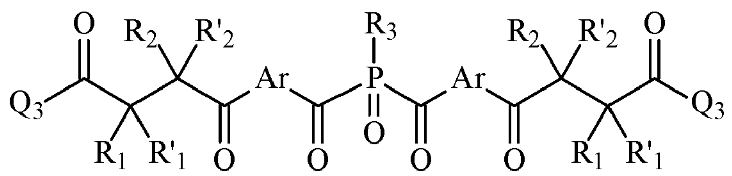

(2)

wherein Ar, $R_1$, $R'_1$, $R_2$, $R'_2$, $R_3$, $Q_1$, $Q_2$, $Q_3$, $Q_4$ are as defined herein.

The invention further relates to a process for the preparation of a photoinitiator of formula (1) or (2) according to the invention, wherein the process comprises reacting at least one precursor of formula (30) or (31) with at least one product of formula (32):

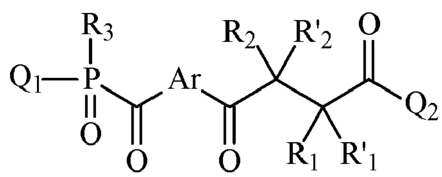

(1)

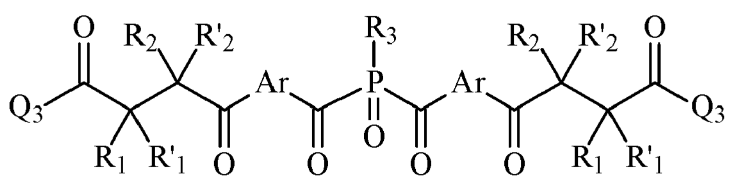

(2)

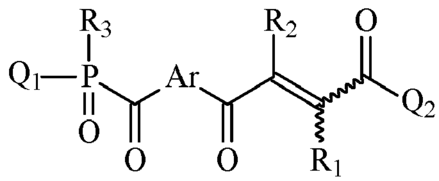

(30)

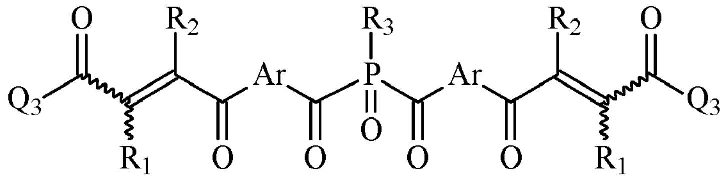

(31)

$R'_1$-$R'_2$ (32)

wherein Ar, $R_1$, $R_2$, $R_3$, $R'_1$, $R'_2$, $Q_1$, $Q_2$ and $Q_3$ are as defined herein.

The invention further relates to a precursor of formula (30) or (31):

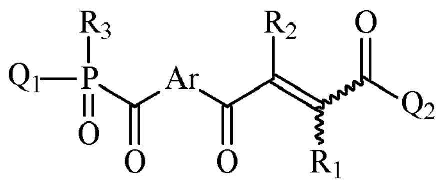

(30)

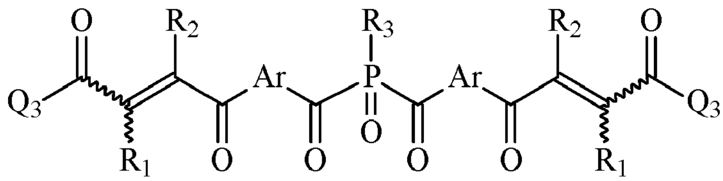

(31)

wherein Ar, $R_1$, $R_2$, $R_3$, $Q_1$, $Q_2$ and $Q_3$ are as defined herein.

The invention further relates to a process for the preparation of a precursor of formula (30) or (31) according to the invention, wherein the process comprises reacting at least one precursor of formula (33) or (34) with at least one compound of formula (35) to (42):

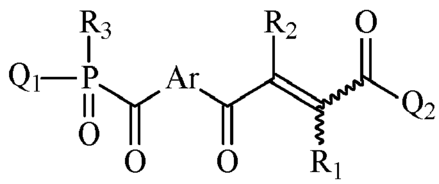

(30)

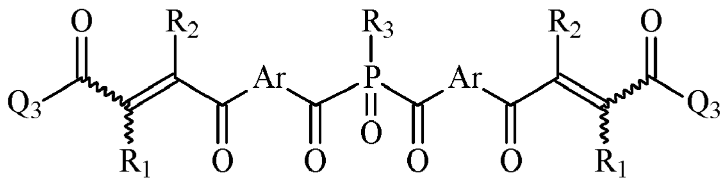

(31)

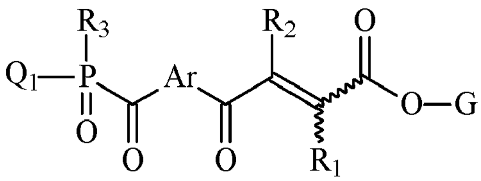

(33)

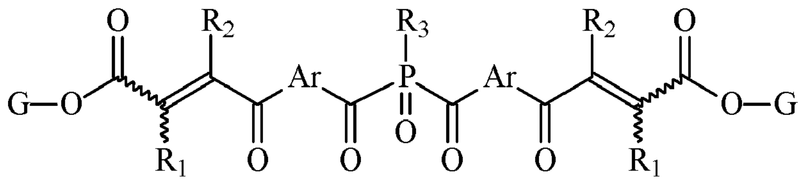

(34)

$R^{14}$-OH (35)

$R^{15}$-SH (36)

$NHR^{16}R^{17}$ (37)

$Z^{1a}$-OH (38)

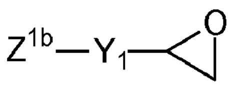

(39)

$Z^2$-SH (40)

$Z^3$-NH($R^{18}$) (41)

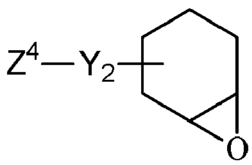

(42)

wherein Ar, $R_1$, $R_2$, $R_3$, $Q_1$, $Y_1$, $Y_2$, G, $R^{14}$, $R^{15}$, $R^{16}$, $R^{17}$, $Z^{1a}$, $Z^{1b}$, $Z^2$, $Z^3$ and $Z^4$ are as defined herein.

The invention further relates a precursor of formula (33) or (34)

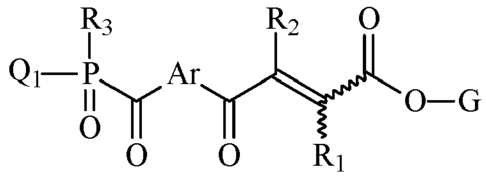

(33)

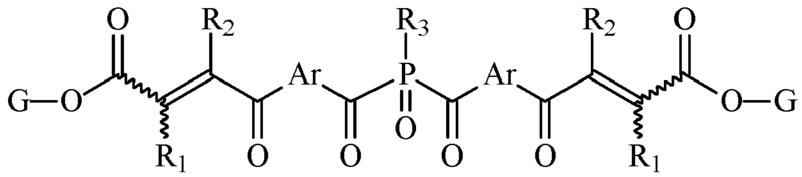

(34)

wherein Ar, $R_1$, $R_2$, $R_3$, $Q_1$ ,and G are as defined herein.

The invention further relates to a process for the preparation of a precursor of formula (33) or (34) according to the invention, wherein the process comprises reacting at least one phosphine oxide of formula (48) or (49) with at least one cyclic anhydride of formula (50) to provide a precursor according to formula (33) or (34) wherein G is H:

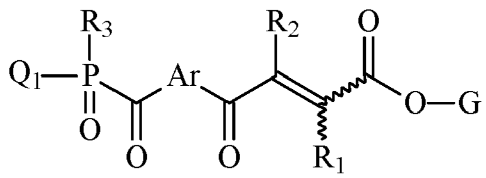

(33)

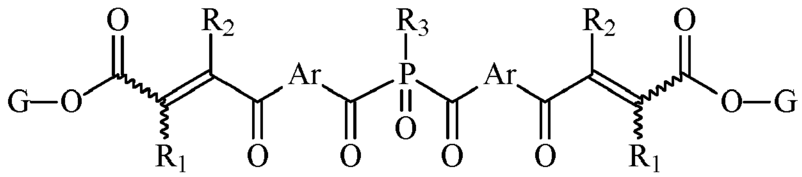

(34)

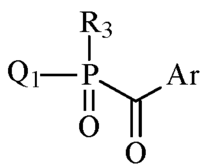

(48)

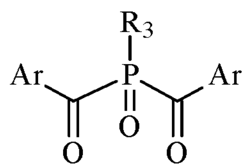

(49)

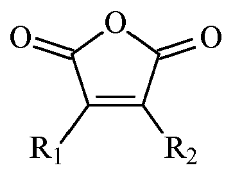

(50)

wherein Ar, $R_1$, $R_2$, $R_3$, $Q_1$ are as defined herein; the process optionally comprising an additional step of:

- reacting the precursor according to formula (33) or (34) wherein G is H with an acyl halide of formula (51) to provide a precursor according to formula (33) or (34) wherein G is -C(=O)-J

Hal-C(=O)-J (51)

wherein Hal and J are as defined herein; or

- reacting the precursor according to formula (33) or (34) wherein G is H with a halogenating agent, in particular

thionyl chloride, to provide a precursor according to formula (33) or (34) wherein G is a halogen atom.

The invention further relates to a process for the preparation of a photoinitiator of formula (1) or (2) according to the invention, wherein the process comprises reacting at least one precursor of formula (52) or (53) with at least one compound of formula (35) to (42):

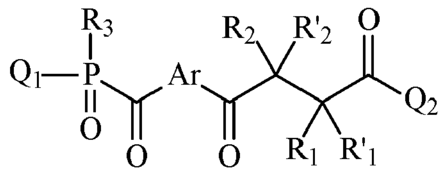

(1)

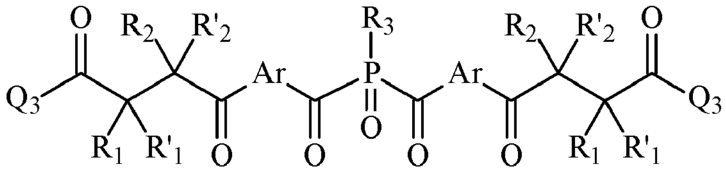

(2)

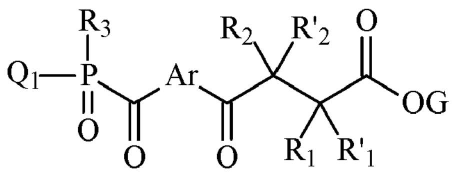

(52)

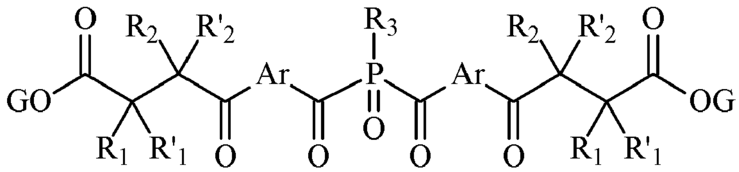

(53)

$R^{14}$-OH (35)

$R^{15}$-SH (36)

$NHR^{16}R^{17}$ (37)

$Z^{1a}$-OH (38)

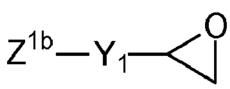

(39)

$Z^{2}$-SH (40)

$Z^{3}$-NH($R^{18}$) (41)

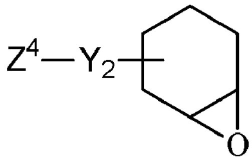

(42)

wherein Ar, $R_1$, $R_2$, $R_3$, $R'_1$, $R'_2$, $Q_1$, $Y_1$, $Y_2$, G, $R^{14}$, $R^{15}$, $R^{16}$, $R^{17}$, $Z^{1a}$, $Z^{1b}$, $Z^2$, $Z^3$ and $Z^4$ are as defined herein.

The invention further relates to a precursor of formula (52) or (53):

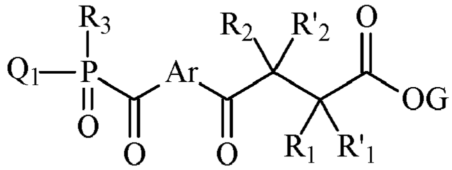

(52)

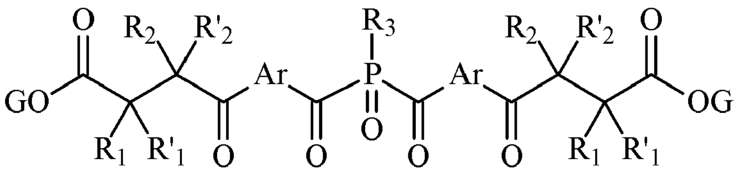

(53)

wherein Ar, $R_1$, $R_2$, $R_3$, $R'_1$, $R'_2$, $Q_1$ and G are as defined herein.

The invention further relates to a process for the preparation of a precursor of formula (52) or (53) according to the invention, wherein the process comprises reacting at least one precursor of formula (33) or (34) with at least one product of formula (32) to provide a precursor of formula (52) or (53) wherein G is H:

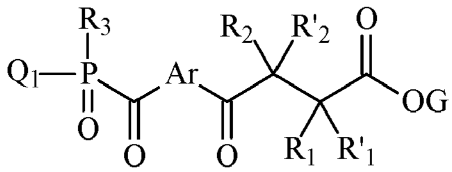

(52)

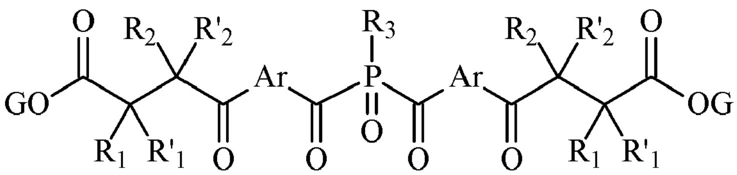

(53)

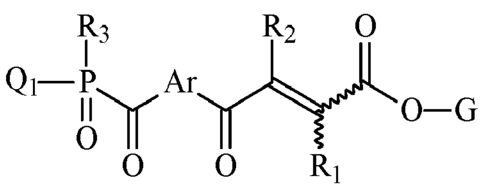

(33)

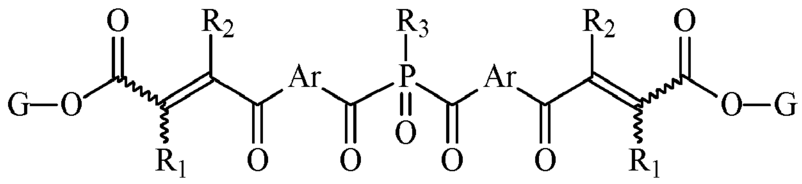

(34)

$R'_1-R'_2$ (32)

wherein Ar, $R_1$, $R_2$, $R_3$, $R'_1$, $R'_2$, $Q_1$ and G are as defined herein; the process optionally comprising an additional step of:

- reacting the precursor according to formula (52) or (53) wherein G is H with an acyl halide of formula (51) to provide a precursor according to formula (52) or (53) wherein G is -C(=O)-J

  Hal-C(=O)-J (51)

  wherein Hal is a halogen atom and J is alkyl or aryl, in particular tert-butyl; or
- reacting the precursor according to formula (52) or (53) wherein G is H with a halogenating agent, in particular thionyl chloride, to provide a precursor according to formula (52) or (53) wherein G is a halogen atom.

The invention further relates to a process for the preparation of a photoinitiator of formula (5) or (6) according to the invention, wherein the process comprises reacting at least one precursor of formula (33) or (34) with at least one product of formula (54):

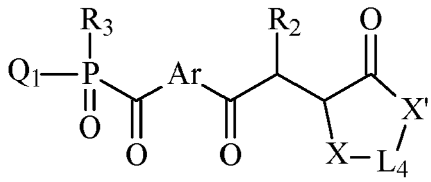

(5)

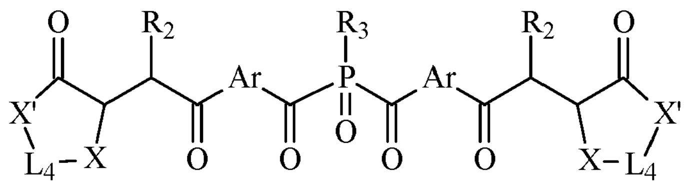

(6)

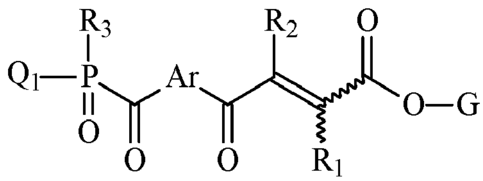

(33)

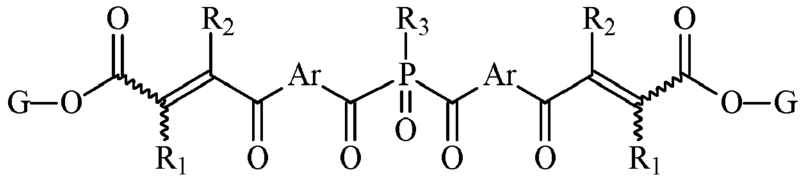

(34)

$HX-L_4-X'H$ (54)

wherein Ar, $R_1$, $R_2$, $R_3$, $Q_1$, G, X, X' and $L_4$ are as defined herein.

The invention further relates to a photoinitiator composition comprising:

- a mixture of at least two photoinitiators of formula (1) according to the invention;
- a mixture of at least two photoinitiators of formula (2) according to the invention;
- a mixture of at least one photoinitiator of formula (1) according to the invention and at least one precursor of formula (30) according to the invention; or
- a mixture of at least one photoinitiator of formula (2) according to the invention and at least one precursor of formula (31) according to the invention.

The invention further relates to a photoinitiator composition comprising a photoinitiator of formula (1) or (2) according to the invention and a photoinitiator other than a photoinitiator of formula (1) or (2), in particular a photoinitiator selected from SpeedCure® MBF (methyl benzoylformate), SpeedCure® 73 (2-hydroxy-2-methyl-1-phenylpropanone), SpeedCure® 7005 (polymeric benzophenone).

The invention further relates to a process for photopolymerizing one or more ethylenically unsaturated compounds comprising contacting one or more ethylenically unsaturated compounds with a photoinitiator of formula (1) or (2) according to the invention or a photoinitiator composition according to the invention, and irradiating the mixture, in particular with UV, near-UV, visible, infrared and/or near-infrared radiation.

The invention further relates to a curable composition comprising:

a) a photoinitiator of formula (1) or (2) according to the invention or a photoinitiator composition according to the invention; and
b) an ethylenically unsaturated compound.

The invention further relates to a process for the preparation of a cured product, comprising curing the curable composition according to the invention, preferably by exposing the curable composition to radiation such as UV, near-UV, visible, infrared and/or near-infrared radiation.

The invention further relates to a process of 3D printing comprising printing a 3D article with the composition according to the invention, in particular layer by layer or continuously.

The invention further relates to a process of inkjet printing comprising jetting the curable composition according to the invention onto a substrate.

The invention further relates to a process of coating a nail, wherein the process comprises applying the composition according to the invention on a nail, and curing the composition on the nail.

The invention further relates to a use of a photoinitiator of formula (1) or (2) according to the invention or a photoinitiator composition according to the invention, as a photoinitiator or a photoinitiating system in a radiation curable composition, preferably in a UV or LED-curable composition.

The invention further relates to a use of a photoinitiator of formula (1) or (2) according to the invention or a photoinitiator composition according to the invention, to cure one or more ethylenically unsaturated compounds.

The invention further relates to a use of a photoinitiator of formula (1) or (2) according to the invention or a photoinitiator composition according to the invention, to obtain a cured product having a reduced amount of extractables.

## DETAILED DESCRIPTION

The invention will now be described in more detail without limitation in the following description.

### Definitions

The term *"alkyl"* means a monovalent saturated alicyclic hydrocarbon group of formula $-C_nH_{2n+1}$ wherein n is 1 to 20. An alkyl may be linear or branched. Examples of alkyl groups include methyl, ethyl, propyl, isopropyl, butyl, isobutyl, tert-butyl, pentyl, hexyl, 2-methylbutyl, 2,2-dimethylpropyl, n-hexyl, 2-methylpentyl, 2,2-dimethylbutyl, n-heptyl, 2-ethylhexyl, and the like.

The term "*aryl*" means an optionally substituted polyunsaturated aromatic group. The aryl may contain a single ring (i.e. phenyl) or more than one ring wherein at least one ring is aromatic. When the aryl comprises more than one more ring, the rings may be fused, linked via a covalent bond (for example biphenyl). The aromatic ring may optionally comprise one to two additional fused rings (i.e. cycloalkyl, heterocycloalkyl or heteroaryl). The term *"aryl"* also encompasses partially hydrogenated derivatives of the carbocyclic system is described above. Examples include phenyl, naphtyl, biphenyl, phenanthrenyl and naphthacenyl.

The term *"arylene"* means a substituent that derives from an aromatic hydrocarbon (arene) and is bivalent.

The term *"halogen"* means an atom selected from C!, Br, F and I.

The term *"cycloalkyl"* means a monovalent saturated alicyclic hydrocarbon group comprising a cycle. Examples of cycloalkyl groups include cyclopentyl, cyclohexyl and isobornyl.

The term *"heterocycloalkyl"* means a cycloalkyl having at least one ring atom that is a heteroatom selected from O, N or S.

The term *"alkoxy"* means a group of formula -O-alkyl, wherein the alkyl is as defined above.

The term *"aryloxy"* means a group of formula -O-aryl, wherein the aryl is as defined above.

The term *"thioalkyl"* means a group of formula -S-alkyl, wherein the alkyl is as defined above.

The term *"thioaryl"* means a group of formula -S-aryl, wherein the aryl is as defined above.

The term *"linker"* means a plurivalent group. A linker may connect at least two moieties of a compound together, in particular 2 to 16 moieties of a compound together. For example, a linker that connects two moieties of a compound together is referred to as a divalent linker, a linker that connects three moieties of a compound together is referred to as a trivalent linker, etc....

The term *"hydrocarbon linker"* means a linker having a carbon backbone chain which may optionally be interrupted by one or more heteroatoms selected from N, O, S, Si and mixtures thereof. A hydrocarbon linker may be aliphatic, cycloaliphatic or aromatic. A hydrocarbon linker may be saturated or unsaturated. A hydrocarbon linker may be optionally substituted.

The term *"aliphatic"* means a non-aromatic acyclic compound. It may be linear or branched, saturated or unsaturated. It may be substituted by one or more groups, for example selected from alkyl, hydroxyl, halogen (Br, Cl, I, F), isocyanate, carbonyl, amine, carboxylic acid, -C(=O)-OR', -C(=O)-O-C(=O)-R', each R' being independently a $C_1$-$C_6$ alkyl. It may comprise one or more bonds selected from ether, ester, amide, urethane, urea and mixtures thereof.

The term *"acyclic"* means a compound that does not comprise any rings.

The term *"cycloaliphatic"* means a non-aromatic cyclic compound. It may be substituted by one or more groups as defined for the term *"aliphatic".* It may comprise one or more bonds as defined for the term *"aliphatic".*

The term *"aromatic"* means a compound comprising an aromatic ring, which means that respects Hückel's aromaticity rule, in particular a compound comprising a phenyl group. It may be substituted by one or more groups as defined for the term *"aliphatic".* It may comprise one or more bonds as defined for the term *"aliphatic".*

The term *"saturated"* means a compound that does not comprise any double or triple carbon-carbon bonds.

The term *"unsaturated"* means a compound that comprises a double or triple carbon-carbon bond, in particular a double carbon-carbon bond.

The term *"polyether polyol"* or *"polyether linker"* means a polyol (in other words a compound comprising at least two hydroxyl groups), respectively a linker, comprising at least two ether bonds.

The term *"polyester polyol"* or *"polyester linker"* means a polyol, respectively a linker, comprising at least two ester bonds.

The term *"polycarbonate polyol"* or *"polycarbonate linker"* means a polyol, respectively a linker, comprising at least two carbonate bonds.

The term *"polyurethane linker"* means a linker comprising at least two urethane bonds.

The term *"polyorganosiloxane polyol"* or *"polyorganosiloxane linker"* means a polyol, respectively a linker, comprising at least two organosiloxane bonds. The organosiloxane may, for example be a dimethylsiloxane bond.

The term *"polycaprolactone polyol"* or *"polycaprolactone linker"* means a polyol, respectively a linker, comprising at least two units derived from the ring-opening polymerization of ε-caprolactone, in particular at least two $-[(CH_2)_5-C(=O)O]-$ units.

The term *"polybutadiene polyol"* or *"polybutadiene linker"* means a polyol, respectively a linker, comprising at least two units derived from the polymerization of butadiene, in particular at least two units selected from $-CH_2-CH=CH-CH_2-$ and $CH_2-CH(CH=CH_2)-$.

The term *"isocyanate group"* means a -N=C=O group.

The term *"isocyanurate linker"* means a linker comprising an isocyanurate moiety, in particular a moiety of formula:

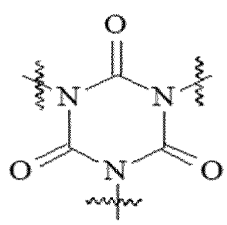

**Photoinitiator of formula (1) or (2)**

The present invention relates to a photoinitiator. The photoinitiator is according to the following formula (1) or (2):

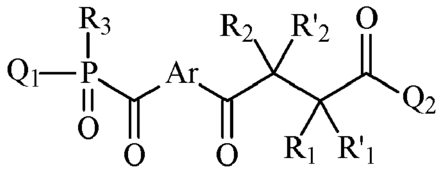

(1)

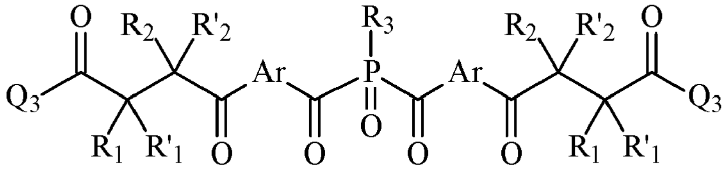

(2)

wherein Ar, $R_1$, $R'_1$, $R_2$, $R'_2$, $R_3$, $Q_1$, $Q_2$, $Q_3$, $Q_4$ are as defined herein.

In formula (1) and (2), each Ar is independently an optionally substituted arylene. In particular, each Ar may independently be an optionally substituted phenylene. The phenylene may be an ortho-phenylene, a meta-phenylene or a para-phenylene (substituted or not). The ortho, meta and para position refer to the position of the radicals of the bivalent phenylene. Preferably, each Ar may independently be a meta-phenylene substituted by one or more optionally substituted groups selected from alkyl, aryl, alkoxy, aryloxy, thioalkyl and thioaryl. More preferably, each Ar is a group of formula (4):

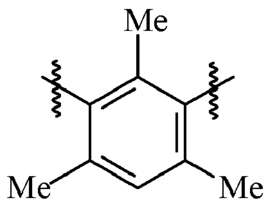

(4).

In formula (1) and (2), $R_1$ and $R_2$ are independently H or an optionally substituted group selected from alkyl and aryl; or $R_1$ and $R_2$, together with the carbon atoms to which they are attached, form a ring. Such ring may be chosen from 5-8-membered ring, for example a 5-membered ring, a 6-membered ring, a 7-membered ring, or an 8-membered ring, and may preferably be a 6-membered ring. Such ring (preferably 6-membered) is preferably a cycloaliphatic ring. In particular, $R_1$ and $R_2$ may both be H or $R_1$ and $R_2$, together with the carbon atoms to which they are attached, may form a six-membered ring, preferably a six-membered cycloaliphatic ring. Preferably, $R_1$ and $R_2$ are both H.

In formula (1) and (2), one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-W^2-R^{10})$, $-C(R^{11})(CO-W^3-R^{12})(CN)$ and $-C(R^{13})(CN)_2$; or $R'_2$ is H and $R'_1$ and $Q_2$, together with the atoms to which they are attached, form a 5-7 membered ring; or $R'_2$ is H and $R'_1$ and $Q_3$, together with the atoms to which they are attached, form a 5-8 membered ring;
wherein:

- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom.

In one embodiment, one of $R'_1$ and $R'_2$ is H and the other of $R'_1$ and $R'_2$ is $-OR^4$. In such a case, $R^4$ is preferably

an optionally substituted alkyl.

In another embodiment, one of $R'_1$ and $R'_2$ is H and the other of $R'_1$ and $R'_2$ is $-SR^5$. In such a case, $R^5$ is preferably an optionally substituted alkyl.

In another embodiment, one of $R'_1$ and $R'_2$ is H and the other of $R'_1$ and $R'_2$ is $-NR^6R^7$. In such a case, $R^6$ and $R^7$, together with the nitrogen atom to which they are attached, preferably form a 5-7 membered ring; more preferably an optionally substituted ring selected from morpholine, piperidine, pyrrolidine, oxazolidine, piperazine, thiazolidine, thiomorpholine and azepane.

In another embodiment, one of $R'_1$ and $R'_2$ is H and the other of $R'_1$ and $R'_2$ is $-C(R^8)(CO-W^1-R^9)(CO-W^2-R^{10})$. In such a case, $R^8$, $R^9$, $R^{10}$, $W^1$ and $W^2$ are preferably as defined below:

- $R^8$ is H;
- $W^1$ and $W^2$ are independently a bond or an oxygen atom; and
- $R^9$ and $R^{10}$ are independently an optionally substituted alkyl.

In another embodiment, $R'_2$ is H and $R'_1$ forms a 5-8 membered ring with $Q_2$ or $Q_3$. In such a case, the photoinitiator is preferably according to formula (5) or (6)

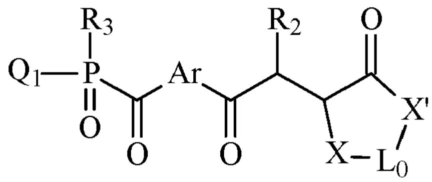

(5)

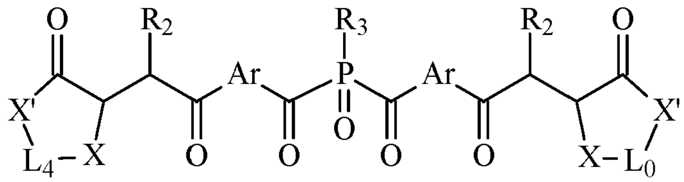

(6)

wherein:

- X and X' are independently selected from O, S and $NR^{19}$;
- $R^{19}$ is H or an optionally substituted alkyl;
- $L_0$ is an optionally substituted C1-C4 alkylene.

In formula (1) and (2), each $R_3$ is independently an optionally substituted group selected from alkyl, aryl and alkoxy. In particular, each $R_3$ may independently be an optionally substituted phenyl, methoxy or ethoxy. Preferably, each $R_3$ is independently phenyl or ethoxy.

In formula (1) and (2), $Q_1$ is an optionally substituted aryl or a group of formula (3):

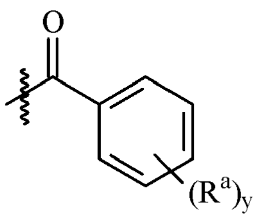

(3)

wherein:

- each $R^a$ is independently an optionally substituted group selected from alkyl, aryl, alkoxy, aryloxy, thioalkyl and thioaryl; and
- y is a number chosen from 0 to 5.

In one embodiment, $Q_1$ may be an unsubstituted aryl such as phenyl.

In another embodiment, $Q_1$ may be a group of formula (3) bearing from 1 to 5, preferably from 2 to 4, substituents $R^a$ as detailed above. Preferably such substituent(s) is (are) methyl group(s).

According to a preferred embodiment, $Q_1$ may be phenyl or a group of formula (3a):

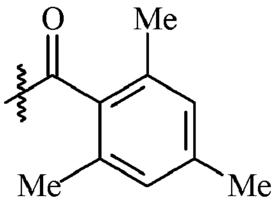

(3a).

In formula (1) and (2), $Q_2$ and $Q_3$ are independently $-OR^{14}$, $-SR^{15}$, $-NR^{16}R^{17}$, $-O-[CH_2-CH(OH)-Y_1]_a-Z^1$, $-S-Z^2$, $-N(R^{18})-Z^3$ or $-O-Cyhex-Y_2-Z^4$; or $Q_2$ and $R'_1$, together with the atoms to which they are attached, form a 5-7 membered ring; or $Q_3$ and $R'_1$, together with the atoms to which they are attached, form a 5-7 membered ring;
wherein:

- $R^{14}$ and $R^{15}$ are independently H or an optionally substituted group selected from alkyl, cycloalkyl, heterocycloalkyl, aryl and heteroaryl;
- $R^{16}$, $R^{17}$ and $R^{18}$ are independently H, or an optionally substituted group selected from alkyl and aryl; or $R^{16}$ and $R^{17}$, together with the nitrogen atom to which they are attached, form a 5-7 membered ring;
- Cyhex is a cycloyhexylene substituted by a hydroxyl group, preferably represented by the following formula:

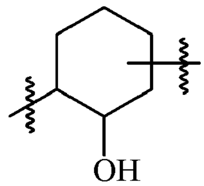

- $Y_1$ is a bond, $-CH_2-O-*$ or $-CH_2-C(=O)-O-*$;
- $Y_2$ is a bond, $-CH_2-O-C(=O))-^{\#}$ or $-C(=O)-O-^{\#}$;
- a is 0 or 1;
- $Z^1$, $Z^2$, $Z^3$ and $Z^4$ are independently a phosphine oxide-containing moiety;
- the symbol * represents a point of attachment to moiety $Z^1$;
- the symbol # represents a point of attachment to moiety $Z^4$.

In one embodiment, $Q_2$ and $Q_3$ are independently $-OR^{14}$. In such a case, $R^{14}$ is preferably an optionally substituted alkyl, more preferably methyl or ethyl.

In another embodiment, $Q_2$ and $Q_3$ are independently $-O-[CH_2-CH(OH)-Y_1]_a-Z^1$. In such a case $Z^1$ is preferably a group of formula (7);

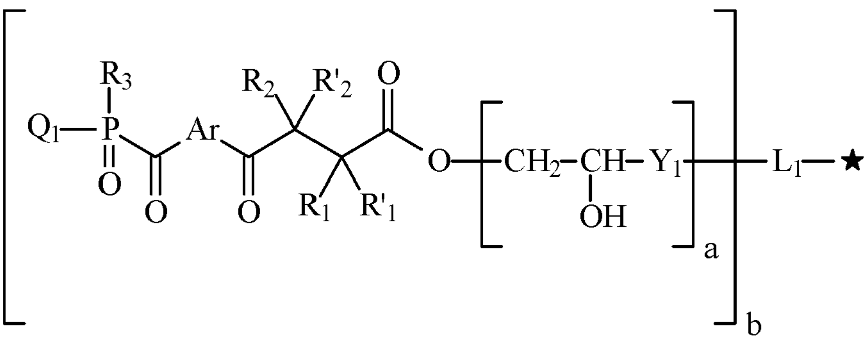

(7)

wherein:

- Ar, $Y_1$, $R_1$, $R_2$, $R'_1$, $R'_2$, $R_3$, $Q_1$ and a are as defined above;
- $L_1$ is a linker; and
- b is a number chosen from 1 to 15 in particular from 1 to 5, more particularly from 1 to 3.

In formula (7), a may be equal to 0. Alternatively, in formula (7), a may be equal to 1 and $Y_1$ is preferably a bond or $-CH_2-O-*$, more preferably $-CH_2-O-*$.

In another embodiment, $Q_2$ and $Q_3$ are independently $-SR^{15}$. In such a case, $R^{15}$ is preferably an optionally substituted alkyl.

In another embodiment, $Q_2$ and $Q_3$ are independently $-S-Z^2$. In such a case, $Z^2$ is preferably a group of formula (8):

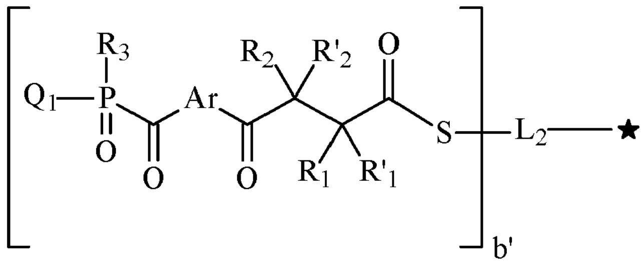

(8)

wherein:

- Ar, $R_1$, $R_2$, $R'_1$, $R'_2$, $R_3$, and $Q_1$ are as defined above;
- $L_2$ is a linker; and
- b' is a number chosen from 1 to 15, in particular from 1 to 5, more particularly from 1 to 3.

In another embodiment, $Q_2$ and $Q_3$ are independently $-NR^{16}R^{17}$. In such a case, $R^{16}$ and $R^{17}$ are preferably independently selected from H or an optionally substituted group selected from alkyl and aryl. Alternatively, $R^{16}$ and $R^{17}$, together with the nitrogen atom to which they are attached, may form a 5-7 membered ring.

In another embodiment, $Q_2$ and $Q_3$ are independently $-N(R^{18})-Z$. In such a case, $R^{18}$ is preferably H or an optionally substituted group selected from alkyl and aryl; and $Z^3$ is preferably a group of formula (9):

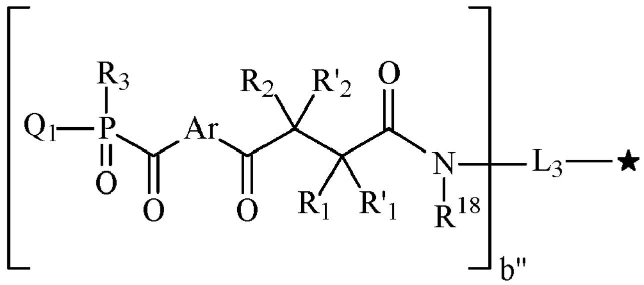

(9)

wherein:

- Ar, $R_1$, $R_2$, $R'_1$, $R'_2$, $R_3$, $R^{18}$ and $Q_1$ are as defined above;
- $L_3$ is a linker; and
- b" is a number chosen from 1 to 15, in particular from 1 to 5, more particularly from 1 to 3.

In another embodiment, $Q_2$ and $Q_3$ are independently $-O-Cyhex-Y_2-Z^4$. In such a case, $Z^4$ is preferably a group of formula (7) as defined above or a group of formula (10);

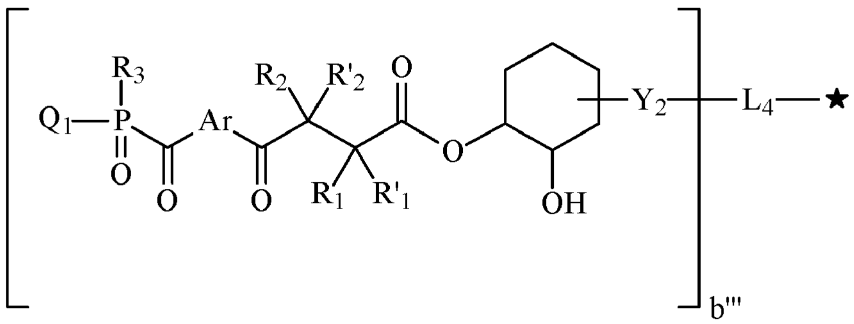

(10)

wherein :

- Ar, $Y_2$, $R_1$, $R_2$, $R'_1$, $R'_2$, $R_3$, $Q_1$ are as defined above;
- $L_4$ is a linker; and
- b‴ is a number chosen from 1 to 15, in particular from 1 to 5, more particularly from 1 to 3.

In formulae (7), (8), (9) and (10), each linker $L_1$, $L_2$, $L_3$ and $L_4$ may independently be a divalent, trivalent, tetravalent, pentavalent, hexavalent, heptavalent, octavalent, nonavalent, decavalent, undecavalent, dodecavalent, tridecavalent, tetradecavalent, pentadecavalent or hexadecavalent linker. More particularly, each linker $L_1$, $L_2$, $L_3$ and $L_4$ may independently be a divalent, trivalent, tetravalent, pentavalent or hexavalent linker. Even more particularly, each linker $L_1$, $L_2$, $L_3$ and $L_4$ may independently be a divalent, trivalent or tetravalent linker.

Each linker $L_1$, $L_2$, $L_3$ and $L_4$ may independently be selected from an aromatic linker, an aliphatic linker, a cycloaliphatic linker, a polyether linker, a polythioether linker, a polyalkylene imine linker, a polyester linker, a polycarbonate linker, a polycaprolactone linker, a polyurethane linker, a polyorganosiloxane linker, a polybutadiene linker, and combinations thereof. Preferably, each linker $L_1$, $L_2$, $L_3$ and $L_4$ is independently selected from an aromatic linker, an aliphatic linker, a cycloaliphatic linker, a polyether linker, a polythioether linker, a polyalkylene imine linker, a polyester linker and combinations thereof.

Each linker $L_1$, $L_2$, $L_3$ and $L_4$ may independently be selected from:

- a trivalent moiety corresponding to formula (11):

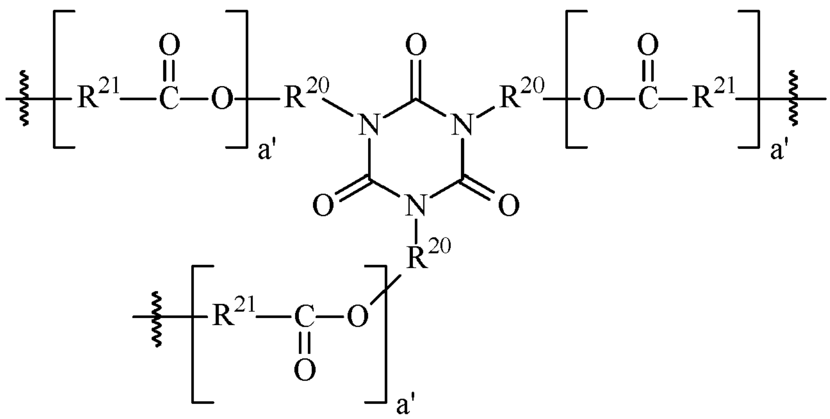

(11)

wherein:

- $R^{20}$ and $R^{21}$ are independently a linear or branched alkylene;
- a' is an integer equal to 0 or 1;

- a trivalent moiety corresponding to formula (12):

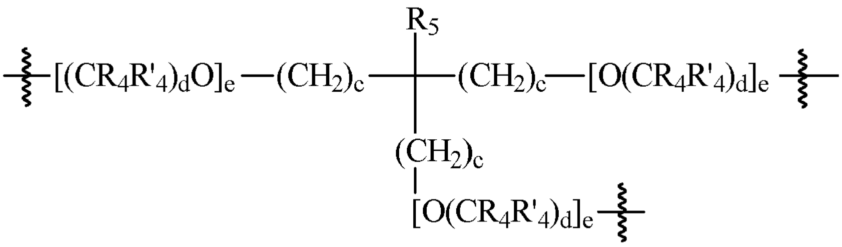

(12)

wherein:

- $R_4$ and $R'_4$ are independently H or methyl;
- $R_5$ is H, alkyl or alkoxy, preferably $R_5$ is alkyl;
- each c is independently an integer from 0 to 2 with the proviso that not more than one c is equal to 0, preferably each c is equal to 1 or one c is equal to 0 and the two other c are equal to 1;
- each d is independently an integer from 2 to 4, in particular 2;
- each e is independently an integer from 0 to 10, in particular from 1 to 6;

- a trivalent moiety according to formula (13):

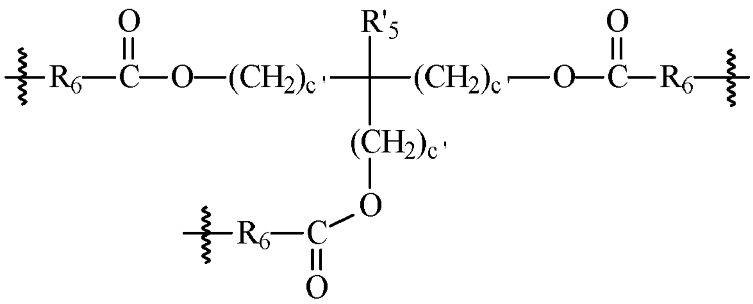

(13)

wherein :

- $R'_5$ is H, alkyl or alkoxy, preferably $R'_5$ is alkyl;
- each $R_6$ is independently a linear or branched alkylene;
- each c' is independently an integer from 0 to 2 with the proviso that not more than one c' is equal to 0, preferably each c' is equal to 1 or one c' is equal to 0 and the two other c' are equal to 1;

- a trivalent moiety according to formula (14a), (14b) or (14c):

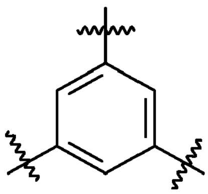

(14a)

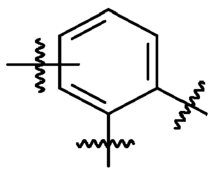

(14b)

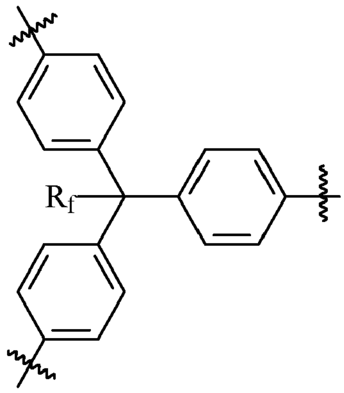

(14c)

wherein $R_f$ is H or methyl;

- a tetravalent moiety according to formula (15a) or (15b):

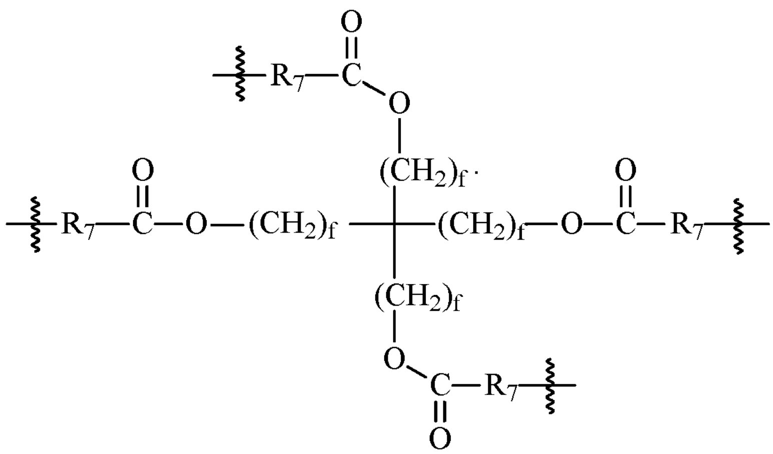

(15a)

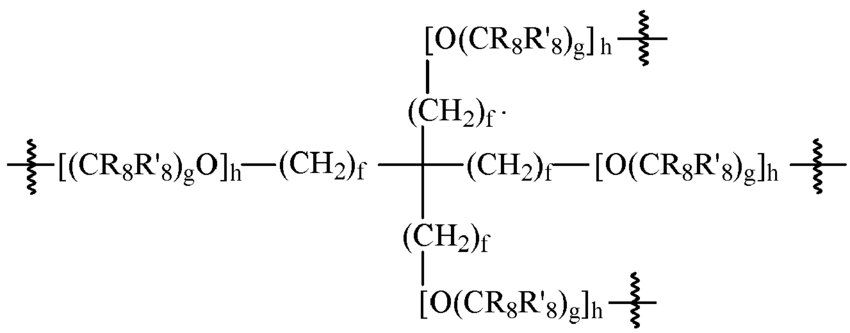

(15b)

wherein:

- each $R_7$ is independently a linear or branched alkylene;
- $R_8$ and $R'_8$ are independently H or methyl;
- each f is independently an integer from 0 to 2 with the proviso that not more than one f is equal to 0, preferably each f is equal to 1;
- each g is independently an integer from 2 to 4, in particular 2;
- each h is independently an integer from 0 to 10, in particular from 1 to 6;

- a tetravalent moiety according to formula (16):

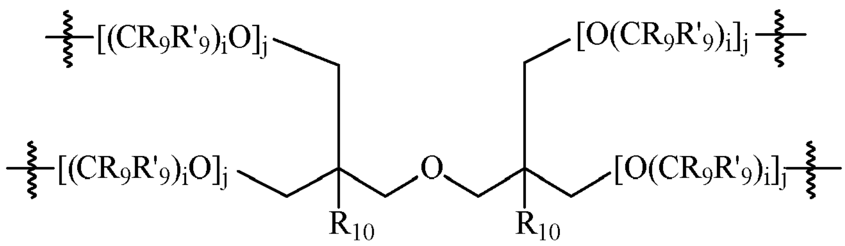

(16)

wherein

- $R_9$ and R’g are independently H or methyl;
- each $R_{10}$ is independently H, alkyl or alkoxy, preferably $R_{10}$ is alkyl;
- each i is independently an integer from 2 to 4, in particular 2;
- each j is independently an integer from 0 to 10, in particular from 1 to 6;

- a tetra-, penta- or hexavalent moiety according to formula (17):

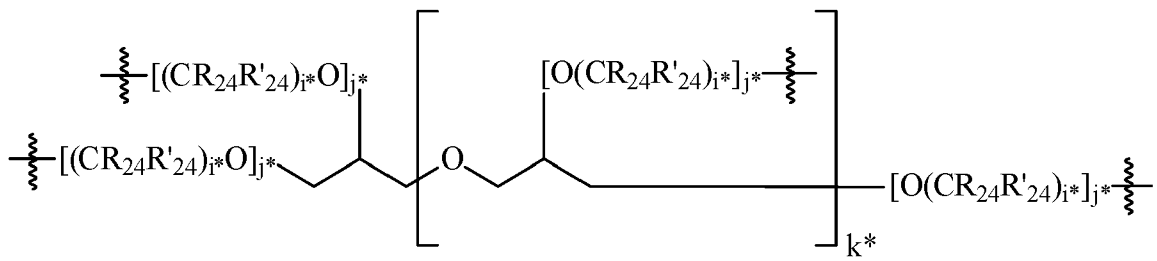

(17)

wherein:

- $R_{24}$ and $R'_{24}$ are independently H or methyl;
- each i* is independently an integer from 2 to 4, in particular 2;
- each j* is independently an integer from 0 to 10, in particular from 1 to 6;
- k’ is an integer from 1 to 3;

- a hexavalent moiety according to formula (18):

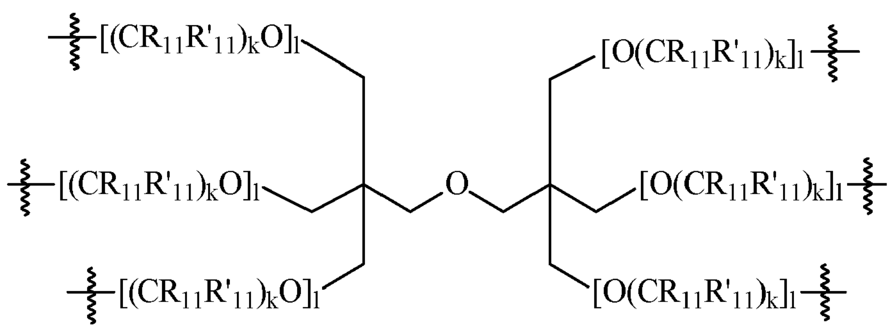

(18)

wherein

- $R_{11}$ and $R'_{11}$ are independently H or methyl;;
- each k is independently an integer from 2 to 4, in particular 2;
- each l is independently an integer from 0 to 10, in particular from 1 to 6;

- a hexavalent moiety according to formula (19):

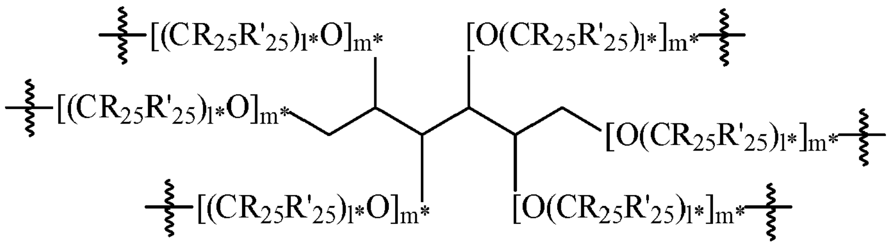

(19)

wherein:

- $R_{25}$ and $R'_{25}$ are independently H or methyl;
- each l* is independently an integer from 2 to 4, in particular 2;
- each m* is independently an integer from 0 to 10, in particular from 1 to 6;

- a divalent moiety according to one of formulae (20) to (28):

$-(CR_{12}R'_{12})_m-$ (20)

$-[(CR_{13}R'_{13})_n-O]_o-(CR_{13}R'_{13})_n-$ (21)

$-[(CR_{14}R'_{14})_p-O]_q-(CR_{15}R'_{15})_r-[O-(CR_{14}R'_{14})_p]_q-$ (22)

$-[(CR_{16}R'_{16})_s-C(=O)O]_t-(CR_{17}R'_{17})u-$ (23a)

$-(CR_{17}R'_{17})_u-[(CR_{16}R'_{16})_s-C(=O)O]_t-$ (23b)

$-[(CR_{18}R'_{18})_v-O-C(=O)-(CR_{19}R'_{19})_w-C(=O)-O]_x-(CR_{18}R'_{18})_v-$ (24)

$-[(CR_{20}R'_{20})_y-S]_z-(CR_{20}R'_{20})_y-$ (25)

$-(CR_{21}R'_{21})_{m'}-C(=O)-O-(CR_{22}R'_{22})_{n'}-O-C(=O)-(CR_{21}R'_{21})_{m'}-$ (26)

$-(CR_{23}R'_{23})_{m''}-Cy-[L-Cy]_{n''}-(CR_{23}R'_{23})_{m''}-$ (27)

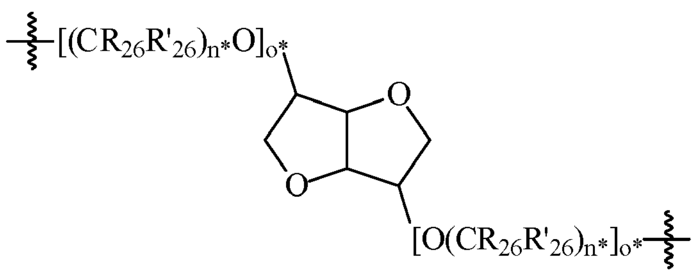

(28)

wherein:

- $R_{12}$, $R'_{12}$, $R_{15}$, $R'_{15}$, $R_{17}$, $R'_{17}$, $R_{18}$, $R'_{18}$, $R_{19}$, $R'_{19}$, $R_{21}$, $R'_{21}$, $R_{22}$, $R'_{22}$, $R_{23}$ and $R'_{23}$ are independently H or alkyl;
- $R_{13}$, $R'_{13}$, $R_{14}$, $R'_{14}$, $R_{16}$, $R'_{16}$, $R_{20}$, $R'_{20}$, $R_{26}$ and $R'_{26}$ are independently H or methyl;
- Cy is an optionally substituted ring, in particular an optionally substituted cyclohexylene or phenylene;
- L is a bond or a linker such as Alk, -C(=O)-, -C(=O)-O-Alk-O-C(=O)-, -SO-, $-SO_2-$, $-C(=CCl_2)-$ and -Alk-Ph-Alk-;
- Alk is an optionally substituted alkylene;
- Ph is an optionally substituted phenylene;
- m, n', r, v, u and w are independently an integer from 2 to 20;

- each m" is independently an integer from 0 to 20;
- n, n*, p and y are independently an integer from 2 to 4;
- n" is an integer equal to 0 or 1;
- m', o, t, x and z are independently an integer from 1 to 20;
- each o* is independently an integer from 0 to 10, in particular from 1 to 6.
- each q is independently an integer from 0 to 20 with the proviso that at least one q is not 0-,
- s is an integer from 3 to 12.

preferably $L_1$, $L_2$ and $L_3$ are independently a divalent linker selected from an alkylene group such as 1,3-propanediyl, 1,3- or 1,4-butanediyl, 1,5-pentanediyl, 1,6-hexanediyl, 1,8-octanediyl, 1,9-nonanediyl, 1,10-decanediyl, 1,12-decanediyl, 2-methyl-1,3-propanediyl, 2,2-diethyl-1,3-propanediyl, 3-methyl-1,5-pentanediyl, 3,3-dimethyl-1,5-pentanediyl, 2,2-dimethyl-1,3-propanediyl, 2,4-diethyl-1,5-pentanediyl; an alkoxylated derivative of the aforementioned alkylenes, preferably an ethoxylated and/or propoxylated derivative of the aforementioned alkylenes; an esterified, preferably by ring-opening polymerization of a lactone such as ε-caprolactone, derivative of the aforementioned alkylenes; a residue of a di-, tri-, tetra- or polyoxyalkene without the hydroxy groups such as di-, tri- or tetraethylene glycol, di-, tri- or tetrapropylene glycol, di-, tri- or tetrabutylene glycol, polyethylene glycol, polypropylene glycol, polybutylene glycol, poly(ethylene glycol-co-propylene glycol).

According to some embodiments, $L_1$ and $L_4$ may independently be the residue of a polyol (i.e the residue that is obtained by removing the OH groups of a polyol). Examples of suitable polyols, referred to herein as $P_{OH}$, include ethylene glycol, 1,2- or 1,3-propylene glycol, 1,2-, 1,3- or 1,4-butylene glycol, 1,5-pentanediol, 1,6-hexanediol, 1,7-heptanediol, 1,8-octanediol, 1,9-nonanediol, 1,10-decanediol, 1,12-dodecanediol, 2-methyl-1,3-propanediol, 2,2-diethyl-1,3-propanediol, 3-methyl-1,5-pentanediol, 3,3-dimethyl-1,5-pentanediol, neopentyl glycol, 2,4-diethyl-1,5-pentanediol, 3,3-butylethyl-1,5-pentane diol, cyclohexanediol, cyclohexane-1,4-dimethanol, norbornene dimethanol, norbornane dimethanol, tricyclodecanediol, tricyclodecane dimethanol, dicyclopentadiene diol, hydroquinone bis(2-hydroxyethyl) ether, pyrocatechol, resorcinol, cardol, phloroglucinol, pyrogallol, tris(hydroxyphenyl)methane, tris(hydroxyphenyl)ethane, bisphenol A, B, F or S, hydrogenated bisphenol A, B, F or S, trimethylolmethane, trimethylolethane, trimethylolpropane, di(trimethylolpropane), triethylolpropane, pentaerythritol, di(pentaerythritol), glycerol, di-, tri- or tetraglycerol, a polyglycerol, di-, tri- or tetra(ethylene glycol), di-, tri- or tetra(1,2-propylene glycol), di-, tri- or tetra(1,3-propylene glycol), di-, tri- or tetra(1,4-butylene glycol), a polyethylene glycol), a polypropylene glycol), a poly(trimethylene glycol), a poly(tetramethylene glycol), a poly(ethylene glycol-co-propylene glycol), an alditol (i.e. erythritol, threitol, arabitol, xylitol, ribitol, mannitol, sorbitol, galactitol, fucitol or iditol), a dianhydrohexitol (i.e. isosorbide, isomannide, isoidide), tris(2-hydroxyethyl)isocyanurate, a hydroxylated vegetable oil, a $C_{36}$ dimer diol, a polybutadiene polyol, a polyester polyol, a polyether polyol, a polyorganosiloxane polyol, a polycarbonate polyol, as well as the alkoxylated (e.g., ethoxylated and/or propoxylated) derivatives thereof and the derivatives obtained by ring-opening polymerization of ε-caprolactone initiated with one of the aforementioned polyols, and combinations thereof.

According to some embodiments, $L_1$ may be the residue of a polyepoxide (i.e the residue that is obtained by removing the epoxy groups of a polyepoxide). Examples of suitable polyepoxides include 1,2,3,4-diepoxybutane, 1,2,4,5-diepoxypentane, 1,2,5,6-diepoxyhexane, 1,2,7,8-diepoxyoctane, 1,2,9,10-diepoxydecane, an epoxidized vegetable oil (such as epoxidized soybean oil and epoxidized linseed oil), epoxidized polybutadiene, triglycidyl isocyanurate, and combinations thereof.

In a preferred embodiment, $L_1$ and $L_4$ are independently the residue of a polyol selected from an optionally alkoxylated trimethylolpropane, an optionally alkoxylated di(trimethylolpropane), an optionally alkoxylated pentaerythritol, an optionally alkoxylated glycerol, an optionally alkoxylated diglycerol, a polyethylene glycol), a polypropylene glycol), a poly(trimethylene glycol), a poly(tetramethylene glycol).

According to some embodiments, $L_2$ may be the residue of a polythiol (i.e the residue that is obtained by removing the SH groups of a polythiol). Examples of suitable polythiols, also referred to herein as $P_{SH}$, include ethane-1,2-dithiol, propane-1,3-dithiol, butane-1,4-dithiol, hexane-1.6-dithiol, octane-1,8-dithiol, decane-1,10-dithiol, 1,8-dimercapto-3,6-dioxaoctane (DMDO), di-, tri- or polyethylene glycol di(ethanethiol), ethylene glycol bis(mercaptoacetate), ethylene glycol bis(3-mercaptopropionate), ethylene glycol bis(3-mercaptobutyrate), 1,2-propylene glycol bis(mercaptoacetate), 1,2-propylene glycol bis(3-mercaptopropionate), 1,2-propylene glycol bis(3-mercaptobutyrate), 1,3-propylene glycol bis(mercaptoacetate), 1,3-propylene glycol bis(3-mercaptopropionate), 1,3-propylene glycol bis(3-mercaptobutyrate), 1,4-butanediol bis(mercaptoacetate), 1,4-butanediol bis(3-mercaptopropionate), 1,4-butanediol bis(3-mercaptobutyrate), 1,6-hexanediol bis(mercaptoacetate), 1,6-hexanediol bis(3-mercaptopropionate), 1,6-hexanediol bis(3-mercaptobutyrate), di-, tri- or polyethylene glycol bis(mercaptoacetate), di-, tri- or polyethylene glycol bis(3-mercaptopropionate), di-, tri- or polyethylene glycol bis(3-mercaptobutyrate), di-, tri- or polypropylene glycol bis(mercaptoacetate), di-, tri- or polypropylene glycol bis(3-mercaptopropionate), di-, tri- or polypropylene glycol bis(3-mercaptobutyrate), trimethylolpropane tris(mercaptoacetate), trimethylolpropane tris(3-mercaptopropionate), trimethylolpropane tris(3-mercaptobutyrate), pentaerythritol tris(mercaptoacetate), pentaerythritol tris(3-mercaptopropionate), pentaerythritol tris(3-mercaptobutyrate), pentaerythritol tetrakis(mercaptoacetate), pentaerythritol tetrakis(3-mercaptopropionate), pentaerythritol tetrakis(3-mercaptobutyrate), tris[2-(3-mercaptopropionyloxy)ethyl] isocyanurate, tris[2-(3-mercaptopropionyloxy)ethyl] isocyanurate, tris[2-(3-mercaptobutyryloxy)ethyl] isocyanurate, mercaptan-terminated polymers (such as such as Capcure® 3-800 (BASF), GPM-800 (Gabriel Performance Products), Capcure® LOF (BASF), GPM-800LO (Gabriel Performance Products), KarenzMT PE-1 (Showa Denko)), as well as the alkoxylated (e.g., ethoxylated and/or propoxylated) derivatives thereof, and combinations thereof.

According to some embodiments, $L_3$ may be the residue of a polyamine (i.e the residue that is obtained by removing the primary and secondary amine groups of a polyamine). Examples of suitable polyamines, also referred to herein as $P_{NH}$, include 1-amino-3-aminomethyl-3,5,5-trimethyl cyclohexane (IPDA), bis(4-aminocyclohexyl)methane, bis(4-amino-3-methylcyclohexyl)methane, 2-methyl pentamethylene diamine, ethylene diamine, 1,2- or 1,3-propanediamine, 2-methyl-1,2-propanediamine, 2,2-dimethyl-1,3-propanediamine, 1,3- or 1,4-butane diamine, 1,3- or 1,5-pentane diamine, 2-methyl-1,5-pentane diamine, 1,6-hexane diamine, 2,5-dimethyl-2,5-hexane diamine, 2,2,4- or 2,4,4-trimethyl-1,6-hexane diamine, 1,7-heptane diamine, 1,8-octane diamine, 1,9-nonane diamine, 1,10-decane diamine, 1,11-undecane diamine, 1,12-dodecane diamine, 2,4- or 2,6-hexahydrotoluylene diamine, 2,4'- or 4,4'-diamino-dicyclohexylmethane, 1,3- or 1,4-cyclohexane diamine, 1,3- or 1,4-bis(methylamino)cyclohexane, 1,8-p-menthane diamine, hydrazine, phenylene diamine, 2,3- 2,4- 3,4- or 2,6-toluylene diamine, o-, m- or p-xylylene diamine, 2,4'- or 4,4'-diaminodiphenyl methane, benzidine, N-(2-aminoethyl)-1,3-propane diamine, N,N'-di-(2-aminoethyl)piperazine, a polyetheramine (in particular a Jeffamine® such as Jeffamine® D-230, Jeffamine® D-400, Jeffamine® D-2000, Jeffamine® D-2010, Jeffamine® D-4000, Jeffamine® ED-600, Jeffamine® ED-900, Jeffamine® ED-2003, Jeffamine® EDR-148, Jeffamine® EDR-176, Jeffamine® THF-100, Jeffamine® THF-170, Jeffamine® T403, Jeffamine® T3000, Jeffamine® T5000, Jeffamine® RFD-270) and combinations thereof.

In one embodiment, the photoinitiator of the present invention may be according to formula (2), and $Q_3$ and $Q_4$ may form a polymeric backbone. In such a case, the photoinitiator of formula (2) preferably comprises:

- a plurality of units of formula (29):

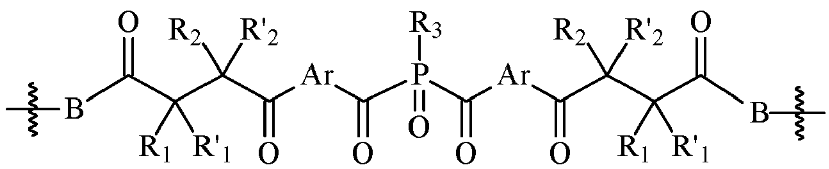

(29)

wherein

- B is $*-O-[CH_2-CH(OH)-Y]_a-$, -S- or - $N(R^{18})$-;
- Y, $R^{18}$ and a are as defined above;
- the symbol * represents a point of attachment to the C(=O) groups;

and;

- a plurality of units according to one of formulae (20) to (28) above.

Non-limiting examples of photoinitiators of formula (1) and (2) are detailed below:

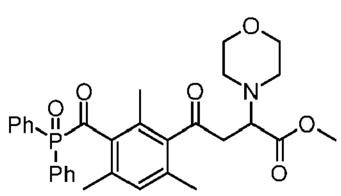

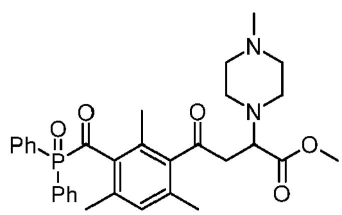

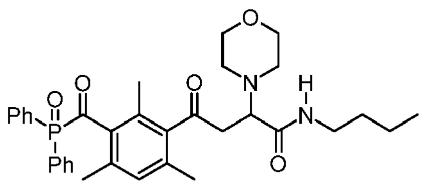
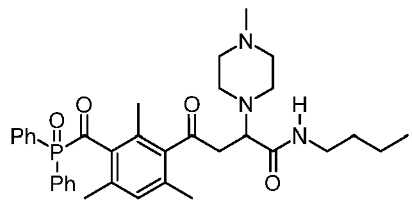

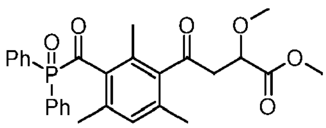
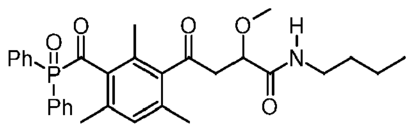

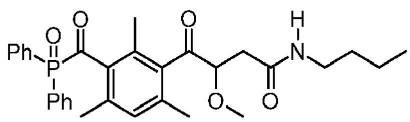
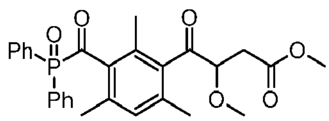

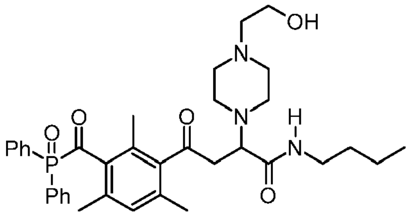
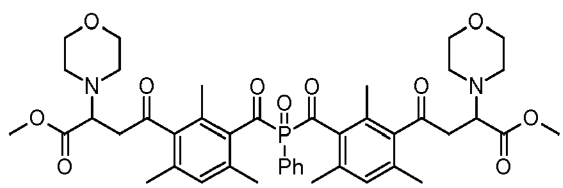

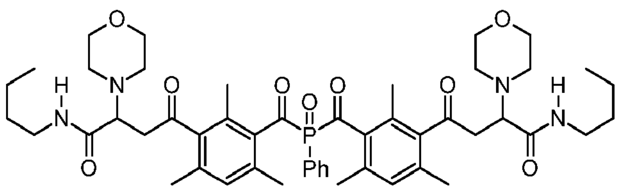
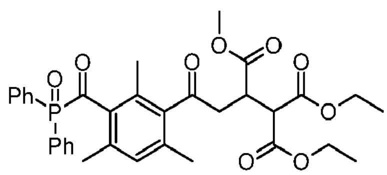

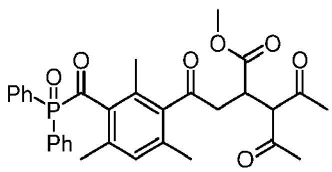
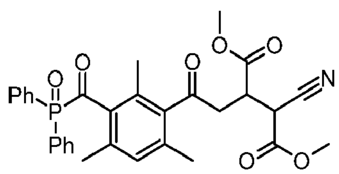

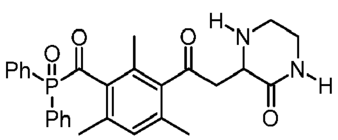
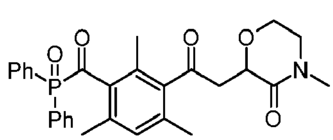
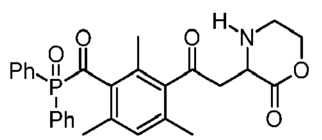

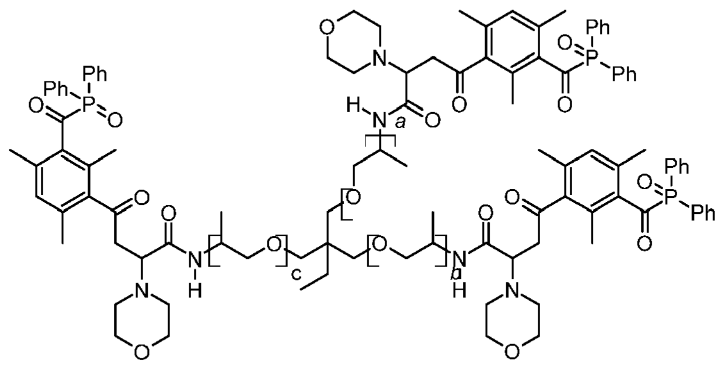

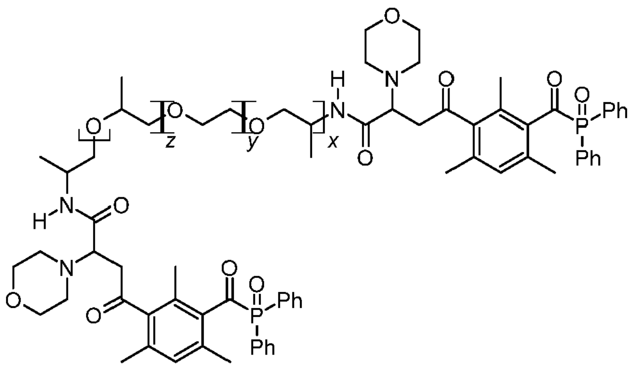

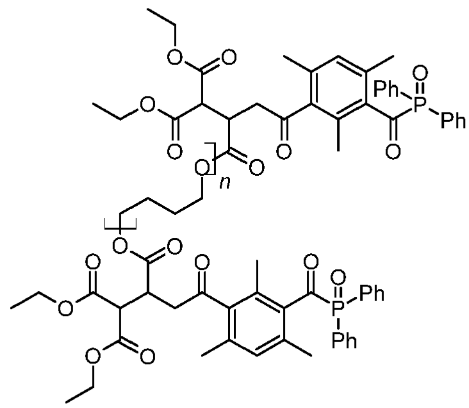

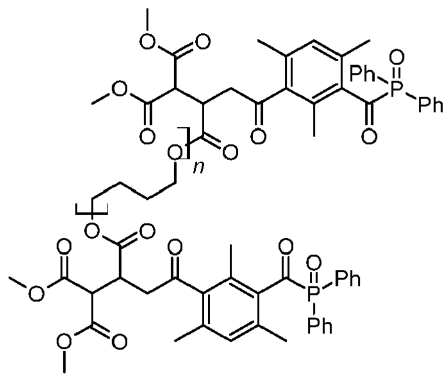

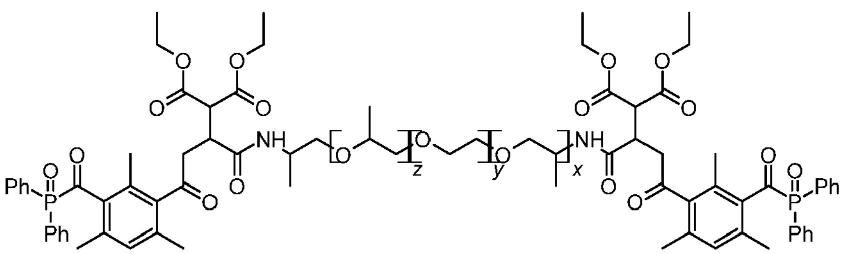

;

and isomers therof;
wherein each a, b, c, n, x, y and z independently represents an integer from 1 to 50.

The photoinitiators of formula (1) and (2) may be prepared by a process as detailed below.

**Preparation processes and precursors**

All of the particular and preferred embodiments described above for the photoinitiators of formula (1) and (2)

equally apply to the following processes and precursors.

*Process n°1 and related precursors*

The photoinitiator of formula (1) or (2) as described above may be prepared by a process comprising reacting at least one precursor of formula (30) or (31) with at least one product of formula (32):

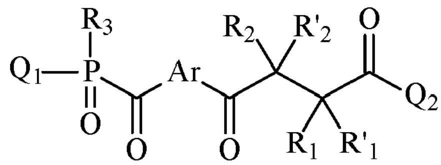

(1)

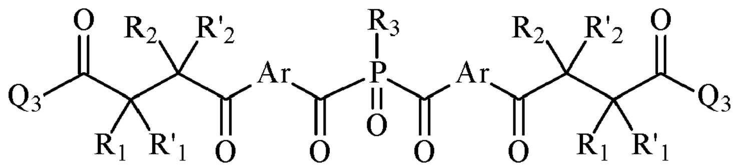

(2)

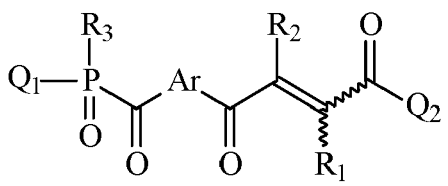

(30)

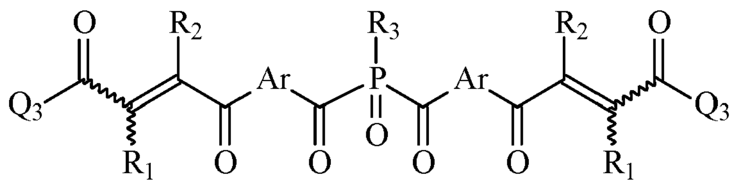

(31)

$R'_1$-$R'_2$ (32)

wherein Ar, $R_1$, $R_2$, $R_3$, $R'_1$, $R'_2$, $Q_1$, $Q_2$ and $Q_3$ are as defined above.

The wavy bonds illustrated in the formulas (30) and (31) represent either the cis or trans isomer.

Preferably, the product of formula (32) may be selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, *N*-methylpiperazine, oxazolidine, thiazolidine, thiomorpholine, azepane), more particularly a secondary cyclic amine (for example morpholine, piperidine, pyrrolidine, *N*-methylpiperazine, oxazolidine, thiazolidine, thiomorpholine, azepane);
- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);
- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile).

The above reaction may be carried out in the presence of one or more compounds selected from:

- a base, in particular a base chosen from sodium or potassium hydroxide, sodium or potassium carbonate or an amine base, such as a tertiary amine base, for example triethylamine, *N,N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as toluene, xylene, 2-butanone, methanol, *N*-methylpyrrolidinone, *N*,*N*-dimethylformamide, *N,N*-dimethylacetamide, dimethyl sulfoxide, sulfolane and mixtures thereof.

Said reaction may be carried out at a temperature from 10 to 120°C and preferably from 50 to 100°C. Said reaction may be carried out for a duration from 30 min to 24 hours and preferably from 1 to 10 hours. Once the reaction is finished, the reaction medium may be washed one or more times with an aqueous solution, for example an aqueous solution of hydrochloric acid, an aqueous solution of sodium bicarbonate and/or an aqueous solution of sodium chloride. The solvent(s) may be evaporated from the resulting organic phase.

The invention also relates to a precursor of formula (30) or (31):

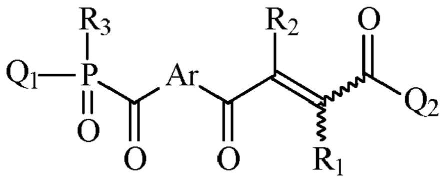

(30)

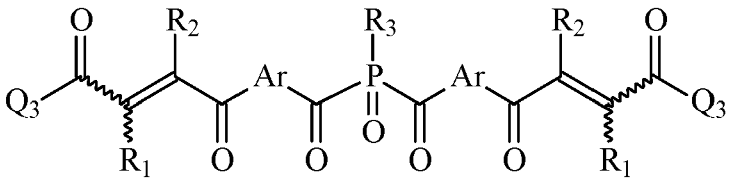

(31)

wherein Ar, $R_1$, $R_2$, $R_3$, $Q_1$, $Q_2$ and $Q_3$ are as defined above.

The precursor of formula (30) or (31) may be prepared by a process comprising reacting at least one precursor of formula (33) or (34) with at least one compound of formula (35) to (42):

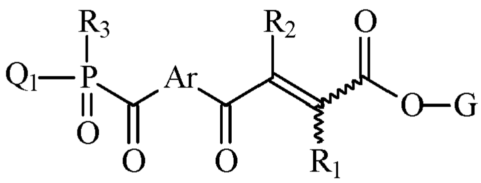

(33)

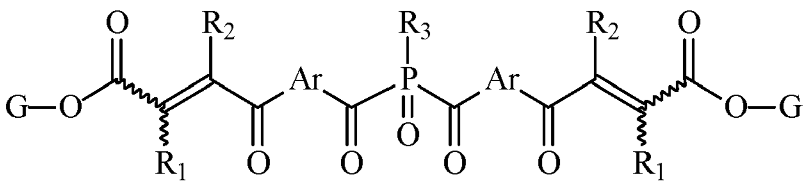

(34)

$R^{14}$-OH (35)

$R^{15}$-SH (36)

$NHR^{16}R^{17}$ (37)

$Z^{1a}$-OH (38)

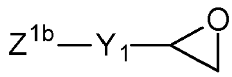

(39)

$Z^2$-SH (40)

$Z^3$-NH($R^{18}$) (41)

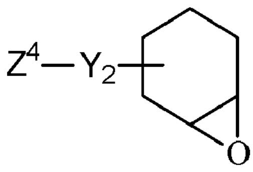

(42)

wherein:

- Ar, $R_1$, $R_2$, $R_3$, $Q_1$, $Y_1$ and $Y_2$ are as defined above;
- G is H, a halogen atom or -C(=O)-J;
- J is alkyl or aryl, in particular tert-butyl;
- $R^{14}$ is as defined above;
- $R^{15}$ is as defined above;
- $R^{16}$ and $R^{17}$ are as defined above;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

The wavy bonds illustrated in the formulas (33) and (34) represent either the cis or trans isomer.

The above reaction may be carried out in the presence of one or more compounds selected from:

- a catalyst, in particular a catalyst chosen from a zirconium catalyst, a titanium catalyst and a quaternary ammonium salt, preferably chosen from a zirconium (IV) catalyst, a titanium (IV) catalyst and a tetraalkylammonium salt, more preferably chosen from zirconium(IV) acetylacetonate, titanium(IV) isopropoxide, titanium (IV) oxyacetylacetonate, tetrabutylammonium bromide and tetrabutylammonium chloride;
- a solvent, in particular a solvent selected from toluene, xylene, acetonitrile, acetone, tetrahydrofuran and mixtures thereof;
- a co-solvent such as *N*-methylpyrrolidinone, *N,N*-dimethylformamide, *N,N*-dimethylacetamide, dimethyl sulfoxide, sulfolane and mixtures thereof.
- a stabilizer/polymerization inhibitor, in particular a polymerization inhibitor selected from hydroquinone (HQ), hydroquinone monomethyl ether (MEHQ, 4-methoxyphenol), 4-tert-butylcatechol (TBC), and 3,5-di-tertiobutyl-4-hydroxytoluene (BHT), phenothiazine (PTZ) and mixtures thereof.

Said reaction may be carried out in the presence of a zirconium catalyst or a titanium catalyst when the reaction corresponds to an esterification, amidification or thioesterification reaction. Said reaction may be carried out in the presence of a quaternary ammonium salt as the catalyst when the reaction corresponds to the opening of an epoxy ring. Said reaction may be carried out at a temperature from 70 to 140°C and preferably from 90 to 130°C. Said reaction may be carried out for a duration from 1 to 72 hours and preferably from 4 to 24 hours. Said reaction may be carried out so as to eliminate the water that is formed during the reaction. For example, the reaction may be carried out in a reactor equipped with a condenser (i.e. Dean-Stark) and the reaction medium may be heated at a temperature sufficient to evaporate the water (optionally as an azeotropic mixture with a solvent). Once the reaction is finished, the reaction medium may be washed one or more times with an aqueous solution, for example an aqueous solution of sodium

chloride. The solvent(s) may be evaporated from the resulting organic phase.

In one embodiment, the precursor of formula (30) or (31) may be prepared by a process comprising reacting at least one precursor of formula (33) or (34) with at least one compound of formula (38) and $Z^{1a}$ corresponds to formula (43):

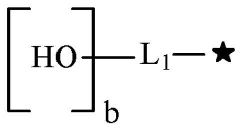

(43)

wherein $L_1$ and b are as defined above.

Preferably, the compound of formula (38) is a polyol as listed above for $P_{OH}$.

Alternatively, the precursor of formula (30) or (31) may be prepared by a process comprising reacting at least one precursor of formula (33) or (34) with at least one compound of formula (39) and $Z^{1b}$ corresponds to formula (44):

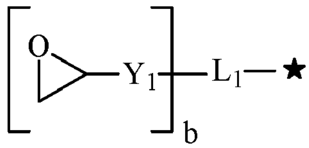

(44)

wherein:

- $Y_1$ is as defined above;
- $L_1$ and b are as defined above.

Preferably, the compound of formula (39) is a polyepoxide, also referred to herein as $P_{EPOX}$, selected from 1,2,3,4-diepoxybutane; 1,2,4,5-diepoxypentane; 1,2,5,6-diepoxyhexane; 1,2,7,8-diepoxyoctane; 1,2,9,10-diepoxydecane; a glycidyl ether or ester of a polyol (such as the polyols listed above for $P_{OH}$) including ethylene glycol diglycidyl ether, 1,2- or 1,3-propylene glycol diglycidyl ether, 1,2-, 1,3- or 1,4-butanediol diglycidyl ether, 1,5-pentanediol diglycidyl ether, 1,6-hexanediol diglycidyl ether, 1,7-hexanediol diglycidyl ether, 1,8-octanediol diglycidyl ether, 1,9-nonanediol diglycidyl ether, 1,10-decanediol diglycidyl ether, 1,12-dodecanediol diglycidyl ether, 2-methyl-1,3-propanediol diglycidyl ether, neopentyl glycol diglycidyl ether, 2,2-diethyl-1,3-propane diol diglycidyl ether, 3-methyl-1,5-pentanediol diglycidyl ether, 3,3-dimethyl-1,5-pentanediol diglycidyl ether, 2,4-diethyl-1,5-pentanediol diglycidyl ether, 3,3-butylethyl-1,5-pentane diol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a polyethylene glycol) diglycidyl ether, a polypropylene glycol) diglycidyl ether, a poly(trimethylene glycol) diglycidyl ether, a poly(tetramethylene glycol) diglycidyl ether, a poly(ethylene glycol-co-propylene glycol) diglycidyl ether, glycerol triglycidyl ether, a polyglycerol polyglycidyl ether, trimethylolmethane triglycidyl ether, trimethylolethane triglycidyl ether, trimethylolpropane triglycidyl ether, di(trimethylolpropane) tetraglycidyl ether, pentaerythritol tetraglycidyl ether, diglycidyl cyclohexanedicarboxylate, cyclohexane diglycidyl ether, cyclohexane-1,4-dimethanol diglycidyl ether, tricyclodecane dimethanol diglycidyl ether, isosorbide diglycidyl ether, pyrocatechol diglycidyl ether, resorcinol diglycidyl ether, cardol diglycidyl ether, phloroglucinol triglycidyl ether, pyrogallol triglycidyl ether, tris(hydroxyphenyl)methane triglycidyl ether, tris(hydroxyphenyl)ethane triglycidyl ether, bisphenol A, B, F or S diglycidyl ether, hydrogenated bisphenol A, B, F or S diglycidyl ether, diglycidyl phthalate, diglycidyl terephthalate, diglycidyl isophthalate; an epoxidized vegetable oil (such as epoxidized soybean oil and epoxidized linseed oil); epoxidized polybutadiene; triglycidyl isocyanurate, and combinations thereof.

Alternatively, the precursor of formula (30) or (31) may be prepared by a process comprising reacting at least one precursor of formula (33) or (34) with at least one compound of formula (40) and $Z^2$ corresponds to formula (45):

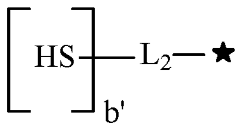

(45)

wherein $L_2$ and b' are as defined above.

Preferably, the compound of formula (40) is a polythiol as listed above for $P_{SH}$.

Alternatively, the precursor of formula (30) or (31) may be prepared by a process comprising reacting at least one precursor of formula (33) or (34) with at least one compound of formula (41) and $Z^3$ corresponds to formula (46):

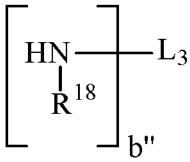

(46)

wherein:

- $R^{18}$ is as defined above;
- $L_3$ and b" are as defined above.

Preferably, the compound of formula (41) is a polyamine as listed above for $P_{NH}$.

Alternatively, the precursor of formula (30) or (31) may be prepared by a process comprising reacting at least one precursor of formula (33) or (34) with at least one compound of formula (42) and $Z^{1b}$ corresponds to formula (47):

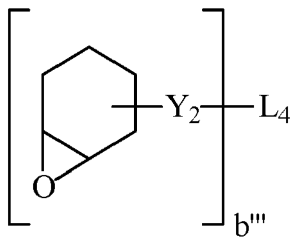

(47)

wherein:

- $Y_2$ is as defined above;
- $L_4$ and b‴ are as defined above.

Preferably, the compound of formula (42) is a cycloaliphatic polyepoxide, also referred to as $P_{CYCLO.\ EPOX}$, selected from 7-oxabicyclo[4.1.0]hept-3-ylmethyl 7-oxabicyclo[4.1.0]heptane-3-carboxylate (UviCure S105), bis((3,4-epoxycyclohexyl)methyl) adipate (UviCure S128), 2-(3,4-epoxycyclohexyl-5,5-spiro-3,4-epoxy)cyclohexane-1,4-dioxane, bis(3,4-epoxy-6-methylcyclohexylmethyl)adipate, 3,4-epoxy-6-methylcyclohexyl-3',4'-epoxy-6'-methylcyclohexanecarboxylate, a compound of formula (47a), (47b) or (47c) and combinations thereof:

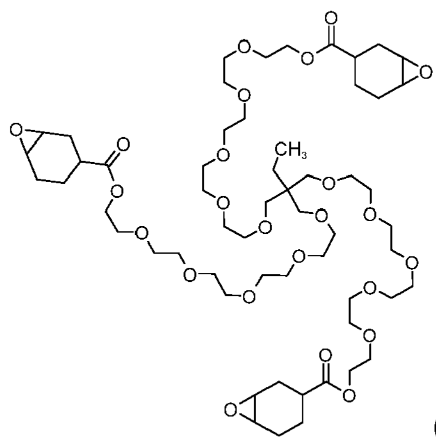

(47a)

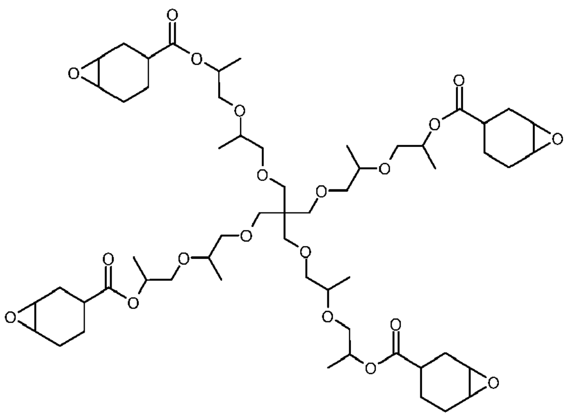

(47b)

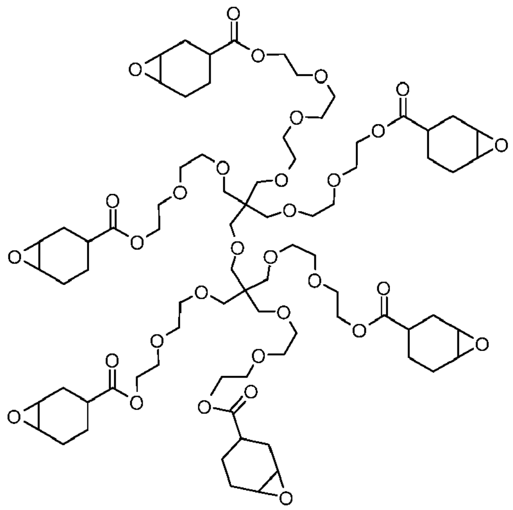

(47c).

The invention also relates to a precursor of formula (33) or (34):

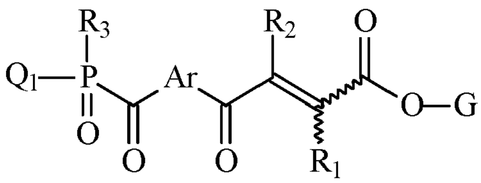

(33)

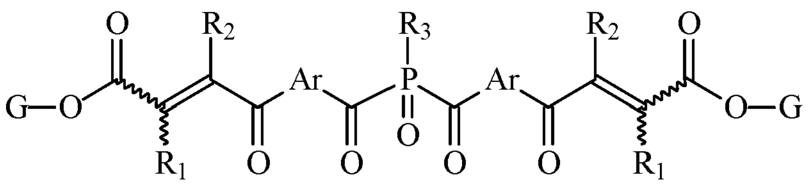

(34)

wherein:

- Ar, $R_1$, $R_2$, $R_3$, $Q_1$ are as defined above;
- G is H, a halogen atom or -C(=O)-J;
- J is alkyl or aryl, in particular tert-butyl.

The precursor of formula (33) or (34) may be prepared by a process comprising reacting at least one phosphine oxide of formula (48) or (49) with at least one cyclic anhydride of formula (50) to provide a precursor according to formula (33) or (34) wherein G is H:

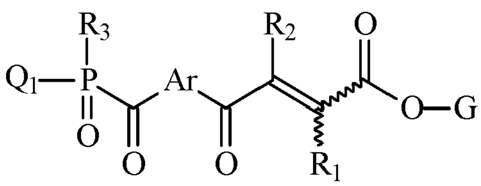

(33)

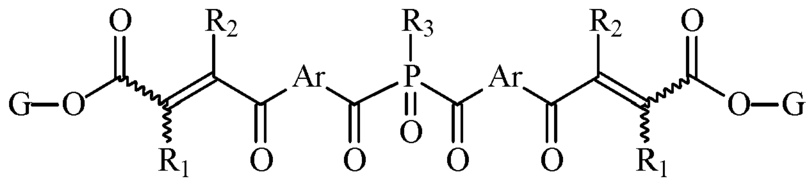

(34)

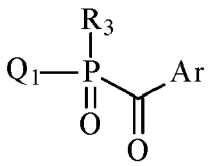

(48)

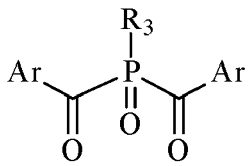

(49)

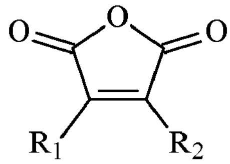

(50)

wherein Ar, $R_1$, $R_2$, $R_3$, $Q_1$ are as defined above;
the process optionally comprising an additional step of:

- reacting the precursor according to formula (33) or (34) wherein G is H with an acyl halide of formula (51) to provide a precursor according to formula (33) or (34) wherein G is -C(=O)-J

Hal-C(=O)-J (51)

wherein Hal is a halogen atom and J is alkyl or aryl, in particular tert-butyl; or
- reacting the precursor according to formula (33) or (34) wherein G is H with a halogenating agent, in particular thionyl chloride, to provide a precursor according to formula (33) or (34) wherein G is a halogen atom.

The reaction of the at least one phosphine oxide of formula (48) or (49) with the at least one cyclic anhydride of formula (50) may be carried out using maleic anhydride as the cyclic anhydride of formula (50). Said reaction may be carried out in the presence of one or more compounds selected from:

- a Lewis acid, in particular a metal halide such as iron chloride, aluminum chloride or aluminum bromide;
- a solvent, in particular a solvent selected from toluene, xylene, dichloromethane, chloroform, 1,2-dichloroethane and mixtures thereof and mixtures thereof.

Said reaction may be carried out at a temperature from 15 to 50°C, in particular 20 to 40°C. Said reaction may be carried out for a duration from 1 to 72 hours, preferably 8 to 36 hours. Once the reaction is finished, the reaction medium may be washed one or more times with an aqueous solution, for example an aqueous solution of sodium chloride. The solvent(s) may be evaporated from the resulting organic phase.

The reaction of the precursor according to formula (33) or (34) wherein G is H with an acyl halide of formula (51) may be carried out with trimethylacetyl chloride as the acyl chloride of formula (51). Said reaction may be carried out in the presence of one or more compounds selected from:

- a base, in particular a base chosen from sodium or potassium hydroxide, sodium or potassium carbonate or an amine base, such as a tertiary amine base, for example triethylamine, *N,N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as xylene, toluene, tetrahydrofuran, dichloromethane and mixtures thereof.

Said reaction may be carried out a temperature of -10 to 10°C, preferably from 0 to 5°C. Said reaction may be carried out for a duration from 1 to 120 minutes and preferably from 15 to 45 minutes. The resulting anhydride may be

used neat in the next step of the process (i.e. reaction with at least one compound of formula (35) to (42) to provide a precursor of formula (30) or (31)).

*Process n°2 and related precursors*

The photoinitiator of formula (1) or (2) as described above may be prepared by a process comprising reacting at least one precursor of formula (52) or (53) with at least one compound of formula (35) to (42):

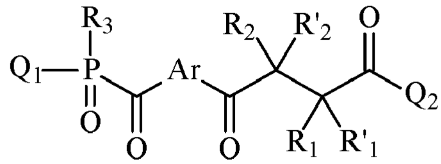

(1)

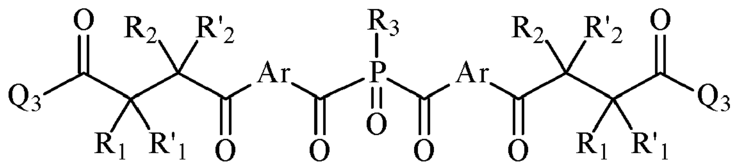

(2)

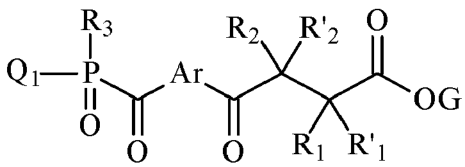

(52)

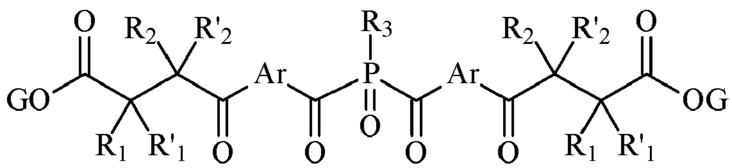

(53)

$R^{14}$-OH (35)

$R^{15}$-SH (36)

$NHR^{16}R^{17}$ (37)

$Z^{1a}$-OH (38)

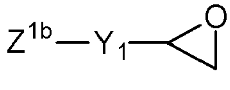

(39)

$Z^2$-SH (40)

$Z^3$-NH($R^{18}$) (41)

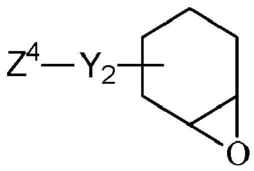

(42)

wherein:

- Ar, $R_1$, $R_2$, $R_3$, $R'_1$, $R'_2$, $Q_1$, $Y_1$ and $Y_2$ are as defined above;
- G is H, a halogen atom or -C(=O)-J;
- J is alkyl or aryl, in particular tert-butyl;
- $R^{14}$ is as defined above;
- $R^{15}$ is as defined above;
- $R^{16}$ and $R^{17}$ are as defined above;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

The above reaction may be carried out as defined above for the preparation process of the precursor of formula (30) or (31).

In one embodiment, the photoinitiator of formula (1) or (2) may be prepared by a process comprising reacting at least one precursor of formula (52) or (53) with at least one compound of formula with at least one compound of formula (38) and $Z^{1a}$ corresponds to formula (43):

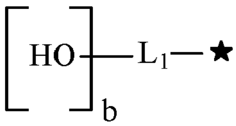

(43)

wherein $L_1$ and b are as defined above.

Preferably, the compound of formula (38) is a polyol as listed above for $P_{OH}$.

Alternatively, the photoinitiator of formula (1) or (2) may be prepared by a process comprising reacting at least one precursor of formula (52) or (53) with at least one compound of formula (39) and $Z^{1b}$ corresponds to formula (44):

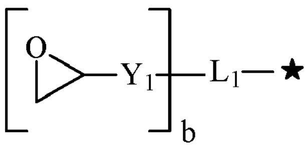

(44)

wherein:

- $Y_1$ is as defined above;
- $L_1$ and b are as defined above;

Preferably the compound of formula (39) is a polyepoxide as listed above for $P_{EPOX}$.

Alternatively, the photoinitiator of formula (1) or (2) may be prepared by a process comprising reacting at least one precursor of formula (52) or (53) with at least one compound of formula (40) and $Z^2$ corresponds to formula (45):

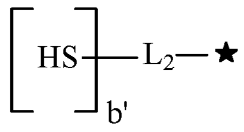

(45)

wherein $L_2$ and b' are as defined above.

Preferably, the compound of formula (40) is a polythiol as listed above for $P_{SH}$.

Alternatively, the photoinitiator of formula (1) or (2) may be prepared by a process comprising reacting at least one precursor of formula (52) or (53) with at least one compound of formula (41) and $Z^3$ corresponds to formula (46):

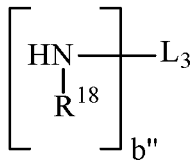

(46)

wherein:

- $R^{18}$ is as defined above;
- $L_3$ and b" are as defined above.

Preferably the compound of formula (41) is a polyamine as listed above for $P_{NH}$.

Alternatively, the photoinitiator of formula (1) or (2) may be prepared by a process comprising reacting at least one precursor of formula (52) or (53) with at least one compound of formula (42) and $Z^4$ corresponds to formula (47):

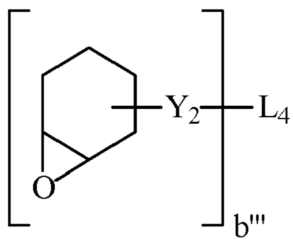

(47)

wherein:

- $Y_2$ is as defined above;
- $L_4$ and b‴ are as defined above.

Preferably, the compound of formula (42) is a cycloaliphatic polyepoxide as listed above for $P_{CYCLO.\ EPOX}$.

The invention also relates to a precursor of formula (52) or (53):

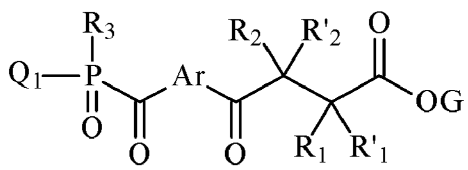

(52)

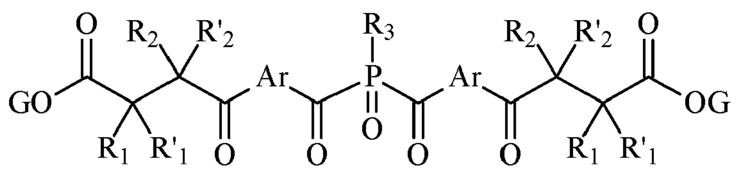

(53)

wherein:

- Ar, $R_1$, $R_2$, $R_3$, $R'_1$, $R'_2$ and $Q_1$ are as defined above;
- G is H, a halogen atom or -C(=O)-J;
- J is alkyl or aryl, in particular tert-butyl.

The precursor of formula (52) or (53) may be prepared by a process comprising reacting at least one precursor of formula (33) or (34) with at least one product of formula (32) to provide a precursor of formula (52) or (53) wherein G is H:

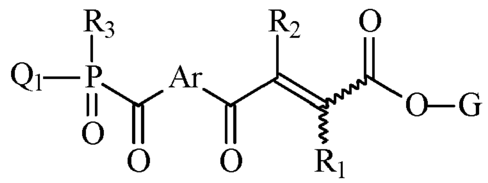

(33)

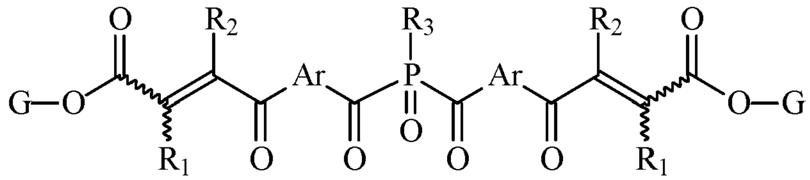

(34)

$R'_1$-$R'_2$ (32)

wherein

- Ar, $R_1$, $R_2$, $R_3$, $R'_1$, $R'_2$ and $Q_1$ are as defined herein;
- G is H;
- J is alkyl or aryl, in particular tert-butyl;

the process optionally comprising an additional step of:

- reacting the precursor according to formula (52) or (53) wherein G is H with an acyl halide of formula (51) to provide a precursor according to formula (52) or (53) wherein G is -C(=O)-J

  Hal-C(=O)-J (51)

  wherein Hal is a halogen atom and J is alkyl or aryl, in particular tert-butyl; or
- reacting the precursor according to formula (52) or (53) wherein G is H with a halogenating agent, in particular thionyl chloride, to provide a precursor according to formula (52) or (53) wherein G is a halogen atom.

The reaction of the at least one precursor of formula (33) or (34) with at least one product of formula (32) may be carried out in the presence of one or more compounds selected from:

- a base, in particular a base chosen from sodium or potassium hydroxide, sodium or potassium carbonate or an amine base, such as a tertiary amine base, for example triethylamine, *N,N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as toluene, xylene, 2-butanone, methanol, *N*-methylpyrrolidinone, *N,N*-dimethylformamide, *N,N*-dimethylacetamide, dimethyl sulfoxide, sulfolane and mixtures thereof.

Said reaction may be carried out at a temperature from 10 to 120°C and preferably from 50 to 80°C. Said reaction may be carried out for a duration from 30 min to 24 hours and preferably from 1 to 10 hours. Once the reaction is finished, the reaction medium may be washed one or more times with an aqueous solution, for example an aqueous solution of hydrochloric acid, an aqueous solution of sodium bicarbonate and/or an aqueous solution of sodium chloride.

The solvent(s) may be evaporated from the resulting organic phase.

The product of formula (32) used in the preparation process of a precursor of formula (52) or (53) may be selected from an amine, an alcohol, a thiol, and an active methylene compound, as defined above in Process n°1 and related precursors.

The reaction of the precursor according to formula (52) or (53) wherein G is H with an acyl halide of formula (51) may be carried out with trimethylacetyl chloride as the acyl chloride of formula (51). Said reaction may be carried out in the presence of one or more compounds selected from:

- a base, in particular a base chosen from sodium or potassium hydroxide, sodium or potassium carbonate or an amine base, such as a tertiary amine base, for example triethylamine, *N,N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as xylene, toluene, tetrahydrofuran, dichloromethane and mixtures thereof.

Said reaction may be carried out a temperature of -10 to 10°C, preferably from 0 to 5°C. Said reaction may be carried out for a duration from 1 to 120 minutes and preferably from 15 to 45 minutes. The resulting anhydride may be used neat in the next step of the process (i.e. reaction with at least one compound of formula (35) to (42) to provide a photoinitiator of formula (1) or (2)).

*Process n°3 and related precursors*

The photoinitiator of formula (5) or (6) as described above may be prepared by a process comprising reacting at least one precursor of formula (33) or (34) with at least one product of formula (54):

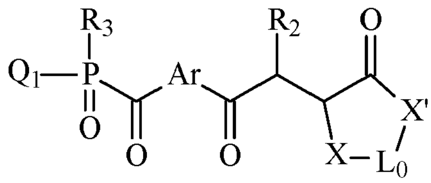

(5)

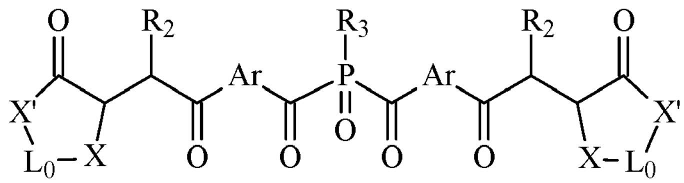

(6)

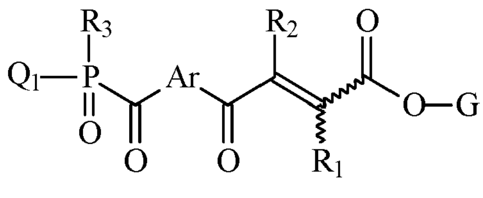

(33)

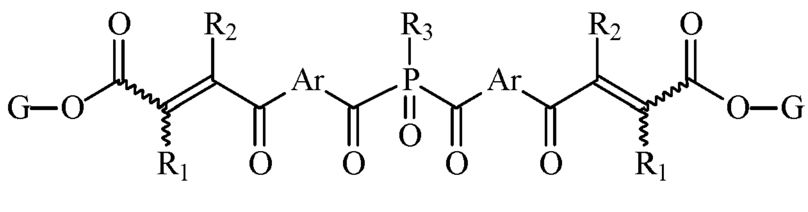

(34)

HX-$L_0$-X'H (54)

wherein:

- Ar, $R_1$, $R_2$, $R_3$, $Q_1$, are as defined above;
- X and X' are independently selected from O, S and $NR^{19}$;
- $R^{19}$ is H or an optionally substituted alkyl;
- $L_0$ is an optionally substituted C1-C4 alkylene
- G is H, a halogen atom or -C(=O)-J;
- J is alkyl or aryl, in particular tert-butyl;

Preferably, the product of formula (54) used in the process to prepare a photoinitiator of formula (5) or (6) is a compound bearing two functional groups independently selected from hydroxyl, amino and thiol. More preferably, the product of formula (54) is an aminoalcohol (for example 2-aminoethanol, 2-(methylamino)ethanol, 2-(ethylamino)ethanol, 3-methylamino-1-propanol) an aminothiol (for example 2-aminoethanethiol), a mercaptoalcohol (for example 2-hydroxyethanethiol), a diol (for example ethylene glycol, propylene glycol, 1,3-propanediol, 1,4-butanediol), a diamine (for example ethylenediamine, 1,2'-dimethylethylenediamine, 1,2'-diethylethylenediamine, N-methylethylenediamine, N-ethylethylenediamine, 1,2-diaminopropane, diethylenetriamine), an amino acid or an amino ester containing an amine group and an alcohol or thiol group (for example D/L-serine, D/L-cysteine, D/L-threonine, and esters thereof particularly methyl or ethyl esters thereof).

The precursors of formula (33) and (34) may be prepared according to the process described in Process n°1 and related precursors.

The reaction of the at least one precursor of formula (33) or (34) with at least one product of formula (54) may be carried out in the presence of one or more compounds selected from:

- a base, in particular a base chosen from sodium or potassium hydroxide, sodium or potassium carbonate or an amine base, such as a tertiary amine base, for example triethylamine, *N,N*-diisopropylethylamine, picoline, pyridine, 1,4-diazabicyclo[2.2.2]octane (DABCO), 1,5-diazabicyclo[4.3.0]non-5-ene (DBN), 1,8-diazabicyclo[5.4.0]undec-7-ene (DBU) or 4-dimethylaminopyridine (DMAP);
- a solvent, such as toluene, xylene, 2-butanone, methanol, *N*-methylpyrrolidinone, *N,N*-dimethylformamide, *N,N*-dimethylacetamide, dimethyl sulfoxide, sulfolane and mixtures thereof.

Said reaction may be carried out at a temperature from 10 to 100°C and preferably from 20 to 50°C. Said reaction may be carried out for a duration from 30 min to 24 hours and preferably from 3 to 20 hours. Once the reaction is finished, the reaction medium may be washed one or more times with an aqueous solution, for example an aqueous solution of hydrochloric acid, an aqueous solution of sodium bicarbonate and/or an aqueous solution of sodium chloride. The solvent(s) may be evaporated from the resulting organic phase.

**Photoinitiator composition**

The present disclosure also relates to a photoinitiator composition comprising:

- a mixture of at least two photoinitiators of formula (1) according to the invention;
- a mixture of at least two photoinitiators of formula (2) according to the invention;
- a mixture of at least one photoinitiator of formula (1) according to the invention and at least one precursor of formula (30) according to the invention; or
- a mixture of at least one photoinitiator of formula (2) according to the invention and at least one precursor of formula (31) according to the invention.

Advantageously, a photoinitiator composition comprising a mixture of such photoinitiators may be liquid at 20°C.

In addition, the present disclosure relates to a photoinitiator composition comprising a photoinitiator of formula (1) or (2) according to the invention and a photoinitiator other than a photoinitiator of formula (1) or (2).

The photoinitiator other than a photoinitiator of formula (1) or (2) may be a photoinitiator having Norrish type I activity and/or Norrish type II activity, more particularly a radical photoinitiator having Norrish type I activity.

Non-limiting types of other photoinitiators suitable for use in the photoinitiator composition of the invention include, for example, benzoins, benzoin ethers, acetophenones, α-hydroxy acetophenones, benzil, benzil ketals, anthraquinones, phosphine oxides, acylphosphine oxides, α-hydroxyketones, phenylglyoxylates, α-aminoketones, benzophenones, thioxanthones, xanthones, acridine derivatives, phenazine derivatives, quinoxaline derivatives, triazine compounds, benzoyl formates, aromatic oximes, metallocenes, acylsilyl or acylgermanyl compounds, camphorquinones, polymeric derivatives thereof, and mixtures thereof.

Examples of suitable other photoinitiators include, but are not limited to, 2-methylanthraquinone, 2-ethylanthraquinone, 2-chloroanthraquinone, 2-benzyanthraquinone, 2-t-butylanthraquinone, 1,2-benzo-9,10-anthraquinone, benzoin ethers, benzoin, benzoin methyl ether, benzoin ethyl ether, benzoin isopropyl ether, alpha-methylbenzoin, alpha-phenylbenzoin, Michler's ketone, acetophenones such as 2,2-dialkoxybenzophenones and 1-hydroxyphenyl ketones, benzophenone, 4,4'-bis-(diethylamino) benzophenone, acetophenone, 2,2-diethyloxyacetophenone, , 2-isopropylthioxanthone, thioxanthone, diethyl thioxanthone, 1,5-acenaphthylene, benzil, $\alpha$-hydroxyketone, 2,4,6-trimethylbenzoyldiphenyl phosphine oxide, , 2,2-dimethoxy-1,2-diphenylethanone, 1-hydroxycyclohexyl phenyl ketone, 2-methyl-1-[4-(methylthio) phenyl]-2-morpholinopropanone, 2-hydroxy-2-methyl-1-phenyl-propanone, oligomeric $\alpha$-hydroxy ketone, benzoyl phosphine oxides, phenylbis(2,4,6-trimethylbenzoyl)phosphine oxide, ethyl(2,4,6-trimethylbenzoyl)phenyl phosphinate, anisoin, anthraquinone, anthraquinone-2-sulfonic acid sodium salt monohydrate, (benzene) tricarbonylchromium, , benzoin isobutyl ether, benzophenone/1-hydroxycyclohexyl phenyl ketone 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone, 4,4'-bis(dimethylamino)benzophenone, camphorquinone, 2-chlorothioxanthen-9-one, dibenzosuberenone, 4,4'-dihydroxybenzophenone, , 4-(dimethylamino)benzophenone, 4,4'-dimethylbenzil, 2,5-dimethylbenzophenone, 3,4-dimethylbenzophenone, diphenyl(2,4,6-trimethylbenzoyl)phosphine oxide /2-hydroxy-2-methylpropiophenone 50/50 blend, 4'-ethoxyacetophenone, 2,4,6-trimethylbenzoyldiphenylphosphine oxide, , 3'-hydroxyacetophenone, 4'-hydroxyacetophenone, 3-hydroxybenzophenone, 4-hydroxybenzophenone, 2-methylbenzophenone, 3-methylbenzophenone, methybenzoylformate, phenanthrenequinone, 4'-phenoxyacetophenone, (cumene)cyclopentadienyl iron(ii) hexafluorophosphate, 9,10-diethoxy and 9,10-dibutoxyanthracene, 2-ethyl-9,10-dimethoxyanthracene, and combinations thereof.

In particular, the other photoinitiator may be selected from a benzophenone such as SpeedCure® BP (benzophenone), SpeedCure® 7005 (polymeric benzophenone), SpeedCure® 7006 (polymeric benzophenone), SpeedCure® EMK (4,4'-bis(diethylamino)benzophenone) or SpeedCure® BMS (4-benzoyl-4'-methyldiphenyl sulphide); a thioxanthone such as SpeedCure® 7010 (polymeric thioxanthone), SpeedCure® ITX (isopropyl thioxanthone), SpeedCure® DETX (2,4-diethylthioxanthone) or SpeedCure® CPTX (1-chloro-4-propoxythioxanthone); an $\alpha$-hydroxy acetophenone such as SpeedCure® 73 (2-hydroxy-2-methyl-1-phenylpropanone); an acylphosphine oxide such as SpeedCure® BPO (phenyl bis(2,4,6-trimethylbenzoyl)-phosphine oxide), SpeedCure® TPO (2,4,6-trimethylbenzoyldiphenylphosphine oxide) or SpeedCure® TPO-L (ethyl (2,4,6-trimethylbenzoyl)phenyl phosphinate); a phenylglyoxylate such as SpeedCure® MBF (methylbenzoylformate); and mixtures thereof.

More particularly, the other photoinitiator may be a phenylglyoxylate, in particular SpeedCure® MBF (methylbenzoylformate). Alternatively, the other photoinitiator may be an $\alpha$-hydroxy acetophenone, in particular SpeedCure® 73 (2-hydroxy-2-methyl-1-phenylpropanone). Alternatively, the other photoinitiator may be a benzophenone, in particular SpeedCure® 7005 (polymeric benzophenone).

## Photopolymerization process

The photoinitiator of formula (1) or (2) as defined above or the photoinitiator composition as defined above may be used in a photopolymerization process, i.e. a process for photopolymerizing (e.g. curing) one or more ethylenically unsaturated compounds.

The process for photopolymerizing one or more ethylenically unsaturated compounds comprises contacting one or more ethylenically unsaturated compounds with a photoinitiator of formula (1) or (2) according to the invention or a photoinitiator composition according to the invention, and irradiating the mixture, in particular with UV, near-UV, visible, infrared and/or near-infrared radiation.

The ethylenically unsaturated compound(s) may be as defined below.

## Curable composition

The curable (or polymerizable) composition of the invention comprises a photoinitiator of formula (1) or (2) according to the invention or a photoinitiator composition according to the invention, referred to as component a). The curable composition of the invention further comprises an ethylenically unsaturated compound (or a mixture of ethylenically unsaturated compounds), referred to as component b).

The curable composition of the invention may comprise:

- from 0.05 to 30 %, preferably from 0.1 to 20 %, more preferably from 0.2 to 15 %, more preferably 0.5 to 10 %, and even more preferably from 1 to 5 % of component a);
- from 70 to 99.95 %, preferably from 80 to 99.9 %, more preferably from 85 to 99.8 %, more preferably from 90 to 99.5 % and even more preferably from 95 to 99 % of component b);

the % being % by weight based on the total weight of components a) and b).

The curable composition of the invention may further comprise one or more compounds selected from:

- a cationically-polymerizable compound;
- a polyol and/or a polythiol;
- an additive; and
- a solvent.

*Ethylenically unsaturated compounds*

As used herein, the term "ethylenically unsaturated compound" means a compound that comprises a polymerizable carbon-carbon double bond. A polymerizable carbon-carbon double bond is a carbon-carbon double bond that can react with another carbon-carbon double bond in a polymerization reaction. A polymerizable carbon-carbon double bond is generally comprised in a group selected from acrylate (including cyanoacrylate), methacrylate, acrylamide, methacrylamide, styrene, maleate, fumarate, itaconate, allyl, propenyl, vinyl and combinations thereof, preferably selected from acrylate, methacrylate, allyl and vinyl, more preferably selected from acrylate and methacrylate. The carbon-carbon double bonds of a phenyl ring are not considered as polymerizable carbon-carbon double bonds.

According to some preferred embodiments, the ethylenically unsaturated compound may be selected from a (meth)acrylate-functionalized monomer, a (meth)acrylate-functionalized oligomer and mixtures thereof. In particular, the ethylenically unsaturated compound comprises a (meth)acrylate-functionalized oligomer and a (meth)acrylate functionalized monomer.

As used herein, the term "(meth)acrylate-functionalized monomer" means a monomer comprising a (meth)acrylate group, in particular an acrylate group. The term "(meth)acrylate-functionalized oligomer" means an oligomer comprising a (meth)acrylate group, in particular an acrylate group. The term "(meth)acrylate group" encompasses acrylate groups ($-O-CO-CH=CH_2$) and methacrylate groups ($-O-CO-C(CH_3)=CH_2$).

According to some embodiments, the ethylenically unsaturated compound comprises a (meth)acrylate-functionalized monomer. The ethylenically unsaturated compound may comprise a mixture of (meth)acrylate-functionalized monomers.

The (meth)acrylate-functionalized monomer may have a molecular weight of less than 600 g/mol, in particular from 100 to 550 g/mol, more particularly 200 to 500 g/mol.

The (meth)acrylate-functionalized monomer may have 1 to 6 (meth)acrylate groups, in particular 1 to 3 (meth)acrylate groups.

The (meth)acrylate-functionalized monomer may comprise a mixture of (meth)acrylate-functionalized monomers having different functionalities. For example the (meth)acrylate-functionalized monomer may comprise a mixture of a (meth)acrylate-functionalized monomer containing a single acrylate or methacrylate group per molecule (referred to herein as "mono(meth)acrylate-functionalized compounds") and a (meth)acrylate-functionalized monomer containing 2 or more, preferably 2 or 3, acrylate and/or methacrylate groups per molecule.

In one embodiment, the (meth)acrylate functionalized monomer comprises a mono(meth)acrylate-functionalized monomer. The mono(meth)acrylate-functionalized monomer may advantageously function as a reactive diluent and reduce the viscosity of the composition.

Examples of suitable mono(meth)acrylate-functionalized monomers include, but are not limited to, mono-(meth)acrylate esters of aliphatic alcohols (wherein the aliphatic alcohol may be straight chain, branched or alicyclic and may be a mono-alcohol, a di-alcohol or a polyalcohol, provided only one hydroxyl group is esterified with (meth)acrylic acid); mono-(meth)acrylate esters of aromatic alcohols (such as phenols, including alkylated phenols); mono-(meth)acrylate esters of alkylaryl alcohols (such as benzyl alcohol); mono-(meth)acrylate esters of oligomeric and polymeric glycols such as diethylene glycol, triethylene glycol, dipropylene glycol, tripropylene glycol, polyethylene glycol, and polypropylene glycol); mono-(meth)acrylate esters of monoalkyl ethers of glycols and oligoglycols; mono-(meth)acrylate esters of alkoxylated (e.g., ethoxylated and/or propoxylated) aliphatic alcohols (wherein the aliphatic alcohol may be straight chain, branched or alicyclic and may be a mono-alcohol, a di-alcohol or a polyalcohol, provided only one hydroxyl group of the alkoxylated aliphatic alcohol is esterified with (meth)acrylic acid); mono-(meth)acrylate esters of alkoxylated (e.g., ethoxylated and/or propoxylated) aromatic alcohols (such as alkoxylated phenols); caprolactone mono(meth)acrylates; and the like.

The following compounds are specific examples of mono(meth)acrylate-functionalized monomers suitable for use in component a): methyl (meth)acrylate; ethyl (meth)acrylate; n-propyl (meth)acrylate; n-butyl (meth)acrylate; isobutyl (meth)acrylate; n-hexyl (meth)acrylate; 2-ethylhexyl (meth)acrylate; n-octyl (meth)acrylate; isooctyl (meth)acrylate; n-decyl (meth)acrylate; n-dodecyl (meth)acrylate; tridecyl (meth)acrylate; tetradecyl (meth)acrylate; hexadecyl (meth)acrylate; 2-hydroxyethyl (meth)acrylate; 2- and 3-hydroxypropyl (meth)acrylate; 2-methoxyethyl (meth)acrylate; 2-ethoxyethyl (meth)acrylate; 2- and 3-ethoxypropyl (meth)acrylate; tetrahydrofurfuryl (meth)acrylate; alkoxylated tetrahydrofurfuryl (meth)acrylate; 2-(2-ethoxyethoxy)ethyl (meth)acrylate; cyclohexyl (meth)acrylate; glycidyl (meth)acrylate; isodecyl (meth)acrylate; lauryl (meth)acrylate; 2-phenoxyethyl (meth)acrylate; alkoxylated phenol (meth)acrylates; alkoxylated nonylphenol (meth)acrylates; cyclic trimethylolpropane formal (meth)acrylate; isobornyl (meth)acrylate; tricyclodecanemethanol (meth)acrylate; tert-butylcyclohexanol (meth)acrylate; trimethylcyclohexanol (meth)acrylate; diethylene glycol monomethyl ether (meth)acrylate; diethylene glycol monoethyl ether (meth)acrylate; diethylene glycol monobutyl ether (meth)acrylate; triethylene glycol monoethyl ether (meth)acrylate; ethoxylated lauryl (meth)acrylate; methoxy polyethylene glycol (meth)acrylates; hydroxyl ethyl-butyl urethane (meth)acrylates; 3-(2-hydroxyalkyl)oxazolidinone (meth)acrylates; and combinations thereof.

In one embodiment, the (meth)acrylate functionalized monomer may comprise a (meth)acrylate-functionalized monomer containing two or more (meth)acrylate groups per molecule.

Examples of suitable (meth)acrylate-functionalized monomers containing two or more (meth)acrylate groups per molecule include acrylate and methacrylate esters of polyols. Examples of suitable polyols are as listed above for $P_{OH}$. Such polyols may be fully or partially esterified (with (meth)acrylic acid, (meth)acrylic anhydride, (meth)acryloyl chloride or the like), provided they contain at least two (meth)acrylate functional groups per molecule.

Exemplary (meth)acrylate-functionalized monomers containing two or more (meth)acryloyloxy groups per molecule may include bisphenol A di(meth)acrylate; hydrogenated bisphenol A di(meth)acrylate; ethylene glycol di(meth)acrylate; diethylene glycol di(meth)acrylate; triethylene glycol di(meth)acrylate; tetraethylene glycol di(meth)acrylate; polyethylene glycol di(meth)acrylate; propylene glycol di(meth)acrylate; dipropylene glycol di(meth)acrylate; tripropylene glycol di(meth)acrylate; tetrapropylene glycol di(meth)acrylate; polypropylene glycol di(meth)acrylate; polytetramethylene glycol di(meth)acrylate; 1,2-butanediol di(meth)acrylate; 2,3-butanediol di(meth)acrylate; 1,3-butanediol di(meth)acrylate; 1,4-butanediol di(meth)acrylate; 1,5-pentanediol di(meth)acrylate; 1,6-hexanediol di(meth)acrylate; 1,8-octanediol di(meth)acrylate; 1,9-nonanediol di(meth)acrylate; 1,10-nonanediol di(meth)acrylate; 1,12-dodecanediol di(meth)acrylate; neopentyl glycol di(meth)acrylate; 2-methyl-2,4-pentanediol di(meth)acrylate; polybutadiene di(meth)acrylate; cyclohexane-1,4-dimethanol di(meth)acrylate; tricyclodecane dimethanol di(meth)acrylate; metallic di(meth)acrylates; modified metallic di(meth)acrylates; glyceryl di(meth)acrylate; glyceryl tri(meth)acrylate; trimethylolethane tri(meth)acrylate; trimethylolethane di(meth)acrylate; trimethylolpropane tri(meth)acrylate; trimethylolpropane di(meth)acrylate; pentaerythritol di(meth)acrylate; pentaerythritol tri(meth)acrylate; pentaerythritol tetra(meth)acrylate, di(trimethylolpropane) diacrylate; di(trimethylolpropane) triacrylate; di(trimethylolpropane) tetraacrylate, sorbitol penta(meth)acrylate; di(pentaerythritol) tetraacrylate; di(pentaerythritol) pentaacrylate; di(pentaerythritol) hexa(meth)acrylate; tris (2-hydroxyethyl) isocyanurate tri(meth)acrylate; as well as the alkoxylated (e.g., ethoxylated and/or propoxylated) derivatives thereof; and combinations thereof.

Component a) may comprise 0 to 99.5%, in particular 5 to 90%, more particularly 10 to 80%, even more particularly 15 to 75%, more particularly still 20 to 70% by weight of (meth)acrylate-functionalized monomer based on the total weight of the component a). In particular, component a) may comprise 5 to 50% or 10 to 50% or 15 to 50% or 20 to 50% or 25 to 50% or 30 to 50%, by weight of (meth)acrylate-functionalized monomer based on the total weight of component a). Alternatively, component a) may comprise 50 to 99.5% or 55 to 99.5% or 60 to 99.5% or 65 to 99.5% or 70 to 99.5%, by weight of (meth)acrylate-functionalized monomer based on the total weight of component a).

In one embodiment, the ethylenically unsaturated compound comprises a (meth)acrylate-functionalized oligomer. The ethylenically unsaturated compound may comprise a mixture of (meth)acrylate-functionalized oligomers.

The (meth)acrylate-functionalized oligomer may be selected in order to enhance the flexibility, strength and/or modulus, among other attributes, of a cured polymer prepared using Composition A.

The (meth)acrylate functionalized oligomer may have 1 to 18 (meth)acrylate groups, in particular 2 to 6 (meth)acrylate groups, more particularly 2 to 6 acrylate groups.

The (meth)acrylate functionalized oligomer may have a number average molecular weight equal or more than 600 g/mol, in particular 800 to 15,000 g/mol, more particularly 1,000 to 5,000 g/mol.

In particular, the (meth)acrylate-functionalized oligomers may be selected from the group consisting of (meth)acrylate-functionalized urethane oligomers (sometimes also referred to as "urethane (meth)acrylate oligomers," "polyurethane (meth)acrylate oligomers" or "carbamate (meth)acrylate oligomers"), (meth)acrylate-functionalized epoxy oligomers (sometimes also referred to as "epoxy (meth)acrylate oligomers"), (meth)acrylate-functionalized polyether oligomers (sometimes also referred to as "polyether (meth)acrylate oligomers"), (meth)acrylate-functionalized polydiene oligomers (sometimes also referred to as "polydiene (meth)acrylate oligomers"), (meth)acrylate-functionalized polycarbonate oligomers (sometimes also referred to as "polycarbonate (meth)acrylate oligomers"), and (meth)acrylate-functionalized polyester oligomers (sometimes also referred to as "polyester (meth)acrylate oligomers") and mixtures thereof.

Preferably, the (meth)acrylate-functionalized oligomer comprises a (meth)acrylate-functionalized urethane oligomer, more preferably an acrylate-functionalized urethane oligomer.

Advantageously, the (meth)acrylate-functionalized oligomer comprises a (meth)acrylate-functionalized urethane oligomer having two (meth)acrylate groups, more preferably an acrylate-functionalized urethane oligomer having two acrylate groups.

Exemplary polyester (meth)acrylate oligomers include the reaction products of acrylic or methacrylic acid or mixtures or synthetic equivalents thereof with hydroxyl group-terminated polyester polyols. The reaction process may be conducted such that all or essentially all of the hydroxyl groups of the polyester polyol have been (meth)acrylated, particularly in cases where the polyester polyol is difunctional. The polyester polyols can be made by polycondensation reactions of polyols (in particular, diols) and polycarboxylic acid functional compounds (in particular, dicarboxylic acids and anhydrides). The polyol and polycarboxylic acid functional compounds can each have linear, branched, cycloaliphatic or aromatic structures and can be used individually or as mixtures.

Examples of suitable epoxy (meth)acrylates include the reaction products of acrylic or methacrylic acid or mixtures thereof with an epoxy resin (polyglycidyl ether or ester). The epoxy resin may, in particular, by selected from bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)cyclohexane-1,4-dioxane, bis(3,4-epoxycyclohexylmethyl)adipate, bis(3,4-epoxy-6-methylcyclohexylmethyl)adipate, 3,4-epoxy-6-methylcyclohexyl-3',4'-epoxy-6'-methylcyclohexanecarboxylate, dicyclopentadiene diepoxide, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of a polyether polyol obtained by the addition of one or more alkylene oxides to an aliphatic polyhydric alcohol such as ethylene glycol, propylene glycol and glycerol, diglycidyl esters of aliphatic C6-C22 dibasic acids, glycidyl esters of C30-36 dimers of fatty acids, an epoxidized vegetable oil (such as epoxidized soybean oil and epoxidized linseed oil), epoxidized polybutadiene, and the like.

Suitable polyether (meth)acrylate oligomers include, but are not limited to, the condensation reaction products of acrylic or methacrylic acid or synthetic equivalents or mixtures thereof with polyetherols which are polyether polyols (such as polyethylene glycol, polypropylene glycol or polytetramethylene glycol). Suitable polyetherols can be linear or branched substances containing ether bonds and terminal hydroxyl groups. Polyetherols can be prepared by ring opening polymerization of cyclic ethers such as tetrahydrofuran or alkylene oxides (e.g., ethylene oxide and/or propylene oxide) with a starter molecule. Suitable starter molecules include water, polyhydroxyl functional materials, polyester polyols and amines.

Polyurethane (meth)acrylate oligomers (sometimes also referred to as "urethane (meth)acrylate oligomers") suitable for use in Composition A include urethanes based on aliphatic, cycloaliphatic and/or aromatic polyester polyols and polyether polyols and aliphatic, cycloaliphatic and/or aromatic polyester diisocyanates and polyether diisocyanates capped with (meth)acrylate end-groups. Suitable polyurethane (meth)acrylate oligomers include, for example, aliphatic polyesterbased urethane di- and tetra-acrylate oligomers, aliphatic polyether-based urethane di- and tetra-acrylate oligomers, as well as aliphatic polyester/polyether-based urethane di- and tetra-acrylate oligomers.

The polyurethane (meth)acrylate oligomers may be prepared by reacting aliphatic, cycloaliphatic and/or aromatic polyisocyanates (e.g., diisocyanate, triisocyanate) with OH group terminated polyester polyols, polyether polyols, polycarbonate polyols, polycaprolactone polyols, polyorganosiloxane polyols (e.g., polydimethylsiloxane polyols), or polydiene polyols (e.g., polybutadiene polyols), or combinations thereof to form isocyanate-functionalized oligomers which are then reacted with hydroxyl-functionalized (meth)acrylates (such as 2-hydroxyethyl (meth)acrylate or 3-hydroxypropyl (meth)acrylate) to provide terminal (meth)acrylate groups. For example, the polyurethane (meth)acrylate oligomers may contain two, three, four or more (meth)acrylate functional groups per molecule. Other orders of addition may also be practiced to prepare the polyurethane (meth)acrylate, as is known in the art. For example, the hydroxyl-functionalized (meth)acrylate may be first reacted with a polyisocyanate to obtain an isocyanate-functionalized (meth)acrylate, which may then be reacted with an OH group terminated polyester polyol, polyether polyol, polycarbonate polyol, polycaprolactone polyol, polydimethylsiloxane polyol, polybutadiene polyol, or a combination thereof. In yet another embodiment, a polyisocyanate may be first reacted with a polyol, including any of the aforementioned types of polyols, to obtain an isocyanate-functionalized polyol, which is thereafter reacted with a hydroxyl-functionalized (meth)acrylate to yield a polyurethane (meth)acrylate. Alternatively, all the components may be combined and reacted at the same time.

Suitable acrylic (meth)acrylate oligomers (sometimes also referred to in the art as "acrylic oligomers") include oligomers which may be described as substances having an oligomeric acrylic backbone which is functionalized with one or (meth)acrylate groups (which may be at a terminus of the oligomer or pendant to the acrylic backbone). The acrylic backbone may be a homopolymer, random copolymer or block copolymer comprised of repeating units of acrylic monomers. The acrylic monomers may be any monomeric (meth)acrylate such as C1-C6 alkyl (meth)acrylates as well as functionalized (meth)acrylates such as (meth)acrylates bearing hydroxyl, carboxylic acid and/or epoxy groups. Acrylic (meth)acrylate oligomers may be prepared using any procedures known in the art, such as by oligomerizing monomers, at least a portion of which are functionalized with hydroxyl, carboxylic acid and/or epoxy groups (e.g., hydroxyalkyl(meth)acrylates, (meth)acrylic acid, glycidyl (meth)acrylate) to obtain a functionalized oligomer intermediate, which is then reacted with one or more (meth)acrylate-containing reactants to introduce the desired (meth)acrylate functional groups.

The curable composition of the invention may comprise 0 to 99.5 %, in particular 5 to 90 %, more particularly 10 to 80 %, even more particularly 15 to 75 %, more particularly still 20 to 70 % by weight of (meth)acrylate-functionalized oligomer based on the total weight of the curable composition. In particular, the curable composition of the invention may comprise 5 to 50 % or 10 to 50 % or 15 to 50 % or 20 to 50 % or 25 to 50 % or 30 to 50 %, by weight of (meth)acrylate-functionalized oligomer based on the total weight of the curable composition. Alternatively, the curable composition of the invention may comprise 50 to 99.5 % or 55 to 99.5 % or 60 to 99.5 % or 65 to 99.5 % or 70 to 99.5 %, by weight of (meth)acrylate-functionalized oligomer based on the total weight of the curable composition.

The composition may comprise one or more ethylenically unsaturated compounds other than a (meth)acrylate-functionalized monomer or oligomer. Examples of such ethylenically unsaturated compounds include:

- polyvinylic and/or polyallylic monomers (in particular divinyl benzene, 1,4-butanediol divinyl ether, tri(ethylene glycol) divinyl ether, diallyl ether, glycerol diallyl ether, glycerol triallyl ether, trimethylolpropane diallyl ether, trimethylolpropane triallyl ether, pentaerythritol triallyl ether, pentaerythritol tetraallyl ether, diallyl phthalate, triallyl isocyanurate, 2,4,6-triallyloxy-1,3,5-triazine, glyoxal bis(diallyl acetal) and mixtures thereof);
- vinyl esters of carboxylic acids (in particular vinyl acetate, vinyl propionate, vinyl hexanoate, vinyl 2-ethylhexanoate, vinyl octanoate, vinyl pelargonate, vinyl laurate, vinyl stearate, a vinyl ester of versatic acid and mixtures thereof);
- vinyl ethers (in particular vinyl methyl ether, vinyl ethyl ether, vinyl n-butyl ether, vinyl iso-butyl ether and mixtures thereof, ethylene glycol divinyl ether, triethylene glycol divinyl ether and trimethylolpropane trivinyl ether);
- cycloaliphatic vinyl monomers (in particular vinylcyclohexane);
- olefins (in particular ethylene, propene, 1-butene, isobutylene, diisobutylene, 1-nonene, 1-decene and mixtures thereof);
- conjugated dienes (in particular butadiene, isoprene, pentadiene, chlorodiene and mixtures thereof);
- vinyl aromatic monomers (in particular styrene, alpha-methylstyrene, tertbutylstyrene, ortho-, meta-, and para-methylstyrene, ortho-, meta- and paraethylstyrene, o-methyl-p-isopropylstyrene, p-chlorostyrene, p-bromostyrene, o,p-dichlorostyrene, o,p-dibromostyrene, ortho-, meta- and paramethoxystyrene, optionally substituted indenes, optionally substituted vinylnaphthalenes, acenaphthylene, diphenylethylene, vinyl anthracene and mixtures thereof);
- mono- or dicarboxylic acid monomers, cyclic anhydride monomers and salts thereof (in particular 3-butenoic acid, crotonic acid, vinyl acetic acid, fumaric acid, maleic acid, maleic anhydride, tetrahydrophthalic acid, tetrahydrophthalic anhydride, itaconic acid, mesaconic acid, citraconic acid, glutaconic acid, muconic acid and mixtures thereof);
- unsaturated polymers such as polybutadiene;
- as well as the alkoxylated (e.g., ethoxylated and/or propoxylated) derivatives thereof
- and mixtures thereof.

*Cationically polymerizable compounds*

The curable composition of the present invention may further comprise a cationically polymerizable compound. The curable composition may comprise a mixture of cationically polymerizable compounds.

The term "cationically-polymerizable compound" means a compound (other than an ethylenically unsaturated compound) comprising at least one polymerizable functional group which polymerizes via a cationic mechanism, for example a heterocyclic group. In a cationic polymerization mechanism, a cationic initiator forms a Bronsted or Lewis acid species that binds to the cationically-polymerizable compound which then becomes reactive and leads to chain growth by reaction with another cationically-polymerizable compound.

The cationically polymerizable compound may be selected from epoxides, oxetanes, oxolanes, cyclic acetals, cyclic lactones, thiiranes, thiethanes, spiro orthoesters, and mixtures thereof.

In a preferred embodiment, the cationically polymerizable compound may be selected from epoxides, oxetanes and mixtures thereof.

Examples of suitable polyepoxides are as listed above for $P_{EPOX}$. Examples of suitable cycloaliphatic polyepoxides are as listed above for $P_{CYCLO\ EPOX}$.

Examples of suitable oxetanes include trimethylene oxide, 3,3-dimethyloxetane, 3,3-dichloromethyloxetane, 3-ethyl-3-phenoxymethyloxetane, and bis(3-ethyl-3-methyloxy)butane, 3-ethyl-3-oxetanemethanol.

Examples of suitable oxolanes include tetrahydrofuran and 2,3-dimethyltetrahydrofuran.

Examples of suitable cyclic acetals include trioxane, 1,3-dioxolane, and 1,3,6-trioxanecyclooctane.

Examples of suitable cyclic lactones include $\beta$-propiolactone and $\varepsilon$-caprolactone.

Examples of suitable thiiranes include ethylene sulfide, 1,2-propylene sulfide, and thioepichlorohydrin.

Examples of suitable thiethanes capable of being cationically polymerized include trimethylene sulfide, 2-propylthietane and 3,3-dimethylthiethane.

Examples of suitable spiro orthoesters capable of being cationically polymerized are compounds obtained by the reaction of an epoxy compound and a lactone.

When the composition of the invention comprises a cationically polymerizable compound, it may further comprise a polyol. Suitable polyols are as listed above for POH.

The curable composition of the invention may comprise 10 to 80%, in particular 15 to 75%, more particularly 20 to 70%, by weight of cationically polymerizable compound based on the total weight of the curable composition.

*Polyol and Thiol*

When the composition of the invention comprises a cationically polymerizable compound, it may further comprise a polyol and/or a polythiol. Suitable polyols and polythiols are as listed above for $P_{OH}$ and $P_{SH}$.

Polyols may be of particular use when the composition of the invention comprises a cationically polymerizable compound.

Polythiols may be of particular use when the composition of the invention comprises an ethylenically unsaturated compound other than a (meth)acrylate-functionalized monomer or oligomer, in particular a polyvinylic and/or polyallylic monomer.

The amount of polyol and polythiol in the curable composition will vary depending on the type of compound that is used. Typically, however, the curable composition is formulated to comprise from 0 to 10%, from 0.5 to 8%, from 1 to 5% or from 1.5 to 4%, by weight of polyol and/or polythiol based on the weight of the curable composition.

*Additives*

The curable composition of the present invention may further comprise an additive. The curable composition may comprise a mixture of additives.

In particular, the additive may be selected from sensitizers, amine synergists, stabilizers, antioxidants, light blockers, polymerization inhibitors, foam inhibitors, flow or leveling agents, colorants, pigments, dispersants (wetting agents, surfactants), slip additives, fillers, thixotropic agents, matting agents, impact modifiers, waxes and mixtures thereof; and any other additive conventionally used in the coating, sealant, adhesive, molding, 3D printing or ink arts.

According to some embodiments, the curable composition may comprise a stabilizer.

Stabilizers may be introduced in the curable composition of the present invention in order to provide adequate storage stability and shelf life. Further, stabilizers may be used during the preparation of the curable composition, to protect against unwanted reactions during processing of the ethylenically unsaturated components of the curable composition. A stabilizer may be a compound or substance which retards or prevents reaction or curing of actinically-polymerizable functional groups present in a composition in the absence of actinic radiation. However, it will be advantageous to select an amount and type of stabilizer such that the composition remains capable of being cured when exposed to actinic radiation (that is, the stabilizer does not prevent radiation curing of the composition). The stabilizer may, in particular be a free radical stabilizer (i.e. a stabilizer which functions by inhibiting free radical reactions).

Any of the stabilizers known in the art related to (meth)acrylate-functionalized compounds may be utilized in the present invention. Quinones represent a particularly preferred type of stabilizer which can be employed in the context of the present invention. As used herein, the term "*quinone*" includes both quinones and hydroquinones as well as ethers thereof such as monoalkyl, monoaryl, monoaralkyl and bis(hydroxyalkyl) ethers of hydroquinones. Hydroquinone monomethyl ether is an example of a suitable stabilizer which can be utilized. Other stabilizers known in the art such as hydroquinone (HQ), 4-tert-butylcatechol (TBC), 3,5-di-tertiobutyl-4-hydroxytoluene (BHT), phenothiazine (PTZ), pyrogallol, phosphite compounds, triphenyl antimony and tin(II) salts.

The concentration of stabilizer in the curable composition will vary depending upon the particular stabilizer or combination of stabilizers selected for use and also on the degree of stabilization desired and the susceptibility of components in the curable compositions towards degradation in the absence of stabilizer. Typically, however, the curable composition is formulated to comprise from 5 to 5000 ppm stabilizer. According to certain embodiments of the invention, the reaction mixture during each stage of the method employed to make the curable composition contains at least some stabilizer, e.g., at least 10 ppm stabilizer.

The curable composition may comprise a colorant. A colorant may be a dye, a pigment and mixtures thereof. The term "dye", as used herein means a colorant having a solubility of 10 mg/L or more in the medium in which it is introduced at 25°C. The term "pigment" is defined in DIN 55943, as a colorant that is practically insoluble in the application medium under the pertaining ambient conditions, hence having a solubility of less than 10 mg/L therein at 25°C. The term "C.I." is used as an abbreviation for Colour Index.

The colorant may be a pigment. Organic and/or inorganic pigments may be used. If the colorant is not a self-dispersible pigment, the inkjet inks preferably also contain a dispersant, more preferably a polymeric dispersant. The pigment may be black, cyan, magenta, yellow, red, orange, violet, blue, green, brown and mixtures thereof. Pigments may be chosen from those disclosed by HERBST, Willy, et al. Industrial Organic Pigments, Production, Properties, Applications. 3rd edition. Wiley - VCH , 2004. ISBN 3527305769.

Particular pigments include:

- Carbon black;
- C.I. Pigment White 1, 3, 4, 5, 6, 7, 10, 11, 12, 14, 17, 18, 19, 21, 24, 25, 27, 28 and 32;
- C.I. Pigment Yellow 1, 3, 10, 12, 13, 14, 17, 55, 65, 73, 74, 75, 83, 93, 97, 109, 111, 120, 128, 138, 139, 150, 151, 154, 155, 180, 185 and 213;
- C.I. Pigment Red 17, 22, 23, 41, 48:1 , 48:2, 49:1, 49:2, 52:1,57:1,81 :1, 81 :3, 88, 112, 122, 144, 146, 149, 169, 170, 175, 176, 184, 185, 188, 202, 206, 207, 210, 216, 221, 248, 251, 254, 255, 264, 270 and 272;
- C.I. Pigment Violet 1, 2, 19, 23, 32, 37 and 3;
- C.I. Pigment Blue 15:1, 15:2, 15:3, 15:4, 15:6, 16, 56, 61 and (bridged) aluminium phthalocyanine pigments;
- C.I. Pigment Orange 5, 13, 16, 34, 40, 43, 59, 66, 67, 69, 71 and 73;
- C.I. Pigment Green 7 and 36;
- C.I. Pigment Brown 6 and 7;

and mixtures thereof.

The curable composition of the invention may comprise a dispersant. The dispersant may be used to disperse an insoluble material such as a pigment or filler in the curable composition.

The dispersant may be a polymeric dispersant, a surfactant and mixtures thereof.

Typical polymeric dispersants are copolymers of two, three, four, five or even more monomers. The properties of polymeric dispersants depend on both the nature of the monomers and their distribution in the polymer. Copolymeric dispersants preferably have the following polymer compositions:

- random copolymer (e.g. ABBAABAB);
- alternating copolymer (e.g. ABABABAB);
- gradient copolymer (e.g. AAABAABBABBB) ;
- block copolymers (e.g. AAAAABBBBBB);
- graft copolymers (polymeric backbone with polymeric side chains attached to the backbone);

and mixed forms of these copolymers.

The polymeric dispersant may have a number average molecular weight Mn between 500 and 30,000 g/mol, more preferably between 1,500 and 10,000 g/mol.

Commercial examples of polymeric dispersants include:

- DISPERBYK® dispersants available from BYK CHEMIE GMBH;
- SOLSPERSE® dispersants available from LUBRIZOL;
- TEGO® DISPERSE dispersants from EVONIK;
- DISPEX®, EFKA® and JONCRYL® dispersants from BASF;
- DISPONER® dispersants from ELEMENTIS.

*Solvents*

The curable composition of the invention may comprise a solvent. As used herein, the term "solvent" means a non-reactive organic solvent, i.e. a solvent comprising carbon and hydrogen atom that does not react when exposed to the actinic radiation used to cure the curable compositions described herein.

Advantageously, the curable composition of the present invention may be formulated to be solvent-free. For example, the curable composition of the present invention may contain little or no solvent, e.g., less than 10 %, or less than 5 %, or less than 1 %, or even 0 % by weight of solvent, based on the total weight of the curable composition.

According to some embodiments, the curable composition is a liquid at 25°C. In various embodiments of the invention, the curable compositions described herein are formulated to have a viscosity of less than 10,000 mPa.s, or less than 5,000 mPa.s, or less than 1,000 mPa.s, or less than 500 mPa.s, or less than 250 mPa.s, or even less than 100 mPa.s as measured at 25°C using a Brookfield viscometer, model DV-II, using a 27 spindle (with the spindle speed varying typically between 20 and 200 rpm, depending on viscosity). In advantageous embodiments of the invention, the viscosity of the curable composition is from 10 to 10,000 mPa.s, or from 10 to 5,000 mPa.s, or from 10 to 1,000 mPa.s, or from 10 to 500 mPa.s, or from 10 to 250 mPa.s, or from 10 to 100 mPa.s at 25°C.

*Formulations*

The curable compositions described herein may be compositions that are to be subjected to curing by means

of free radical polymerization. In particular embodiments, the curable compositions may be photocured (i.e., cured by exposure to actinic radiation, in particular UV, near-UV, visible, infrared and/or near-infrared radiation).

The curable composition of the invention may be an ink composition, a coating composition, an adhesive composition, a sealant composition, a molding composition, a dental composition, a nail polish composition or a 3D-printing composition.

End use applications for the curable compositions include, but are not limited to, inks, coatings, adhesives, additive manufacturing resins (such as 3D printing resins), molding resins, sealants, composites, antistatic layers, electronic applications, recyclable materials, smart materials capable of detecting and responding to stimuli, packaging materials, personal care articles, nail polishes, articles for use in agriculture, water or food processing, or animal husbandry, and biomedical materials. The curable compositions of the invention thus find utility in the production of biocompatible articles. Such articles may, for example, exhibit high biocompatibility, low cytotoxicity and/or low extractables.

The composition according to the invention may in particular be used to obtain a cured product according to the following processes.

## Process for the preparation of a cured product

The process for the preparation of a cured product according to the invention comprises curing the curable composition of the invention. In particular, the curable composition may be cured by exposing the composition to radiation. More particularly, the curable composition may be cured by exposing the composition to UV, near-UV, visible, infrared and/or near-infrared radiation. The curable composition may advantageously be cured by exposing the composition to a LED light source.

Curing may be accelerated or facilitated by supplying energy to the curable composition, such as by heating the curable composition. Thus, the cured product may be deemed as the reaction product of the curable composition, formed by curing. A curable composition may be partially cured by exposure to actinic radiation, with further curing being achieved by heating the partially cured article. For example, a product formed from the curable composition may be heated at a temperature of from 40°C to 120°C for a period of time from 5 minutes to 12 hours.

Prior to curing, the curable composition may be applied to a substrate surface in any known conventional manner, for example, by spraying, jetting, knife coating, roller coating, casting, drum coating, dipping, and the like and combinations thereof. Indirect application using a transfer process may also be used.

The substrate on which the curable composition is applied and cured may be any kind of substrate. Suitable substrates are detailed below. When used as an adhesive, the curable composition may be placed between two substrates and then cured, the cured composition thereby bonding the substrates together to provide an adhered article. Curable compositions in accordance with the present invention may also be formed or cured in a bulk manner (e.g., the curable composition may be cast into a suitable mold and then cured).

The substrate may be a ceramic, metallic, mineral, cellulosic, animal-based or polymeric substrate. The substrate may also be a part of a human body, such as a tooth or a nail.

The substrate may be porous or substantially non-porous. The substrates may be transparent, translucent or opaque.

Examples of ceramic substrates include alumina-based ceramics and zirconiabased ceramics.

Examples of metallic substrates include titanium, gold, silver, copper, brass, steel and bronze.

Examples of mineral substates include glass, asbestos and basalt.

Examples of cellulosic substrates include plain paper or resin coated paper (e.g. polyethylene or polypropylene coated paper). There is no real limitation on the type of paper and it includes newsprint paper, magazine paper, office paper, wallpaper but also paper of higher grammage, usually referred to as boards, such as white lined chipboard, corrugated board and packaging board. Further examples of cellulosic substrates include bamboo, cotton, flax, hemp, jute, lyocell, modal, rayon, raffia, ramie and sisal.

Examples of cellulosic substrates include wool, fur, silk and leather.

Examples of polymeric substrates include polyethylene, polypropylene, polycarbonate, polyvinyl chloride, polyethylene terephthalate, polyethylene naphthalate, polylactide, polyamide, polyimide, polyacrylonitrile, polyurethane, acrylonitrile butadiene styrene.

There is no restriction on the shape of the substrate. It can be a sheet, a film, a nonwoven or woven fiber mat or a three dimensional object.

In particular, the substrate may be selected from a food and beverage packaging, a pharmaceutical packaging, a textile, a nail, a tooth, a medical device, a food and beverage processing equipment, a water pipe.

The cured product obtained with the process of the invention may be an ink, a coating, an adhesive, a sealant, a molded article, a dental material, a nail polish or a 3D-printed article.

## Process of 3D printing

A 3D-printed article may, in particular, be obtained with a 3D printing process that comprises printing a 3D article with the composition of the invention. In particular, the process may comprise printing a 3D article layer by layer or continuously.

Three-dimensional (3D) printing (also referred to as additive manufacturing) is a process in which a 3D digital model is manufactured by the accretion of construction material. The 3D printed object is created by utilizing the computer-aided design (CAD) data of an object through sequential construction of two dimensional (2D) layers or slices that correspond to cross-sections of 3D objects. The radiation can be in the form of electromagnetic waves or an electron beam. The most commonly applied energy source is UV, near-UV, visible, infrared and/or near-infrared radiation.

A plurality of layers of a curable composition in accordance with the present invention may be applied to a substrate surface; the plurality of layers may be simultaneously cured (by exposure to a single dose of radiation, for example) or each layer may be successively cured before application of an additional layer of the curable composition.

Non-limiting examples of suitable 3D printing processes include stereolithography (SLA); digital light process (DLP); liquid crystal device (LCD); inkjet head (or multjet) printing; Continuous Liquid Interface Production (CLIP); extrusion type processes such as continuous fiber 3D printing and cast-in-motion 3D printing; and volumetric 3D printing. The building method may be "layer by layer" or continuous. The liquid may be in a vat, or deposited with an inkjet or gel deposition, for example.

Stereolithography and other photocurable 3D printing methods typically apply low intensity light sources to radiate each layer of a photocurable resin to form the desired article. As a result, photocurable resin polymerization kinetics and the green strength of the printed article are important criteria if a particular photocurable resin will sufficiently polymerize (cure) when irradiated and have sufficient green strength to retain its integrity through the 3D printing process and post-processing.

The curable compositions of the invention may be used as 3D printing resin formulations, that is, compositions intended for use in manufacturing three-dimensional articles using 3D printing techniques. Such three-dimensional articles may be free-standing/self-supporting and may consist essentially of or consist of a composition in accordance with the present invention that has been cured. The three-dimensional article may also be a composite, comprising at least one component consisting essentially of or consisting of a cured composition as previously mentioned as well as at least one additional component comprised of one or more materials other than such a cured composition (for example, a metal component or a thermoplastic component or inorganic filler or fibrous reinforcement). The curable compositions of the present invention are particularly useful in digital light printing (DLP), although other types of three-dimensional (3D) printing methods may also be practiced using the inventive curable compositions (e.g., SLA, inkjet, multi-jet printing, piezoelectric printing, actinically-cured extrusion, and gel deposition printing). The curable compositions of the present invention may be used in a three-dimensional printing operation together with another material which functions as a scaffold or support for the article formed from the curable composition of the present invention.

Thus, the curable compositions of the present invention are useful in the practice of various types of three-dimensional fabrication or printing techniques, including methods in which construction of a three-dimensional object is performed in a stepwise or layer-by-layer manner. In such methods, layer formation may be performed by solidification (curing) of the curable composition under the action of exposure to radiation, such as visible, UV or other actinic irradiation. For example, new layers may be formed at the top surface of the growing object or at the bottom surface of the growing object. The curable compositions of the present invention may also be advantageously employed in methods for the production of three-dimensional objects by additive manufacturing wherein the method is carried out continuously. For example, the object may be produced from a liquid interface. Suitable methods of this type are sometimes referred to in the art as "*continuous liquid interface (or interphase) product (or printing)*" ("CLIP") methods. Such methods are described, for example, in WO 2014/126830; WO 2014/126834; WO 2014/126837; and Tumbleston et al., "Continuous Liquid Interface Production of 3D Objects", Science Vol. 347, Issue 6228, pp. 1349-1352 (March 20, 2015.

The curable composition may be supplied by ejecting it from a printhead rather than supplying it from a vat. This type of process is commonly referred to as inkjet or multijet 3D printing. One or more UV curing sources mounted just behind the inkjet printhead cures the curable composition immediately after it is applied to the build surface substrate or to previously applied layers. Two or more printheads can be used in the process which allows application of different compositions to different areas of each layer. For example, compositions of different colors or different physical properties can be simultaneously applied to create 3D printed parts of varying composition. In a common usage, support materials - which are later removed during post-processing - are deposited at the same time as the compositions used to create the desired 3D printed part. The printheads can operate at temperatures from about 25°C up to about 100°C. Viscosities of the curable compositions are less than 30 mPa.s at the operating temperature of the printhead.

The process for the preparation of a 3D-printed article may comprise the steps of:

a) providing (e.g., coating) a first layer of a curable composition in accordance with the present invention onto a

surface;
b) curing the first layer, at least partially, to provide a cured first layer;
c) providing (e.g., coating) a second layer of the curable composition onto the cured first layer;
d) curing the second layer, at least partially, to provide a cured second layer adhered to the cured first layer; and
e) repeating steps c) and d) a desired number of times to build up the three-dimensional article.

Alternatively, the process for the preparation of a 3D-printed article may comprise the steps of:

a) providing a carrier and an optically transparent member having a build surface, the carrier and build surface defining a build region therebetween;
b) filling the build region with a composition as defined above;
c) continuously or intermittently curing part of the composition in the build region according to the method as defined above to form a cured composition; and
d) continuously or intermittently advancing the carrier away from the build surface to form the 3D-printed article from the cured composition.

After the 3D article has been printed, it may be subjected to one or more post-processing steps. The post-processing steps can be selected from one or more of the following steps removal of any printed support structures, washing with water and/or organic solvents to remove residual resins, and post-curing using thermal treatment and/or actinic radiation either simultaneously or sequentially. The post-processing steps may be used to transform the freshly printed article into a finished, functional article ready to be used in its intended application.

## Process of inkjet printing

The process of inkjet printing according to the invention comprised jetting the curable composition of the invention onto a substrate.

The substrate on which the curable composition is jetted may be any kind of substrate. Suitable substrates are as detailed above.

The curable composition may be jetted by one or more print heads ejecting small droplets in a controlled manner through nozzles onto a substrate moving relative to the print head(s).

The print head may be a piezoelectric head or a continuous type print head.

The inkjet printing process may be carried out in a single pass or with a multi-pass printing mode.

The inkjet printing process may further comprise a UV-curing step. In inkjet printing, the UV curing device may be arranged in combination with the print head of the inkjet printer, travelling therewith so that the liquid UV curable inkjet ink is exposed to curing radiation very shortly after been jetted.

In a particularly preferred embodiment, the UV curing step is performed using UV LED light sources.

For facilitating curing, the inkjet printer may include one or more oxygen depletion units. The oxygen depletion units place a blanket of nitrogen or other relatively inert gas (e.g. $CO_2$), with adjustable position and adjustable inert gas concentration, in order to reduce the oxygen concentration in the curing environment.

## Process of coating a nail

The process of coating a nail according to the invention comprises applying the curable composition of the invention on a nail, and curing the composition on the nail.

## Uses

The compound of formula (1) or (2) of the invention or the photoinitiator composition of the invention may be used as a photoinitiator or a photoinitiating system in a radiation curable composition, in particular in a UV or LED-curable composition.

As used herein, *"UV curable composition"* means a composition cured by exposure to UV light emitted by a mercury light source, in particular a mercury-vapor lamp, and "*LED-curable composition*" means curing by exposure to UV light emitted by a LED light source, in particular a LED light source having an emission band in the range from 365 to 420 nm.

The compound of formula (1) or (2) of the invention or the photoinitiator composition of the invention may be used in a photopolymerization reaction. The photopolymerization reaction may be used to cure one or more ethylenically unsaturated compounds as defined above.

The compound of formula (1) or (2) of the invention or the photoinitiator composition of the invention may be

used to obtain a cured product having a reduced amount of extractables. In particular, the cured product may be an ink, an overprint varnish, a coating, an adhesive, a sealant, a molded article, a dental material, a nail-polish or a 3D-printed article.

The reduction in the amount of extractables may be assessed in comparison with a cured product obtained with a conventional photoinitiator.

The extractables may be any component that migrates from the cured product. In particular, the extractables may be a photoinitiator or a residue thereof.

Migration in inkjet inks may occur in different ways:

- Penetration Migration - through the substrate to the reverse-side of the print;
- Set-off Migration - from the printed side of a substrate to the reverse side of the substrate while stacked or stored on a roll;
- Vapor-phase migration - evaporation of volatile compounds when heated;
- Condensation Extraction - condensation of critical compounds when cooked or sterilized.

The amount of extractables may be determined quantitatively using a suitable analytical method such as liquid chromatography mass spectroscopy (LC-MS). For example, the curable composition can be applied in 12 μm thickness film on a glass substrate, and crosslinked using a UV Hg lamp. Resulting cured films are removed from the glass plate, weighed and soaked in solvent such as acetonitrile or dichloromethane. The liquid fraction is finally evaporated and the residue, corresponding to the extractables part, is weighed, allowing to determine the amount of product that is uncured (not trapped within the photocured network).

Analytical methods such as nuclear magnetic resonance (NMR), liquid chromatography mass spectroscopy (LC-MS) or gas chromatography mass spectroscopy (GC-MS) may then be used to identify the nature of the extractables and refine their corresponding content.

In particular, the cured product may have less than 5 %, less than 2 %, less than 1 %, less than 0.5 %, less than 0.25 % or less than 0.1 %, by weight of extractables based on the weight of the cured product.

The curable composition of the invention may be used to obtain an ink, an overprint varnish, a coating, an adhesive, a sealant, a molded article, a dental material or a 3D-printed article, in particular an ink.

Within this specification, embodiments have been described in a way which enables a clear and concise specification to be written, but it is intended and will be appreciated that embodiments may be variously combined or separated without departing from the invention. For example, it will be appreciated that all preferred features described herein are applicable to all aspects of the invention described herein.

Although the invention is illustrated and described herein with reference to specific embodiments, the invention is not intended to be limited to the details shown. Rather, various modifications may be made in the details within the scope and range of equivalents of the claims and without departing from the invention.

## EXAMPLES

The following examples illustrate the invention without limiting it.

### Example 1: Synthesis of Precursor 1

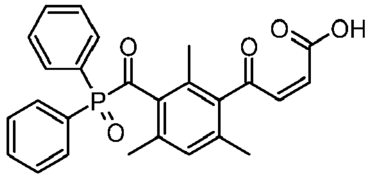

To an ice-cooled solution of 2,4,6-trimethylbenzoyldiphenylphosphine oxide (SpeedCure® TPO from Arkema - 85.0 g, 244 mmol) and maleic anhydride (28.7 g, 293 mmol) in dichloromethane (850 mL) was added aluminium chloride (129 g, 968 mmol) portion-wise over 1 h while maintaining the reaction temperature at 5-10 °C. The resulting deep red solution was heated at 30-32°C for 48 h. The mixture was allowed to cool to 20°C, then was poured into ice water (approx. 1 L) with stirring. Dichloromethane was removed from the biphasic mixture by concentration under reduced pressure, then the resulting aqueous slurry was filtered to obtain the crude solid product. The product was washed repeatedly with water, then was suspended in toluene (500 mL) and filtered. The obtained solid was thoroughly dried

in a vacuum oven at 60°C, giving **Precursor** 1 as a pale yellow powder (97 g, 89%).

**Example 2: Synthesis of Precursor 2**

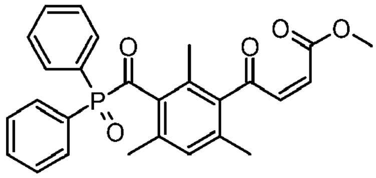

To an ice-cooled solution of **Precursor 1** (10.0 g, 22.4 mmol) and triethylamine (9.4 mL, 67.2 mmol) in toluene (150 mL) was added trimethylacetyl chloride (3.0 mL, 24.6 mmol) over 20 minutes and the resulting mixture was stirred at 5-10°C for 30 minutes. Methanol (9.1 mL, 224 mmol) was added in one portion and the solution was stirred for a further 30 minutes. Volatiles were removed under reduced pressure and the residue was dissolved in ethyl acetate (100 mL). The organic solution was washed with 1M HCl (3 × 75 mL), saturated NaHCOs solution (3 × 75 mL) and brine (75 mL), then was dried ($MgSO_4$), filtered and concentrated under reduced pressure to give **Precursor 2** as a pale-yellow solid (8.50 g, 82%).

**Example 3: Synthesis of Photoinitiator 1**

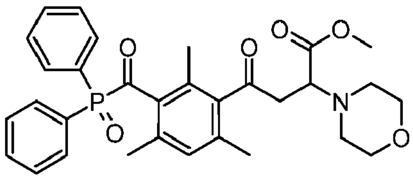

To a stirred solution of **Precursor 2** (4.0 g, 8.69 mmol) in methanol (45 mL) was added morpholine (1.5 mL, 17.4 mmol) and the resulting solution was stirred at 20°C for 30 minutes. Volatiles were removed under reduced pressure and the resulting residue was re-dissolved in ethyl acetate (40 mL) and washed with deionised water (3 × 30 mL) and brine (40 mL), then the organic phase was dried ($MgSO_4$), filtered and concentrated under reduced pressure to give **Photoinitiator 1** as a pale-orange solid (3.48 g, 73%).

**Example 4: Synthesis of Photoinitiator 2**

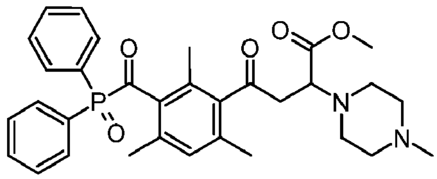

To a stirred solution of **Precursor 2** (4.45 g, 9.66 mmol) in methanol (50 mL) was added 1-methylpiperazine (2.2 ml, 19.3 mmol) and the resulting solution was stirred at 20°C for 30 minutes. Volatiles were removed under reduced pressure and the resulting residue was re-dissolved in ethyl acetate (40 mL) and washed with deionised water (3 × 30 mL) and brine (40 mL), then the organic phase was dried ($MgSO_4$), filtered and concentrated under reduced pressure to give **Photoinitiator 2** as an orange solid (3.20 g, 59%, single isomer).

**Example 5: Synthesis of Precursor 3**

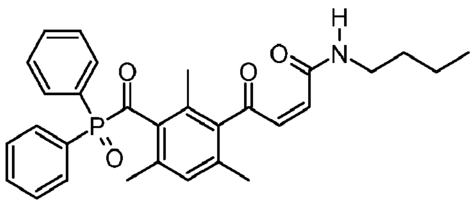

To an ice-cooled solution of **Precursor 1** (14.0 g, 31.4 mmol) and triethylamine (13.1 mL, 94.1 mmol) in toluene (250 mL) was added trimethylacetyl chloride (4.2 mL, 34.5 mmol) over 20 minutes and the resulting mixture was stirred at 5-10°C for 30 minutes. n-Butylamine (3.4 mL, 34.5 mmol) was added in one portion and the solution was stirred for a further 30 minutes. Volatiles were removed under reduced pressure and the residue was dissolved in ethyl acetate (150 mL). The organic solution was washed with 1M HCl (3 × 100 mL), saturated NaHCOs solution (3 × 100 mL) and brine (120 mL), then was dried ($MgSO_4$), filtered and concentrated under reduced pressure to give **Precursor 3** as a colourless solid. (15.1 g, 96%).

<u>**Example 6: Synthesis of Photoinitiator 3**</u>

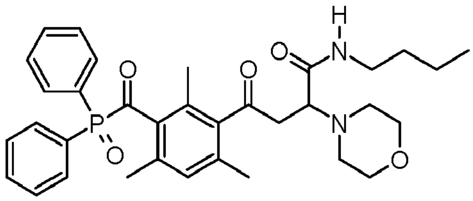

To a stirred solution of **Precursor 3** (4.0 g, 7.98 mmol) in methanol (60 mL) was added morpholine (1.4 ml, 16.0 mmol) and the resulting solution was stirred at 20°C for 30 minutes. Volatiles were removed under reduced pressure and the resulting residue was re-dissolved in ethyl acetate (40 mL) and washed with deionised water (3 × 30 mL) and brine (40 mL), then the organic phase was dried ($MgSO_4$), filtered and concentrated under reduced pressure to give **Photoinitiator 3** as an off-white solid. (3.55 g, 76%, single isomer).

<u>**Example 7 : Synthesis of Photoinitiator 4**</u>

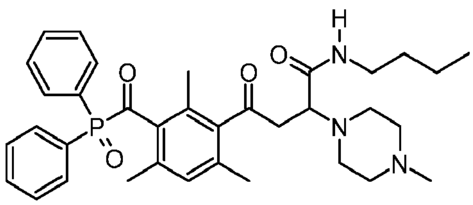

To a stirred solution of **Precursor 3** (4.50 g, 8.97 mmol) in methanol (60 mL) was added *N*-methylpiperazine (2.0 mL, 17.9 mmol) and the resulting solution was stirred at 20°C for 30 minutes. Volatiles were removed under reduced pressure and the resulting residue was re-dissolved in ethyl acetate (40 mL) and washed with deionised water (3 × 30 mL) and brine (40 mL), then the organic phase was dried ($MgSO_4$), filtered and concentrated under reduced pressure to give **Photoinitiator 4** as a glassy solid. (3.70 g, 69%, single isomer).

<u>**Example 8: Synthesis of Photoinitiator 5**</u>

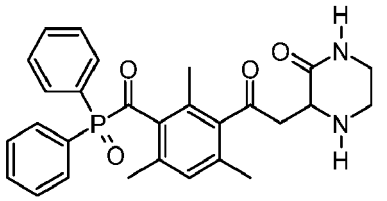

To an ice-cooled suspension of **Precursor 1** (10.0 g, 22.4 mmol) and triethylamine (12.0 mL, 86.1 mmol) in toluene (100 mL) was added trimethylacetyl chloride (3.0 mL, 24.5 mmol) at 0-5°C and the resulting solution was stirred at 0-5°C for 30 minutes. Methanol (60 mL) was added and the mixture was stirred at 30-35°C for 1 h. The mixture was allowed to cool to 20°C, then ethylenediamine (1.80 g, 28.0 mmol) was added and the solution was stirred at 20°C for 16 h. Methanol was removed by concentration under reduced pressure, then the resulting residue was dissolved in ethyl acetate (100 mL) and the organic solution was washed with water (100 mL), 10 wt% aqueous sodium carbonate solution (100 mL) and brine (50 mL), then dried ($MgSO_4$), filtered and concentrated under reduced pressure to give the crude product, which was washed with cold *tert*-butyl methyl ether to give the pure **Photoinitiator 5** as a pale yellow solid (10.0 g, 91%).

**Example 9: Synthesis of Precursor 4**

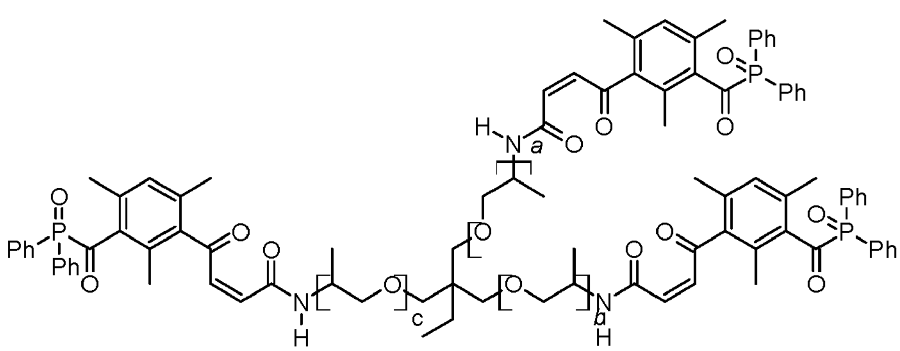

To a stirred, ice-cooled suspension of **Intermediate 1** (105 g, 235 mmol) and triethylamine (120 mL, 861 mmol) in toluene (1.2 L) was added trimethylacetyl chloride (28.8 mL, 235 mmol) at 5-10°C over 10 minutes and the resulting suspension was stirred at 5-10°C for 35 minutes. A trifuncitional primary amine having repeating oxypropylene units and an average molecular weight of 440 g/mol (Jeffamine® T403 from Hunstman - 34.2 g, 77.7 mmol) was added at 5-10°C and the mixture was allowed to warm to 20°C, then was stirred for a further 16 h. Water (1 L) was added and the layers were separated. The organic phase was washed with 2M hydrochloric acid (500 mL), 10% w/w aqueous sodium carbonate solution (250 mL) and brine (200 mL), then was dried ($MgSO_4$), filtered and concentrated under reduced pressure to give **Precursor 4** as a pale cream-coloured solid (124 g, 92%).

**Example 10: Synthesis of Photoinitiator 6**

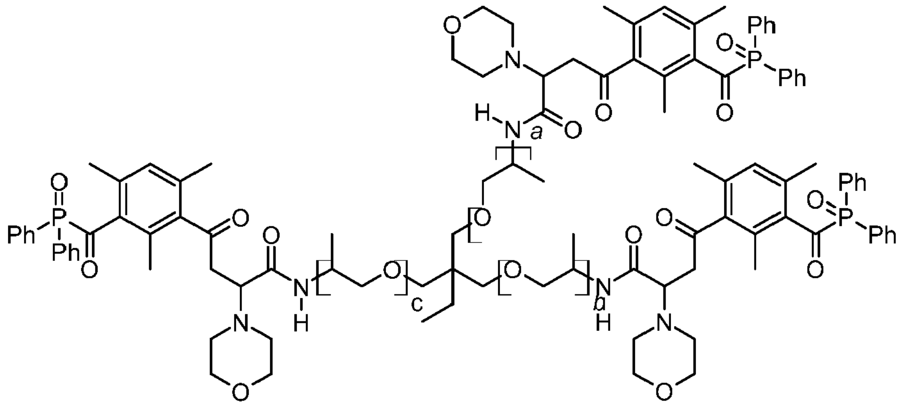

To a solution of **Precursor 4** (5.30 g, 3.08 mmol) in methanol (60 mL) was added morpholine (5.0 mL, 57.4 mmol) and the resulting solution was stirred at 20°C for 4 h. The mixture was concentrated under reduced pressure to remove methanol, then the resulting residue was re-dissolved in ethyl acetate (100 mL) and the organic solution was washed with water (2 × 100 mL) and brine (50 mL), then dried ($MgSO_4$), filtered and concentrated under reduced pressure to give **Photoinitiator 6** as a colourless solid (5.6 g, 92%).

## Example 11: Synthesis of Photoinitiator 7

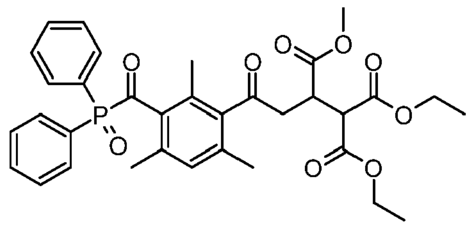

To a solution of **Precursor 2** (1.00 g, 2.17 mmol) and diethyl malonate (0.42 g, 2.60 mmol) in *N*,*N*-dimethylformamide (10 mL) was added potassium carbonate (1.00 g, 7.24 mmol) and the resulting suspension was heated at 60°C for 1 h. The mixture was allowed to cool to 20°C, then ethyl acetate (100 mL) and water (50 mL) were added, followed by 1M hydrochloric acid (20 mL), and the biphasic mixture was shaken vigorously and separated. The organic phase was washed with saturated sodium bicarbonate solution (50 mL) and brine (50 mL) then was dried ($MgSO_4$), filtered and concentrated under reduced pressure to give the crude product. Column chromatography (eluting with 1:1 petrol-ethyl acetate) gave pure **Photoinitiator 7** as pale yellow liquid (1.20 g, 89%).

## Example 12: Synthesis of Precursor 5

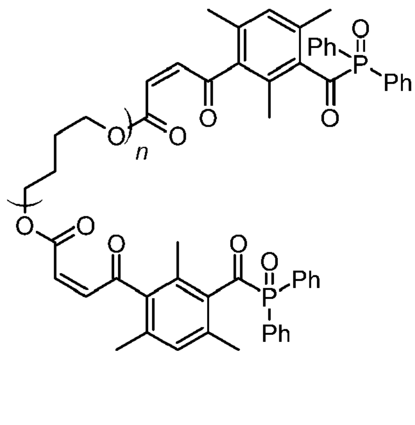

To a suspension of **Precursor 1** (15.0 g, 33.6 mmol) and a poly(tetrahydrofuran) having a number average molecular weight of 250 g/mol (4.20 g, 16.8 mmol) in toluene (90 mL) was added methanesulphonic acid (1.5 mL, 23.1 mmol) and the resulting mixture was heated at reflux temperature for 8 h, while water was continuously removed using a Dean-Stark apparatus. The mixture was allowed to cool to 20°C, then 5 wt% aqueous sodium carbonate solution (100 mL) was added and the layers were separated. The organic phase was washed with brine (50 mL), dried ($MgSO_4$), filtered and concentrated under reduced pressure to give **Precursor 5** as a yellow glassy solid (17.2 g, 92%).

**Example 13: Synthesis of Photoinitiator 8**

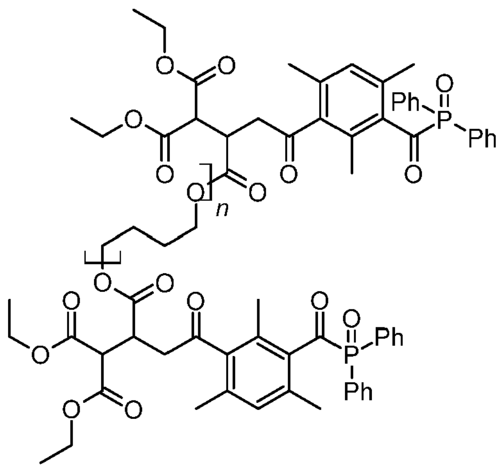

To a solution of **Precursor 5** (3.00 g, 2.71 mmol) and diethyl malonate (0.92 g, 5.69 mmol) in 2-butanone (40 mL) was added potassium carbonate (1.87 g, 13.5 mmol) and the resulting suspension was heated to 85°C for 3 h. The mixture was allowed to cool to 40°C and the solvent was removed by distillation under reduced pressure. Toluene (30 mL) was added to the residue and 1M hydrochloric acid (50 mL) was slowly added as gas was evolved. More toluene (50 mL) was added and the layers were separated. The organic layer was washed with water (50 mL) and brine (20 mL) then was dried ($MgSO_4$), filtered and concentrated under reduced pressure to give **Photoinitiator 8** as a pale-yellow glassy solid (3.5 g, 91 %).

**Example 14: Synthesis of Photoinitiator 9**

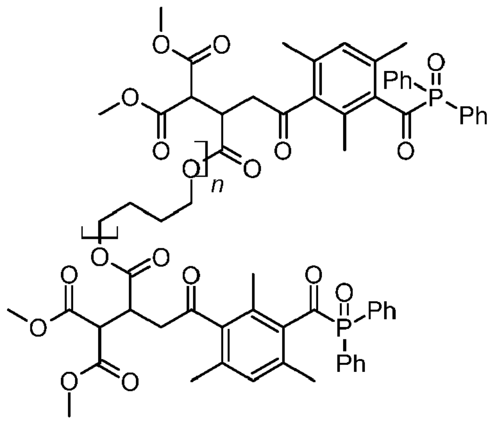

To a solution of **Precursor 5** (14.8 g, 13.4 mmol) and dimethyl malonate (3.71 g, 28.1 mmol) in 2-butanone (85 mL) was added potassium carbonate (6.47 g, 46.8 mmol) and the resulting suspension was heated to 85°C for 3 h. The mixture was allowed to cool to 40°C and the solvent was removed by distillation under reduced pressure. Toluene (50 mL) was added to the residue and 1M hydrochloric acid (100 mL) was slowly added as gas was evolved. More

toluene (80 mL) was added and the layers were separated. The organic layer was washed with water (50 mL) and brine (30 mL) then was dried ($MgSO_4$), filtered and concentrated under reduced pressure to give **Photoinitiator 9** as a pale-yellow glassy solid (17.2 g, 94%).

## Example 15: Synthesis of Precursor 6

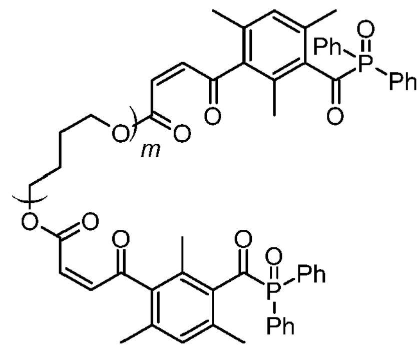

To a suspension of **Precursor 1** (15.0 g, 33.6 mmol) and a poly(tetrahydrofuran) having a number average molecular weight of 650 g/mol (410.9 g, 16.8 mmol) in toluene (90 mL) was added methanesulphonic acid (1.5 mL, 23.1 mmol) and the resulting mixture was heated at reflux temperature for 8 h, while water was continuously removed using a Dean-Stark apparatus. The mixture was allowed to cool to 20°C, then 5 wt% aqueous sodium carbonate solution (100 mL) was added and the layers were separated. The organic phase was washed with brine (50 mL), dried ($MgSO_4$), filtered and concentrated under reduced pressure to give **Precursor 5** as a yellow liquid (22.0 g, 87%).

## Example 16: Synthesis of Photoinitiator 10

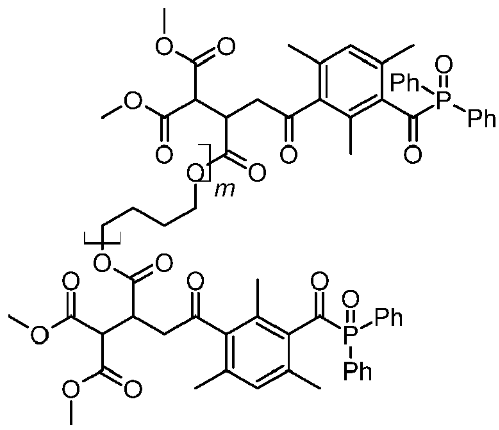

To a solution of **Precursor 5** (17.5 g, 11.6 mmol) and dimethyl malonate (3.22 g, 24.4 mmol) in 2-butanone (100 mL) was added potassium carbonate (5.61 g, 40.6 mmol) and the resulting suspension was heated to 85°C for 3 h. The mixture was allowed to cool to 40°C and the solvent was removed by distillation under reduced pressure. Toluene (60 mL) was added to the residue and 1M hydrochloric acid (150 mL) was slowly added as gas was evolved. More toluene (140 mL) was added and the layers were separated. The organic layer was washed with water (30 mL) and brine (50 mL) then was dried ($MgSO_4$), filtered and concentrated under reduced pressure to give **Photoinitiator 10** as a pale-yellow liquid (19.5 g, 95%).

## Example 17: Synthesis of Precursor 7

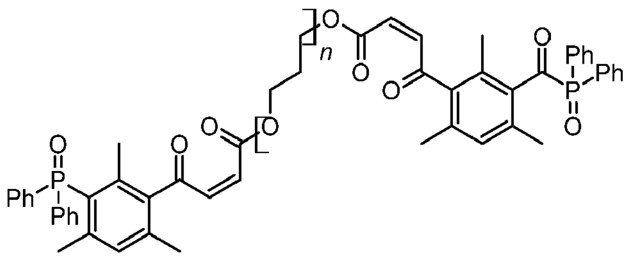

To a suspension of **Precursor 1** (240 g, 538 mmol) and 1,3-poly-propanediol having a number average molecular weight of 200-300 g/mol (Velvetol® H250 from WeylChem - 67.3 g, 269 mmol) in toluene (1.4 L) was added methanesulphonic acid (24 mL, 370 mmol) and the resulting mixture was heated at reflux temperature for 5 h, while water was continuously removed using a Dean-Stark apparatus. The mixture was allowed to cool to 20°C, then 5 wt% aqueous sodium carbonate solution (1 L) was added and the layers were separated. The organic phase was washed with water (200 mL) and brine (200 mL), then was dried ($MgSO_4$), filtered and concentrated under reduced pressure to give **Precursor 6** as a glassy yellow solid (290 g, 97%).

## Example 18: Synthesis of Photoinitiator 11

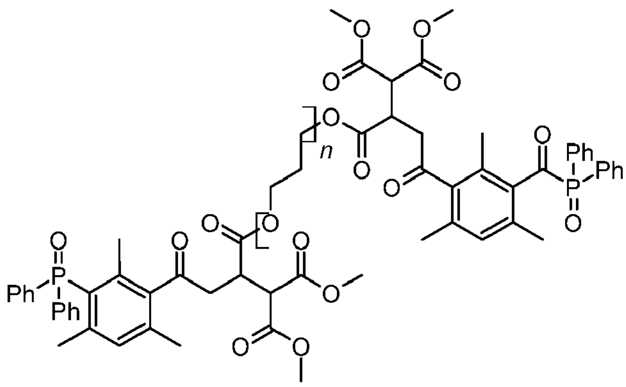

To a solution of **Precursor 6** (186 g, 168 mmol) in toluene (1 L) were added dimethyl malonate (46.4 g, 352 mmol) and potassium carbonate (81.0 g, 586 mmol) and the resulting suspension was heated at 90°C for 2.5 h. The mixture was allowed to cool to 20°C, then 2M hydrochloric acid (1 L) was slowly added as carbon dioxide was evolved. When gas evolution ceased, the layers were mixed well and separated, then the organic phase was washed with water (400 mL) and brine (250 mL). The organic phase was then dried ($MgSO_4$), filtered and concentrated under reduced pressure to give **Photoinitiator 11** as a glassy, pale-yellow solid (223 g, 97%).

## Example 19: Curing Experiments

The following examples illustrate the high curing speed of the photoinitiators disclosed in this invention in comparison with previously disclosed photoinitiators.

Testing Protocol: Formulations were prepared by combining all materials in the given proportions and then stirring at 30-40°C until the samples were fully homogeneous; the formulations were then allowed to cool to 20°C. All components remained fully dissolved in the resin formulations throughout these experiments. For all experiments, the formulations were cured on Leneta Form 3N-31 gloss finish paper at 50 μm film thickness using a belt-cure instrument; the films were prepared using a K-bar. All films were then cured under an LED lamp at 395 nm at a belt speed of 10 m/min. The cure speed for each formulation was calculated from the number of passes under each lamp required to give complete surface cure (determined when light scratching of the surface of the film no longer left a mark) and depth cure (determined using the 'thumb-twist' test, where no visible mark is made when a thumb is pressed down firmly onto the coating with a twisting motion), and from the belt speed; the calculated cure speed (in m/min) is given in Tables 1A-1B as an average of 3 runs. Where cure speed was less than 0.3 m/min, the result was recorded as 'No cure'.

Table 1A: Curing of Phosphine Oxides in Formulations at the Same Weight% Formulations were prepared containing 8% w/w of each phosphine oxide photoinitiator in a 7:3 w/w mixture of bisphenol A ethoxylate diacrylate and tripropylene glycol diacrylate.

| Photoinitiator | Cure speed (m/min) | |
|---|---|---|
| | Surface cure | Depth cure |
| SpeedCure TPO | 2.2 | 5.6 |
| **Precursor 3** | No cure | 1.8 |
| **Photoinitiator 3** | No cure | 3.9 |
| **Photoinitiator 4** | No cure | 5.0 |
| **Precursor 4** | No cure | 1.9 |
| **Photoinitiator 6** | No cure | 2.0 |

As can be seen from these results, the phosphine oxides disclosed in this invention are effective photoinitiators for the depth curing of acrylate resin films under LED lamp conditions. Though they are somewhat slower than commercially available photoinitiator SpeedCure TPO, this is to be expected given their higher molecular weights and lower active content at that concentration. Furthermore, the photoinitiators disclosed in this invention promote faster curing than previously disclosed photoinitiators **Photoinitiator B** and **Photoinitiator C.**

Table 1B: Curing of Phosphine Oxides at the Same Active Concentration Formulations were prepared containing phosphine oxide photointiators at the given weight % in a 7:3 w/w mixture of bisphenol A ethoxylate diacrylate and tripropylene glycol diacrylate. The amount of phosphine oxide was chosen to ensure that the same approximate concentration of active phosphine oxide was present in each formulation, based on the proportion of each molecule that contained an active phosphine oxide moiety.

| Photoinitiator | Wt% | Cure speed (m/min) | |
|---|---|---|---|
| | | Surface cure | Depth cure |
| SpeedCure TPO | 8 | 2.2 | 5.6 |
| **Precursor 3** | 11.5 | No cure | 1.8 |
| **Photoinitiator 3** | 13.5 | 1.7 | 5.0 |
| **Photoinitiator 4** | 13.8 | 1.6 | 5.0 |
| **Precursor 4** | 13.3 | No cure | 3.9 |
| **Photoinitiator 6** | 15.1 | 1.2 | 5.6 |
| **Precursor 5** | 12.7 | No cure | 1.3 |
| **Photoinitiator 9** | 15.8 | 1.3 | 5.6 |

As can be seen from these results, the phosphine oxides disclosed in this invention are effective photoinitiators for the depth and surface curing of acrylate resin films under LED lamp conditions, and are comparable to commercially available SpeedCure TPO when the same active phosphine oxide content is present. The disclosed phosphine oxides also promote surface cure of acrylate resin films under these conditions.

## Example 20: Nail gel coating

A typical UV curable nail gel top coat formulation is shown below in Table 2A. CN9066 is a urethane methacrylate oligomer that has a good balance of adhesion, optical clarity and tensile properties. The formulation was diluted with a difunctional monomer, SR239 (HDDMA) and SR170 (2-hydroxyethyl methacrylate). Formulations containing 2 wt% and 4 wt% loadings of Speedcure TPO (Comp. 1 & 3) and Speedcure TPO-L (Comp 2 & 4) were compared to formulations containing 2 wt% and 4 wt% of **Photoinitiator 9** according to the invention as prepared in example 14 (Inv 1 & 2) based on the weight of the ethylenically unsaturated compounds.

Table 2A

| | Comp 1 | Comp 2 | Inv 1 | Comp 3 | Comp 4 | Inv 2 |
|---|---|---|---|---|---|---|
| CN9066 | 13 | 13 | 13 | 12.73 | 12.73 | 12.73 |
| SR239 | 4.6 | 4.6 | 4.6 | 4.51 | 4.51 | 4.51 |
| SR170 | 2 | 2 | 2 | 1.96 | 1.96 | 1.96 |
| Speedcure TPO | 0.4 | | | 0.8 | | |
| Speedcure TPO-L | | 0.4 | | | 0.8 | |
| **Photoinitiator 9** | | | 0.4 | | | 0.8 |

The formulations were mixed for two minutes at 1500 RPM using a Flacktek DAC 400 high-speed mixer until uniform. The compositions were drawn down using a 3 MIL draw down bar on glass panels and cured in a LED nail lamp (Gelish 18G, λ - 395-405 nm) for 60 seconds each. The color, haze and yellowness of the compositions were measured using HunterLab Ultrascan VIS spectrophotometer. Surface tack was measured qualitatively by coating the comparative and inventive compositions on a plastic nail spoon and curing them using the LED nail lamp for 60s. Tack was assessed on a 0-5 scale, with 0 = no tack and 5 = very tacky. Hardness was measured using a Konig pendulum (ASTM D4366) on the surface of coating before and after IPA wipe. LED curable compositions will have a tacky layer on the surface due to oxygen inhibition. The tacky layer is removed with IPA to determine the hardness of the coating. Removability was measured using a Methyl Ethyl Ketone (MEK) Double Rub Test (ASTM D5402). The performance properties of the UV curable nail gel top coat are shown in Table 2B below.

Table 2B

| | Comp1 | Comp 2 | Inv 1 | Comp 3 | Comp 4 | Inv 2 |
|---|---|---|---|---|---|---|
| Formulation | clear | clear | clear | clear | clear | sl. yellow |
| Initial Color (APHA, 10mm) | 3.75 | 9.26 | 16.41 | 16.18 | 18.64 | 30.05 |
| Initial Yellowness (b*) | 0.13 | 0.33 | 0.63 | 0.59 | 0.71 | 1.15 |
| Surface Tack | 1 | 1 | 1 | 1 | 1 | 1 |
| Hardness (Konig, before IPA wipe) | 4 | 9.3 | 4.3 | 27 | 25.3 | 4.3 |
| Hardness (Konig, after IPA wipe) | 42.7 | 45.7 | 35.7 | 52.7 | 45.3 | 46.3 |
| Removability (MEK Double Rub) | >200 | >200 | >200 | >200 | >200 | >200 |

The color and yellowness values of the films containing **Photoinitiator 9** were slightly higher compared to TPO and TPO-L. Konig hardness was slightly lower for formulations containing **Photoinitiator 9** before and after IPA wipe. After IPA wipe, hardness values increased for all formulations. Formulations containing **Photoinitiator 9** ranged from 35-46 compared to 42-52 for the formulations containing TPO and 45-46 for the formulations containing TPO-L. All compositions had the same surface tack after curing in the LED lamp for up to 60 seconds. None of the comparative or inventive formulations were able to achieve a tack free surface. All formulations were able to last more than 200 double rubs with MEK, indicating a cured coating with good chemical resistance.

Photo Differential Scanning Calorimetry (PhotoDSC) was used to measure the cure speed, heat generation during cure and heat flow measurements for the UV curable top coat compositions containing TPO, TPO-L and **Photoinitiator 9** as shown in Table 2C below. PhotoDSC was measured using a TA instruments Q2000 DSC equipped with an EFOS A4000 Acticure UV/Visible light curing system containing a 100W Mercury lamp light source. The UV-light intensity was measured out of the sample window using an EIT UV power puck II radiometer prior to the experiment. Sample preparation for PhotoDSC occurred as follows: A Tzero aluminum reference pan and a Tzero aluminum sample pan were weighed. One drop of formulation (about 5-15 milligrams) was placed at the center of the sample pan and the mass was recorded. The two pans were placed in the DSC apparatus. The system was stabilized at 25°C for 30 seconds under a continuous stream of nitrogen. An isothermal experiment was initiated and sample and reference pan were flooded with UV/Visible light (320 to 450 nm, 190-210 mJ/$cm^2$) for two minutes. An exothermic peak, due to crosslinking, is recorded during the experiment. The cure speed is measured by determining the time it takes to reach the peak max while the lamp is turned on. The area under the peak is recorded as the heat flow value (J/g). The max temperature

during cure is recorded as the temperature shown at the maximum peak during cure.

Table 2C

| UV PhotoDSC (320-450 nm, 190-210 mJ/cm$^2$) | | |
|---|---|---|
| | PhotoDSC (Time to peak max, min) | PhotoDSC Exothermic Heat Flow (J/g) |
| Comp 1 | 0.05 | 215.2 |
| Comp 2 | 0.06 | 258.3 |
| Inv 1 | 0.06 | 209.3 |
| Comp 3 | 0.06 | 279.4 |
| Comp 4 | 0.06 | 234.5 |
| Inv 2 | 0.06 | 206.0 |

Inv 1 and Comp 1 and 2 are a direct comparison of a composition containing 2 wt% photoinitiator whereas Inv 2 and Comp 3 and 4 are a direct comparison of a composition containing 4 wt% photoinitiator. The cure speed of Inv 1 and 2 was similar to that of Comp 1-4. The time to peak max was 0.5 min for TPO and 0.06 min for TPO-L and **Photoinitiator 9** for compositions containing 2 wt% photoinitiator. The time to peak max was 0.06 min for TPO, TPO-L and **Photoinitiator 9** for compositions containing 4 wt% photoinitiator.

Next, the cure speed of the formulations was tested using 405 nm LED apparatus. The previous data utilized broad spectrum UV light. Typical nail gel lamps contain 18 X 2W LED bulbs that have an output of 30-50 mJ/cm$^2$ of 395-405nm light. In order to understand the differences in cure speed, the dosage of light from the 405nm LED apparatus was set to 40 mJ/cm$^2$ to mimic curing in a nail lamp. The PhotoDSC results using the 405 nm LED apparatus can be seen in Table 2D below.

Table 2D

| LED PhotoDSC (405 nm, 40 mJ/cm$^2$) | | |
|---|---|---|
| | PhotoDSC (Time to peak max, min) | PhotoDSC Exothermic Heat Flow (J/g) |
| Comp 1 | 0.10 | 174.6 |
| Comp 2 | 0.11 | 166.3 |
| Inv 1 | 0.13 | 170.1 |
| Comp 3 | 0.10 | 180.3 |
| Comp 4 | 0.10 | 177.4 |
| Inv 2 | 0.12 | 165.8 |

Comp 1 and 2 had a slightly faster cure speed (0.10 min and 0.11 min) compared to Inv 1 (0.13 min). In addition, Comp 3 and 4 had a slightly faster cure speed (0.10 min for both) compared to Inv 2 (0.12 min). The heat flow during cure was similar for all samples and ranged from 165-180 J/g. For nail gel compositions, the difference in cure speed between the compositions does not indicate superiority of one photoinitiator over the others, because in a nail salon setting, the consumer will be placing their hand in a nail lamp for 60 seconds All samples will achieve a full cure during this time.

## Example 21: 3D printing experiments

*Materials*

The following materials were used in Example 21:

| Material | Composition | Supplier |
|---|---|---|
| SR494 | 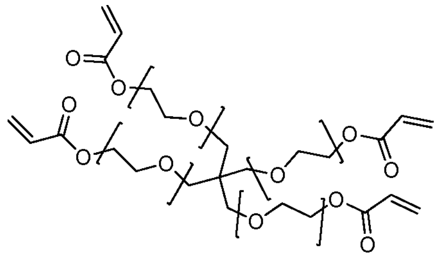 Ethoxylated$_4$ Pentaerythritol Tetraacrylate | Sartomer |
| CN991 | Proprietary aliphatic urethane diacrylate | Sartomer |
| SR531 | 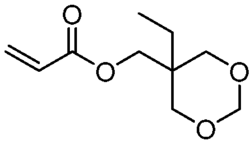 Cyclic Trimethylolpropane Formal Acrylate | Sartomer |
| Speedcure TPO | 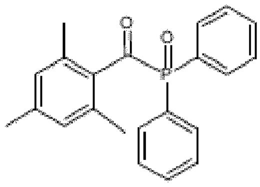 2,4,6-trimethylbenzoyldiphenylphasphine oxide | Sartomer |
| **Precursor 4** (obtained according to Example 9) | 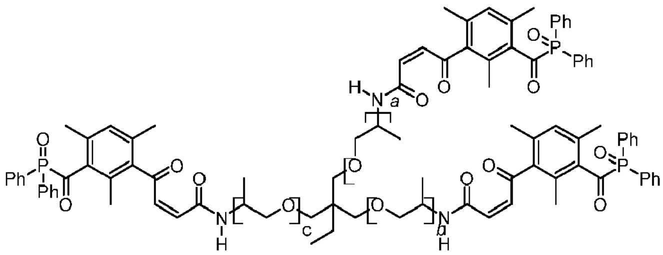 | Sartomer |
| **Photoinitiator 6** (obtained according to Example 10) | 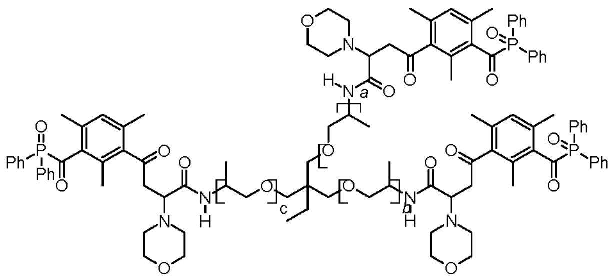 | Sartomer |

(continued)

| Material | Composition | Supplier |
|---|---|---|
| **Photoinitiator 9** (obtained according to Example 14) | 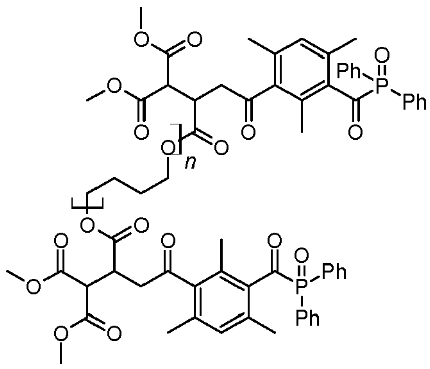 | Sartomer |

*Curable compositions*

Curable compositions were prepared with the compounds listed in the Tables 3A and 3B (amounts are indicated in parts by weight).

Table 3A

| Component | Ctr 1 | Ex 1 | Ex 2 | Ctr 2 | Ex 3 | Ex 4 |
|---|---|---|---|---|---|---|
| **SR494** | 55.00 | 55.00 | 55.00 | 55.00 | 55.00 | 55.00 |
| **SR991** | 30.00 | 30.00 | 30.00 | 30.00 | 30.00 | 30.00 |
| **SR531** | 15.00 | 15.00 | 15.00 | 15.00 | 15.00 | 15.00 |
| **SpeedCure TPO** | 2.00 | | | 6.00 | | |
| **Preucrsor 4 obtained according to Example 9** | | 3.33 | | | 10.00 | |
| **Photoinitiator 6 obtained according to Example 10** | | | 3.77 | | | 11.32 |
| **Total** | 102.00 | 103.33 | 103.77 | 106.00 | 110.00 | 111.32 |
| **Max heat flow (W/g)** | 60.08 | 19.86 | 24.82 | 51.45 | 11.01 | 30.51 |
| **Peak time (mins)** | 0.02 | 0.07 | 0.04 | 0.03 | 0.09 | 0.03 |
| **Acrylate Conversion (%)** [B] | 89.48 | 50.95 | 77.32 | 90.06 | 56.85 | 78.36 |
| *The Max heat flow and Peak time were determined with the following test conditions: 405nm, 50mW/cm$^2$ LED for 18s, 50mL/min $N_2$ flow rate, 40°C. Acrylate conversion was determined with the following test conditions: 405nm, 10mW/cm$^2$ LED for 20s, 20°C.* | | | | | | |

Table 3B. Summary of formulations and their properties

| Component | Ctr 1 | Ex 5 | Ctr 3 | Ex 6 | |
|---|---|---|---|---|---|
| **SR494** | 55.00 | 55.00 | 55.00 | 55.00 | |
| **SR991** | 30.00 | 30.00 | 30.00 | 30.00 | |
| **SR531** | 15.00 | 15.00 | 15.00 | 15.00 | |
| **SpeedCure TPO** | 2.00 | | 4.00 | | |
| **Photoinitiator 9 obtained according to Example 14** | | 4.08 | | 8.16 | |
| **Total** | 102.00 | 104.08 | 104.00 | 108.16 | |

(continued)

| Component | Ctr 1 | Ex 5 | Ctr 3 | Ex 6 | |
|---|---|---|---|---|---|
| **Viscosity (mPa.s, 25°C)** | 325 | 603.5 | 400 | 815 | |
| **Acrylate Conversion (%)[c]** | 67.88 | 66.52 | 66.68 | 64.75 | |
| 385nm 3D Printing data | | | | | |
| **Ec (mJ/cm$^2$)** | 15.5 | 11.0 | 7.46 | 4.09 | |
| **Dp (mils)** | 35.5 | 14.4 | 12.91 | 3.66 | |
| **Tensile strength (MPa)** | 37.5 | 36.5 | 35.2 | 41.8 | |
| **Elongation at break (%)** | 2.6 | 3.7 | 2.9 | 5.1 | |
| **Tensile modulus (MPa)** | 2620 | 2039 | 2159 | 2049 | |
| **Energy at break (J)** | 0.28 | 0.39 | 0.30 | 0.69 | |
| **Tg (Tan delta, °C)** | 86.50 | 92.34 | 104.40 | 89.68 | |
| *Acrylate conversion was determined with the following test conditions: 405nm, 10mW/cm$^2$ LED for (1+5)s, 3mil film, 10LPM dry air, 20°C.* | | | | | |

*Formulation preparation in Tables 3A and 3B*

In a white max 50 jar from FlackTek Inc., photoinitiator was loaded at first, SR494, CN991 and SR531 were charged next. 51 ~ 55.66 g mixture of each sample was mixed for 3 minutes at 3000 RPM in Speed Mixer from FlackTec Inc. Then, sample jars were placed in 60°C oven for about 2h, mixed for another 2 minutes until the solution became clear.

*Viscosity*

Viscosity of each blend in **Table 3B** was measured using a Brookfield DV-III+ viscometer with SC-27 spindle at 20°C. Each sample was measured at a certain RPM needed to achieve 50% torque range. Viscosity was measured after temperature and sample stabilization was achieved (10 minutes).

**Results show Photoinitiator 9 according to the invention only moderately increases the viscosity of formulation comparing with the same equivalent of phosphine oxide TPO.**

*UV Vis spectra measurement*

UV-Vis spectrum of each sample was taken with a Shimadzu UV1800 spectrophotometer using a 1.0 cm path of cuvette quartz cell in accordance with ASTM E169-04, and scanning the spectrum over the wavelength range of 450 to 200 nm. The measuring cell was filled a 500 ppm photoinitiator in acetonitrile solution to ensure that the observed absorbance did not exceed 1.0 in the range of the spectrum for which absorbance values were desired. A normalized comparison data was overlaid in **Figure 1.**

**Results show UV spectrum of 2.16 times of Photoinitiator 9 matches very well with TPO by each weight percentage.**

*LED-DSC test*

A photo differential scanning calorimetry (DSC) with a customized 405 nm LED lamp setup was used. All photopolymerization rate measurement were performed using a Q2000 DSC unit from TA Instruments. A lamp holder for the DSC unit can be customized and printed from Arkema N3xtDimention® engineered resin N3D-TOUGH784 in order to ensure precisely fit of a 405nm lamp AccuCure ULM-2-405 from Digital Light Labs. The LED light was automatically triggered by connecting the "Event" outlet of the DSC unit to an Accure Photo Rheometer Ultraviolet Illumination & Measurement System. LED light exposure can be programed by using "Event" on or off from Photo DSC software, but the intensity of light can be preset from the Accure Photo Rheometer Ultraviolet Illumination & Measurement System. For measurement, approximate 10 mg liquid sample was placed at the center of a T130522 DSC Tzero pan, cured by exposing it to 50mW/cm$^2$ of 405nm LED light for 0.3 minutes under a 50 mL/min $N_2$ flow rate and 40°C. The resulting heat flow (W/g) curve was collected to analyze maximum heat flow peak value and maximum peak time, and listed in

**Table 3A.**

**Results show the cure speed Precursor 4 < Photoinitiator 6 < TPO in formulations at the same equivalent of phosphine oxide. Although the photoinitiator according to the invention has slower cure speed than TPO, it advantageously does not generate low molecular weight photoproducts. The cure speed is in a desirable range.**

*FTIR test*

A Fourier Transform Infrared (FTIR) with an Attenuated Total Reflection (ATR) setup was used. All polymerization rate measurements were performed using Nicolet iS50 FT-IR Spectrometer from Thermo Scientific, equipped with a standard DLaTGS detector. A lamp holder for the ART platform of FTIR unit can be customized and printed from Arkema N3xtDimention® engineered resin N3D-TOUGH784 in order to ensure precisely fit of a 405nm lamp AccuCure ULM-2-405 from Digital Light Labs. On the bottom of this lamp holder, a dry air channel is built in to allow air uniformly blowing over sample surface, the gas flow rate can be controlled over a rotameter. The LED light was manually triggered by Ultraviolet illumination & Measurement System. LED light exposure can be programed by AccuCure software. For measurement, a drop of liquid sample was placed in the center of an ATR crystal. 3 mil of thin film was coated by a customized coating applicator (3mil WFM, G1046 from BYK). The LED lamp with holder was place on the top of ART platform. Then FTIR scan was initiated to collect liquid IR spectrum at first. Then each IR spectrum of a total exposure time 10s, 20s, 50s and 100s at 10mW of LED light in ambient condition were collected as showed in **Table 3A** and **Figure 2A**. Or each IR spectrum of a total exposure time 1s, 6s, 16s, 66s and 166s at 10mW of LED light in 10LPM dry air were collected as showed in **Table 3B** or **Figure 2B**. Measurements of acrylate conversion were taken at the height under the reference peak around 1720 $cm^{-1}$; the acrylate peak at approximately 1407 $cm^{-1}$ was also measured. Peak height was determined using the baseline technique where a baseline is chosen to be the two lowest points between 600$cm^{-1}$ and 1800$cm^{-1}$. The height under the peak and above the baseline was then determined. The integration limits for liquid and the cured sample are not identical but are similar, especially for the reference peak.

The ratio of the acrylate height to the reference peak height were determined for both the liquid and the cured samples. Degree of cure or conversion, expressed as percentage reacted acrylate, was calculated from the equation below:

$$\text{Conversion (\%)} = [(R_{liq} - R_c) \times 100] / R_{liq}$$

Where $R_{liq}$ is the height ratio of the liquid sample and $R_c$ is the height ratio of the LED cured sample. The resulting acrylate conversions were showed in **Figure 2A** and **Figure 2B,** and acrylate conversions at 20s exposure listed in **Table 3A** and **3B.**

**Figure 2A shows the cure speed Precursor 4 < Photoinitiator 6 < TPO in formulations at the same equivalent of phosphine oxide. Although the photoinitiator according to the invention has slower cure speed than TPO, it advantageously does not generate low molecular weight photoproducts. The cure speed is in a desirable range.**

**Figure 2B showed the cure speed of Photoinitiator 9 in formulations matched with TPO very well at the same equivalent phosphine oxide.**

*3D printed working curves*

Working curves were measured using the method below to find the Ec (Critical Energy) and Dp (Depth of Penetration) which are key characteristics used to determine printability and printer settings for successful 3D printing. Ec represents the amount of energy that needs to be applied to cure a formulation to a "green state" and Dp is the depth the UV photons penetrate the formulation which determines the thickness of the layer that can be printed.

Working curves and 3D printing were done on an EnvisionOne 3D printer from EnvisionTec with a 385nm light source.

*Preparing the printing files*

1. Import an STL file that has measurable squares of varying thicknesses (in the same increment as the layer thickness being printed).
2. For the below STL file, use 50 $\mu$m layer thickness in the slicing software. This will ensure that each printed square receives a linear increase in energy dosage.

3. Import the STL file to the printer slicing software.
4. Place the part in a known build area, for example in the center.
5. Place the part on the surface, and do not use any support structures, rafts, or base plates.
6. Set the burn in exposure and standard exposure to be equal to each other.
7. Minimize other settings like elevator wait times to make the procedure quick and efficient.

*Preparing the printer*

1. Remove the build platform.
2. Install the vat.
3. Place resin in the vat-only a small amount to cover ~ 0.6 cm of the bottom of the vat is needed.

*Print working-curve parts*

1. Start the working-curve print file. Print at 6.05mW/$cm^2$ for 1s up to 4s per layer depending on formulation
2. Once the print is complete, carefully peel off the part from the bottom of the vat surface.
3. Gently clean the part with IPA (isopropyl alcohol), TPM (tripropylene glycol monomethyl ether), acetone, or other solvent.
4. Print 2-3 working-curves for each formulation.

*Measuring the cure depths for corresponding energy dosages*

1. A caliper Starrett® 3671 was used to measure the cure depths of all squares. Generally speaking, with an increase in energy dosage there should be an increase in cure depth thickness.
2. The energy dosages were determined as follows:

    a. Energy dosage (mJ/$cm^2$) = irradiance (mW/$cm^2$) * time (seconds)
    b. Note: energy dosage can also be measured with a radiometer

| | |
|---|---|
| Projector Intensity ($mW/cm^2$): | 5.6 |

| Time of exposure(s) | Exposure ($mJ/cm^2$) | Thickness (mils) |
|---|---|---|
| 1 | 5.6 | 2.76 |
| 2 | 11.2 | 4.61 |
| 3 | 16.7 | 5.55 |
| 4 | 22.3 | 6.26 |
| 5 | 27.9 | 6.77 |
| 6 | 33.5 | 7.13 |
| 7 | 39.1 | 7.60 |
| 8 | 44.6 | 7.91 |
| 9 | 50.2 | 8.11 |

*Determining critical exposure, penetration depth, and print parameters*

1. The Jacobs working-curve equation, described in P.F. Jacobs, Fundamentals of stereolithography, Proc. Solid Free. Fabr. Symp. (1992) 87-89, was used to determine critical exposure, Ec ($mJ/cm^2$), and penetration depth, Dp (mils).

    a.

    $$C_d = D_p \ln\left(\frac{E_{max}}{E_c}\right)$$

    b. Where,

        i. $C_d$ = measured cure depths (mils)
        ii. $E_{max}$ = energy dosages ($mJ/cm^2$)

    c. Plot $C_d$ (mils) vs. $\ln(E_{max})$. The slope of the plot corresponds to the penetration depth and the $E_{max}$ point that corresponds to $C_d = 0$ is the critical exposure.

2. The measured cure depths and corresponding exposure times were used to determine the optimal print parameters. Target an exposure time that achieves a cure depth 2-4x the layer thickness to print with.
3. Example: for the above energy dosage and cure depth measurements, the Dp = 2.4 mils and the Ec = 0.6 $mJ/cm^2$.

**Results are listed in Table 3B. Results show Ec and Dp of Photoinitiator 9 according to the invention in formulations is lower than TPO at the same equivalent phosphine oxide. The higher the concentration, the lower both Ec and Dp.**

*Tensile and DMA sample preparation:*

1. 400g of each formulation was prepared as showed in **Table 3B**
2. The burn-in range and standard range exposure times of EnvisionOne cDLP Mechanical (385nm) from Envision Tec were verified.
3. The printer was set up with the following parameters

- Printer irradiance: ~6.05 mW/cm$^2$
- Printing thickness: 50 microns/layer
- Elevator settings: default
- Part printing orientation: XY plane
- 3.5 seconds/layer

4. Dog bone shape of tensile bars were printed

- Specimen type: ASTM D638 Type IV
- Number of specimens printed: 5
- Size: approximately 115mm X 19mm X 3.2mm (LxWxH).

5. DMA flexural mode specimens

- Specimen type: ASTM D4065
- Number of specimens printed: 2

6. A set of 5 tensile bars and a set of 2 DMA parts were put in Dymax Model 5000 Flood Cure Unit for UVA/UVV flood cure, each side cured for 60 seconds.
7. The tensile bars and DMA bars were stored in a control room with 23°C and 50%RH for 40~80 hours before testing.

Tensile tester (ASTM D618): Instron 5966 w/ 2630-109 static axial clip-on extensometer.

- Speed of testing: 5 mm/min
- Pre-load: 5N
- Pre-load pull rate: 0.1 mm/min
- Specimen protect: Yes
- Specimen protect load: 4.448 N
- Extensometer: Yes
- Extensometer type: Instron 2630-109 (ASTM E83 Class B-1 extensometer)
- Extensometer gauge length: 1"

All five bars were tested, the average tensile data were calculated and listed in **Table 3B.**
**Results show both elongation at break and tensile toughness of Photoinitiator 9 according to the invention in formulations are higher than that of TPO at the same equivalent phosphine oxide, tensile modulus are slightly lower. The higher the concentration and the better the elongation at break and tensile toughness.**

*DMA test*

ThermoScientific Q800 from TA Instrument was used to observe changes in mechanical properties in each cured DMA part throughout a temperature range from -150C to 250C at 5 C/min with a frequency of 1Hz. Resulting tan (delta) peaks was listed in **Table 3B** to understand changes in polymers behavior.
**Results show the glass transition temperature of Photoinitiator 9 according to the invention in formulation is 5.8°C higher than TPO at the same equivalent phosphine oxide when 4.08 wt% was used. The glass transition temperature of Photoinitiator 9 according to the invention in formulations is 14.7°C lower than TPO at the same equivalent phosphine oxide when 8.16 wt% was used.**

## ITEMS

The invention may be as defined in the following Items:

Item 1. A photoinitiator according to formula (1) or (2):

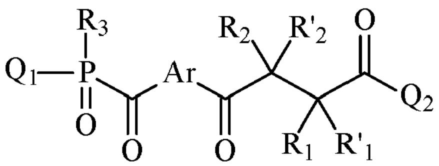

(1)

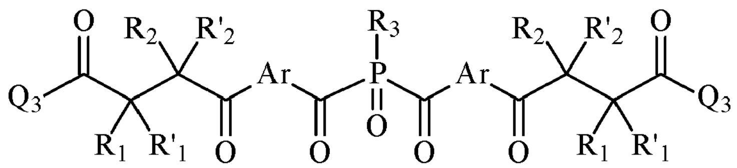

(2)

wherein:

- each Ar is independently an optionally substituted arylene;
- $R_1$ and $R_2$ are independently H or an optionally substituted group selected from alkyl and aryl; or $R_1$ and $R_2$, together with the carbon atoms to which they are attached, form a ring;
- one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-W^2-R^{10})$, $-C(R^{11})(CO-W^3-R^{12})(CN)$ and $-C(R^{13})(CN)_2$; or $R'_2$ is H and $R'_1$ and $Q_2$, together with the atoms to which they are attached, form a 5-7 membered ring; or $R'_2$ is H and $R'_1$ and $Q_3$, together with the atoms to which they are attached, form a 5-8 membered ring;
- each $R_3$ is independently an optionally substituted group selected from alkyl, aryl and alkoxy;
- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom;
- $Q_1$ is an optionally substituted aryl or a group of formula (3):

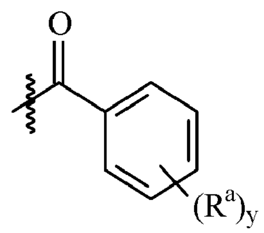

(3)

wherein:

  - each $R^a$ is independently an optionally substituted group selected from alkyl, aryl, alkoxy, aryloxy, thioalkyl and thioaryl; and
  - y is a number chosen from 0 to 5;

- $Q_2$ and $Q_3$ are independently $-OR^{14}$, $-SR^{15}$, $-NR^{16}R^{17}$, $-O-[CH_2-CH(OH)-Y_1]_a-Z^1$, $-S-Z^2$, $-N(R^{18})-Z^3$ or $-O-Cyhex-Y_2-Z^4$; or $Q_2$ and $R'_1$, together with the atoms to which they are attached, form a 5-7 membered ring; or $Q_3$ and $R'_1$, together with the atoms to which they are attached, form a 5-7 membered ring;

- $R^{14}$ and $R^{15}$ are independently H or an optionally substituted group selected from alkyl, cycloalkyl, heterocycloalkyl, aryl and heteroaryl;
- $R^{16}$, $R^{17}$ and $R^{18}$ are independently H, or an optionally substituted group selected from alkyl and aryl; or $R^{16}$ and $R^{17}$, together with the nitrogen atom to which they are attached, form a 5-7 membered ring;
- Cyhex is a cycloyhexylene substituted by a hydroxyl group, preferably represented by the following formula:

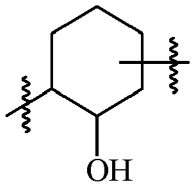

- $Y_1$ is a bond, $-CH_2-O-*$ or $-CH_2-C(=O)-O-*$;
- $Y_2$ is a bond, $-CH_2-O-C(=O))-^{\#}$ or $-C(=O)-O-^{\#}$;
- a is 0 or 1;
- $Z^1$, $Z^2$, $Z^3$ and $Z^4$ are independently a phosphine oxide-containing moiety;
- the symbol * represents a point of attachment to moiety $Z^1$;
- the symbol # represents a point of attachment to moiety $Z^4$.

Item 2. The photoinitiator according to Item 1, wherein each Ar is independently an optionally substituted phenylene, preferably a meta-phenylene substituted by one or more optionally substituted groups selected from alkyl, aryl, alkoxy, aryloxy, thioalkyl and thioaryl; and more preferably Ar is a group of formula (4):

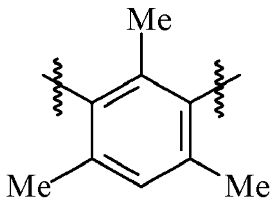

(4).

Item 3. The photoinitiator according to Item 1 or 2, wherein $R_1$ and $R_2$ are both H, or $R_1$ and $R_2$, together with the carbon atoms to which they are attached, form a six-membered ring, preferably a six-membered cycloaliphatic ring, and wherein preferably $R_1$ and $R_2$ are both H.

Item 4. The photoinitiator according to any one of Items 1 to 3, wherein one of $R'_1$ and $R'_2$ is H and the other of $R'_1$ and $R'_2$ is $-OR^4$, and wherein preferably $R^4$ is an optionally substituted alkyl.

Item 5. The photoinitiator according to any one of Items 1 to 3, wherein one of $R'_1$ and $R'_2$ is H and the other of $R'_1$ and $R'_2$ is $-SR^5$, and wherein preferably $R^5$ is an optionally substituted alkyl.

Item 6. The photoinitiator according to any one of Items 1 to 3, wherein one of $R'_1$ and $R'_2$ is H and the other of $R'_1$ and $R'_2$ is $-NR^6R^7$, and wherein preferably $R^6$ and $R^7$, together with the nitrogen atom to which they are attached, form a 5-7 membered ring; in particular an optionally substituted ring selected from morpholine, piperidine, pyrrolidine, oxazolidine, piperazine, thiazolidine, thiomorpholine and azepane.

Item 7. The photoinitiator according to any one of Items 1 to 3, wherein one of $R'_1$ and $R'_2$ is H and the other of $R'_1$ and $R'_2$ is $-C(R^8)(CO-W^1-R^9)(CO-W^2-R^{10})$, and wherein preferably

- $R^8$ is H;
- $W^1$ and $W^2$ are independently a bond or an oxygen atom; and
- $R^9$ and $R^{10}$ are independently an optionally substituted alkyl.

Item 8. The photoinitiator according to any one of Items 1 to 3, wherein $R'_2$ is H and $R'_1$ forms a 5-8 membered ring with $Q_2$ or $Q_3$, and wherein preferably the photoinitiator is according to formula (5) or (6)

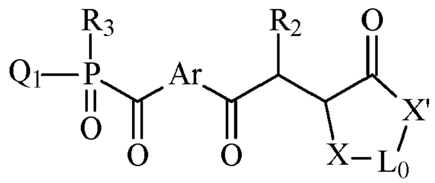

(5)

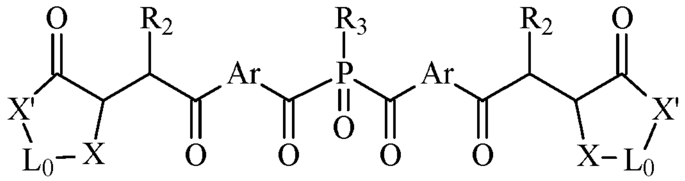

(6)

wherein

- X and X' are independently selected from O, S and $NR^{19}$;
- $R^{19}$ is H or an optionally substituted alkyl;
- $L_0$ is an optionally substituted C1-C4 alkylene.

Item 9. The photoinitiator according to any one of Items 1 to 8, wherein each $R_3$ is independently an optionally substituted phenyl, methoxy or ethoxy; preferably each $R_3$ is independently phenyl or ethoxy.

Item 10. The photoinitiator according to any one of Items 1 to 9, wherein $Q_1$ is phenyl or a group of formula (3a):

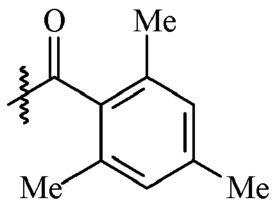

(3a).

Item 11. The photoinitiator according to any one of Items 1 to 7 and 9 to 10, wherein

- $Q_2$ and $Q_3$ are independently $-OR^{14}$;
- $R^{14}$ is an optionally substituted alkyl, preferably methyl or ethyl.

Item 12. The photoinitiator according to any one of Items 1 to 7 and 9 to 10, wherein

- $Q_2$ and $Q_3$ are independently $-O-[CH_2-CH(OH)-Y_1]_a-Z^1$;
- $Z^1$ is a group of formula (7);

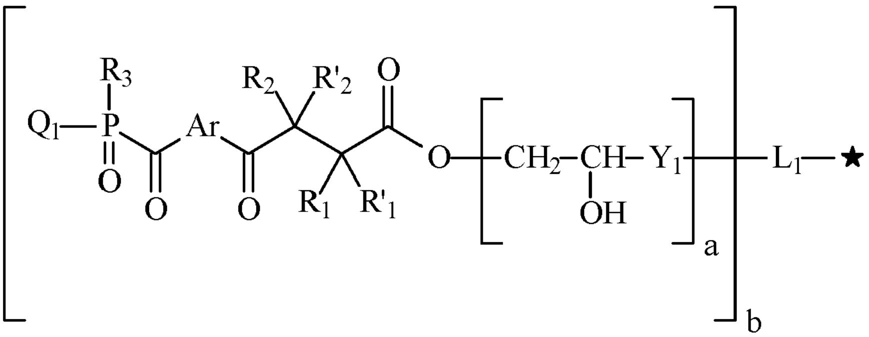

(7)

wherein:

- Ar, $Y_1$, $R_1$, $R_2$, $R'_1$, $R'_2$, $R_3$, $Q_1$ and a are as defined in any of Items 1 to 7 and 9 to 10;
- $L_1$ is a linker; and
- b is a number chosen from 1 to 15.

Item 13. The photoinitiator according to Item 12, wherein a is equal to 0.

Item 14. The photoinitiator according to Item 12, wherein a is equal to 1 and $Y_1$ is a bond or $-CH_2-O-*$, preferably $-CH_2-O-*$.

Item 15. The photoinitiator according to any one of Items 1 to 7 and 9 to 10, wherein

- $Q_2$ and $Q_3$ are independently $-SR^{15}$;
- $R^{15}$ is an optionally substituted alkyl.

Item 16. The photoinitiator according to any one of Items 1 to 7 and 9 to 10, wherein

- $Q_2$ and $Q_3$ are independently $-S-Z^2$;
- $Z^2$ is a group of formula (8):

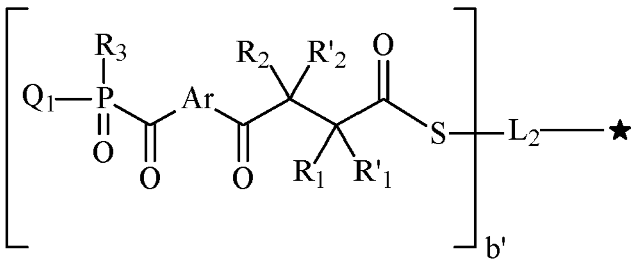

(8)

wherein:

- Ar, $R_1$, $R_2$, $R'_1$, $R'_2$, $R_3$, and $Q_1$ are as defined in any of Items 1 to 7 and 9 to 10;
- $L_2$ is a linker; and
- b' is a number chosen from 1 to 15.

Item 17. The photoinitiator according to any one of Items 1 to 7 and 9 to 10, wherein

- $Q_2$ and $Q_3$ are independently $-NR^{16}R^{17}$;
- $R^{16}$ and $R^{17}$ are independently H, or an optionally substituted group selected from alkyl and aryl; or $R^{16}$ and $R^{17}$, together with the nitrogen atom to which they are attached, form a 5-7 membered ring.

Item 18. The photoinitiator according to any one of Items 1 to 7 and 9 to 10, wherein

- $Q_2$ and $Q_3$ are independently $-N(R^{18})-Z^3$;
- $R^{18}$ is H or an optionally substituted group selected from alkyl and aryl;
- $Z^3$ is a group of formula (9):

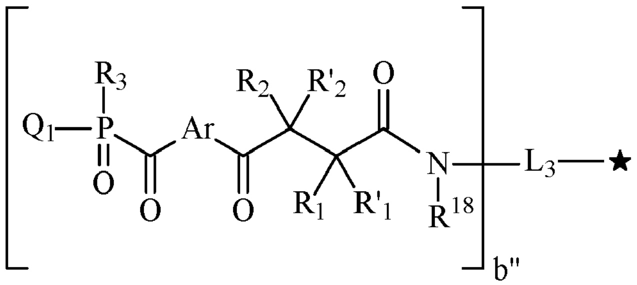

(9)

wherein:

- Ar, $R_1$, $R_2$, $R'_1$, $R'_2$, $R_3$, $R^{18}$ and $Q_1$ are as defined in any of Items 1 to 7 and 9 to 10;
- $L_3$ is a linker; and
- b" is a number chosen from 1 to 15.

Item 19. The photoinitiator according to any one of Items 1 to 7 and 9 to 10, wherein

- $Q_2$ and $Q_3$ are independently -O-Cyhex-$Y_2$-$Z^4$;
- $Z^4$ is a group of formula (7) as defined in Item 12 or a group of formula (10);

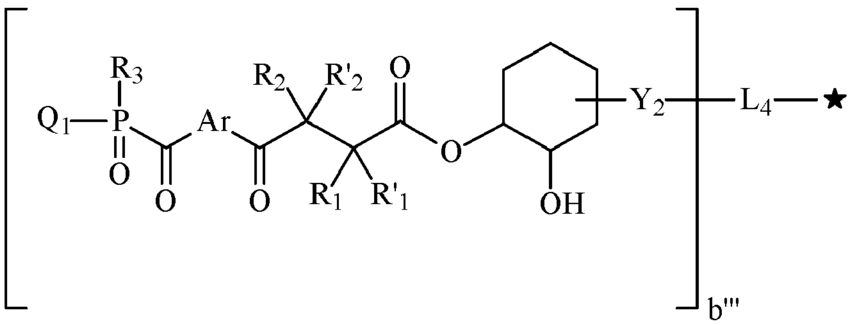

(10)

wherein :

- Ar, $Y_2$, $R_1$, $R_2$, $R'_1$, $R'_2$, $R_3$, $Q_1$ are as defined in any of Items 1 to 7 and 9 to 10;
- $L_4$ is a linker; and
- b‴ is a number chosen from 1 to 15.

Item 20. The photoinitiator according to any one of Items 12, 16, 18 and 19, wherein each linker $L_1$, $L_2$, $L_3$ and $L_4$ is independently selected from an aromatic linker, an aliphatic linker, a cycloaliphatic linker, a polyether linker, a polythioether linker, a polyalkylene imine linker, a polyester linker, a polycarbonate linker, a polycaprolactone linker, a polyurethane linker, a polyorganosiloxane linker, a polybutadiene linker, and combinations thereof; preferably each linker $L_1$, $L_2$, $L_3$ and $L_4$ is independently selected from an aromatic linker, an aliphatic linker, a cycloaliphatic linker, a polyether linker, a polythioether linker, a polyalkylene imine linker, a polyester linker and combinations thereof.

Item 21. The photoinitiator according to any one of Items 12, 16, 18 and 19, each linker $L_1$, $L_2$, $L_3$ and $L_4$ is independently selected from:

- a trivalent moiety corresponding to formula (11):

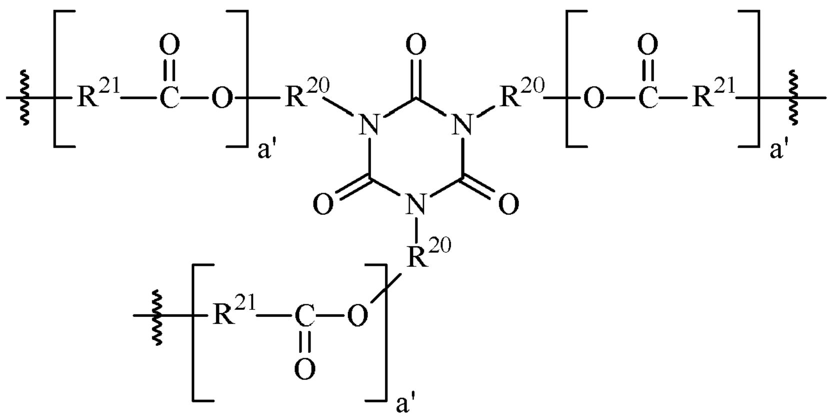

(11)

wherein:

- $R^{20}$ and $R^{21}$ are independently a linear or branched alkylene;
- a' is an integer equal to 0 or 1;

- a trivalent moiety corresponding to formula (12):

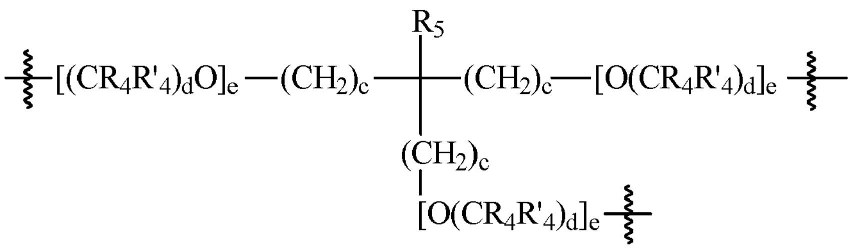

(12)

wherein:

- $R_4$ and $R'_4$ are independently H or methyl;
- $R_5$ is H, alkyl or alkoxy, preferably $R_5$ is alkyl;
- each c is independently an integer from 0 to 2 with the proviso that not more than one c is equal to 0, preferably each c is equal to 1 or one c is equal to 0 and the two other c are equal to 1;
- each d is independently an integer from 2 to 4, in particular 2;
- each e is independently an integer from 0 to 10, in particular from 1 to 6;

- a trivalent moiety corresponding to formula (13):

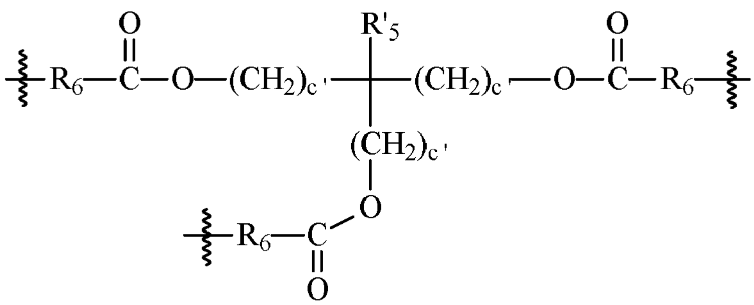

(13)

wherein :

- $R'_5$ is H, alkyl or alkoxy, preferably $R'_5$ is alkyl;

- each $R_6$ is independently a linear or branched alkylene;
- each c' is independently an integer from 0 to 2 with the proviso that not more than one c' is equal to 0, preferably each c' is equal to 1 or one c' is equal to 0 and the two other c' are equal to 1;

- a trivalent moiety corresponding to formula (14a), (14b) or (14c):

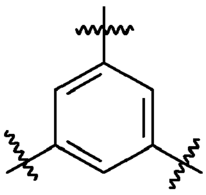
(14a)

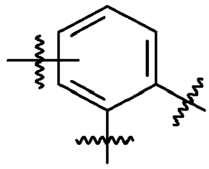
(14b)

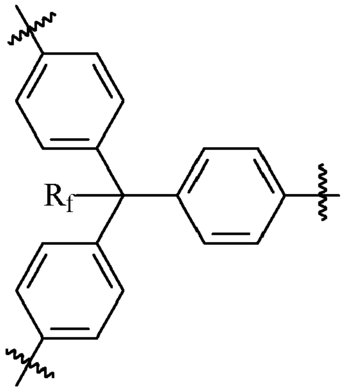
(14c)

wherein $R_f$ is H or methyl;
- a tetravalent moiety corresponding to formula (15a) or (15b):

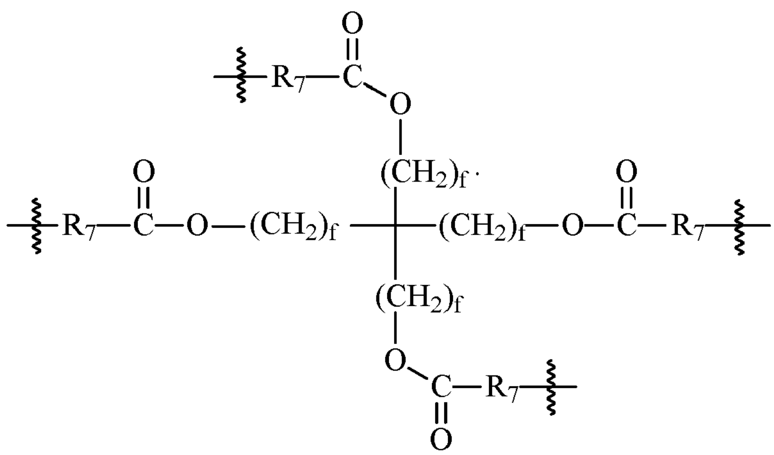
(15a)

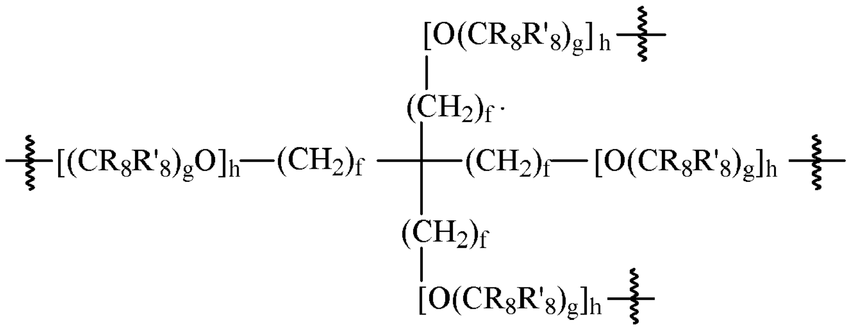

(15b)

wherein:

- each $R_7$ is independently a linear or branched alkylene;
- $R_8$ and $R'_8$ are independently H or methyl;
- each f is independently an integer from 0 to 2 with the proviso that not more than one f is equal to 0, preferably each f is equal to 1;
- each g is independently an integer from 2 to 4, in particular 2;
- each h is independently an integer from 0 to 10, in particular from 1 to 6;

- a tetravalent moiety corresponding to formula (16):

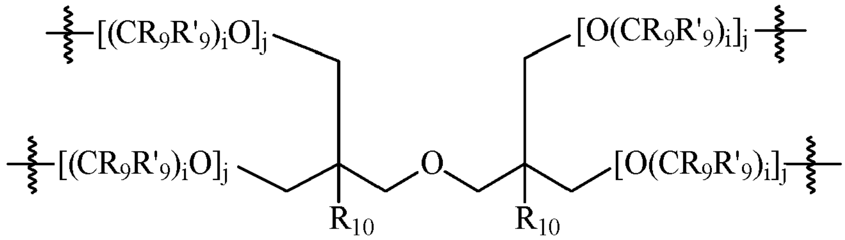

(16)

wherein

- $R_9$ and $R'_9$ are independently H or methyl;
- each $R_{10}$ is independently H, alkyl or alkoxy, preferably $R_{10}$ is alkyl;
- each i is independently an integer from 2 to 4, in particular 2;
- each j is independently an integer from 0 to 10, in particular from 1 to 6;

- a tetra-, penta- or hexavalent moiety corresponding to formula (17):

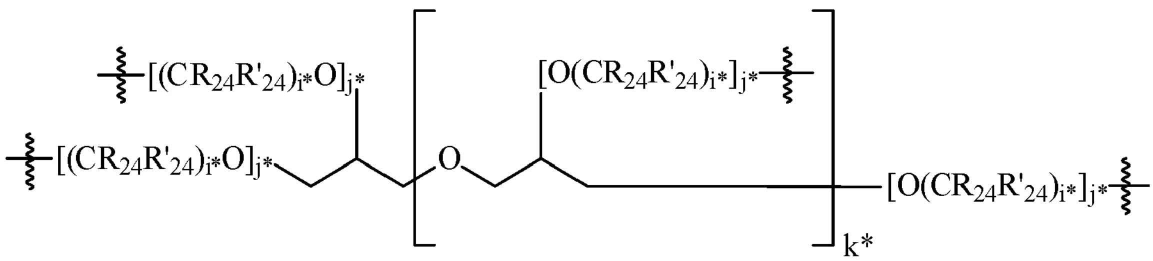

(17)

wherein:

- $R_{24}$ and $R'_{24}$ are independently H or methyl;

- each i* is independently an integer from 2 to 4, in particular 2;
- each j* is independently an integer from 0 to 10, in particular from 1 to 6;
- k' is an integer from 1 to 3;

- a hexavalent moiety corresponding to formula (18):

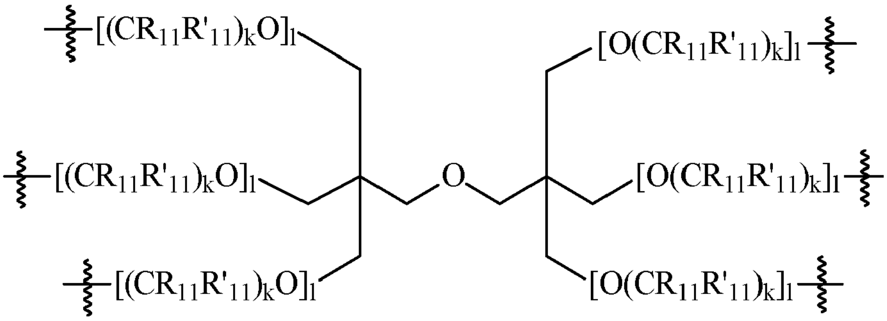
(18)

wherein

- $R_{11}$ and $R'_{11}$ are independently H or methyl;;
- each k is independently an integer from 2 to 4, in particular 2;
- each l is independently an integer from 0 to 10, in particular from 1 to 6

- a hexavalent moiety corresponding to formula (19):

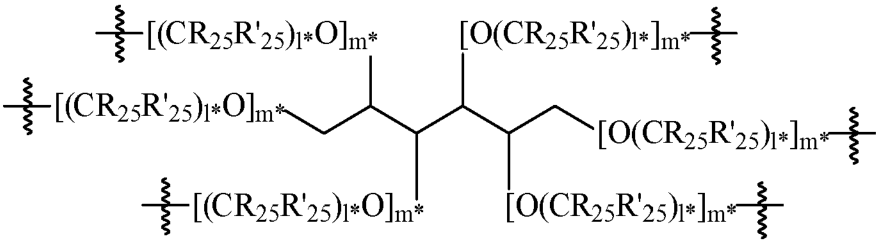
(19)

wherein:

- $R_{25}$ and $R'_{25}$ are independently H or methyl;
- each l* is independently an integer from 2 to 4, in particular 2;
- each m* is independently an integer from 0 to 10, in particular from 1 to 6;

- a divalent moiety according to one of formulae (20) to (28):

$-(CR_{12}R'_{12})_m-$ (20)

$-[(CR_{13}R'_{13})_n-O]_o-(CR_{13}R'_{13})_n-$ (21)

$-[(CR_{14}R'_{14})_p-O]_q-(CR_{15}R'_{15})_r-[0-(CR_{14}R'_{14})_p]_q-$ (22)

$-[(CR_{16}R'_{16})_s-C(=O)O]_t-(CR_{17}R'_{17})_u-$ (23a)

$-(CR_{17}R'_{17})_u-[(CR_{16}R'_{16})_s-C(=O)O]_t-$ (23b)

$-[(CR_{18}R'_{18})_v-O-C(=O)-(CR_{19}R'_{19})_w-C(=O)-O]_x-(CR_{18}R'_{18})_v-$ (24)

$-[(CR_{20}R'_{20})y-S]_z-(CR_{20}R'_{20})y-$ (25)

$-(CR_{21}R'_{21})_{m}'-C(=O)-O-(CR_{22}R'_{22})_{n}'-O-C(=O)-(CR_{21}R'_{21})_{m}'-$ (26)

$-(CR_{23}R'_{23})_{m''}-Cy-[L-Cy]_{n''}-(CR_{23}R'_{23})_{m''}-$ (27)

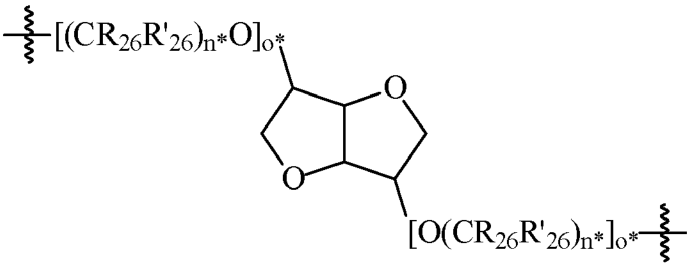

(28)

wherein:

- $R_{12}$, $R'_{12}$, $R_{15}$, $R'_{15}$, $R_{17}$, $R'_{17}$, $R_{18}$, $R'_{18}$, $R_{19}$, $R'_{19}$, $R_{21}$, $R'_{21}$, $R_{22}$, $R'_{22}$, $R_{23}$ and $R'_{23}$ are independently H or alkyl;
- $R_{13}$, $R'_{13}$, $R_{14}$, $R'_{14}$, $R_{16}$, $R'_{16}$, $R_{20}$, $R'_{20}$, $R_{26}$ and $R'_{26}$ are independently H or methyl;
- Cy is an optionally substituted ring, in particular an optionally substituted cyclohexylene or phenylene;
- L is a bond or a linker such as Alk, -C(=O)-, -C(=O)-O-Alk-O-C(=O)-, -SO-, $-SO_2-$, $-C(=CCl_2)-$ and -Alk-Ph-Alk-;
- Alk is an optionally substituted alkylene;
- Ph is an optionally substituted phenylene;
- m, n', r, v, u, w are independently an integer from 2 to 20;
- each m" is independently an integer from 0 to 20;
- n, n*, p and y are independently an integer from 2 to 4;
- n" is an integer equal to 0 or 1;
- m', o, t, x and z are independently an integer from 1 to 20;
- each o* is independently an integer from 0 to 10, in particular from 1 to 6;
- each q is independently an integer from 0 to 20 with the proviso that at least one q is not 0 ;
- s is an integer from 3 to 12.

Item 22. The photoinitiator according to any one of Items 12, 16, 18 and 19, wherein $L_1$, $L_2$, $L_3$ and $L_4$ are independently selected from: preferably each linker $L_1$, $L_2$, $L_3$ and $L_4$ is independently a divalent linker selected from an alkylene group such as 1,3-propanediyl, 1,3- or 1,4-butanediyl, 1,5-pentanediyl, 1,6-hexanediyl, 1,8-octanediyl, 1,9-nonanediyl, 1,10-decanediyl, 1,12-decanediyl, 2-methyl-1,3-propanediyl, 2,2-diethyl-1,3-propanediyl, 3-methyl-1,5-pentanediyl, 3,3-dimethyl-1,5-pentanediyl, 2,2-dimethyl-1,3-propanediyl, 2,4-diethyl-1,5-pentanediyl; an alkoxylated derivative of the aforementioned alkylenes, preferably an ethoxylated and/or propoxylated derivative of the aforementioned alkylenes; an esterified, preferably by ring-opening polymerization of a lactone such as ε-caprolactone, derivative of the aforementioned alkylenes; a residue of a di-, tri-, tetra- or polyoxyalkene without the hydroxy groups such as di-, tri- or tetraethylene glycol, di-, tri- or tetrapropylene glycol, di-, tri- or tetrabutylene glycol, polyethylene glycol, polypropylene glycol, polybutylene glycol, poly(ethylene glycol-co-propylene glycol).

Item 23. The photoinitiator according to any one of Items 1 to 7 and 9, wherein the photoinitiator is according to formula (2) and the $Q_3$ moieties form a polymeric backbone; preferably the photoinitiator of formula (2) comprises:

- a plurality of units of formula (29):

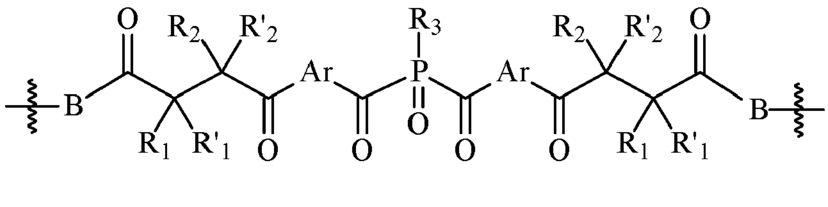

(29)

wherein

- B is *-O-[$CH_2$-CH(OH)-Y]$_a$-, -S- or - N($R^{18}$)-;
- Y, $R^{18}$ and a are as defined in Item 1;
- the symbol * represents a point of attachment to the C(=O) groups;

and;

- a plurality of units according to one of formulae (20) to (28) as defined in Item 21.

Item 24. A process for the preparation of a photoinitiator of formula (1) or (2) according to any one of Items 1 to 7 and 9 to 23, wherein the process comprises reacting at least one precursor of formula (30) or (31) with at least one product of formula (32):

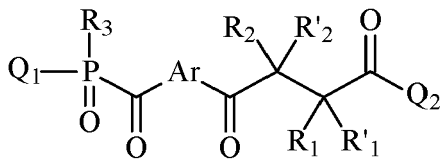

(1)

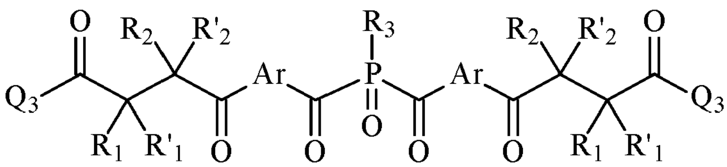

(2)

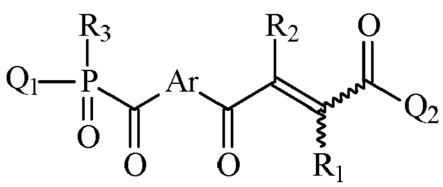

(30)

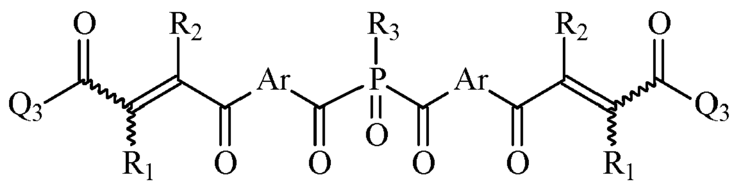

(31)

$R'_1$-$R'_2$ (32)

wherein Ar, $R_1$, $R_2$, $R_3$, $R'_1$, $R'_2$, $Q_1$, $Q_2$ and $Q_3$ are as defined in any one of Items 1 to 23;

preferably the product of formula (32) is selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, N-methylpiperazine, oxazolidine, thiazolidine, thiomorpholine, azepane), more particularly a secondary cyclic amine (for example morpholine, piperidine, pyrrolidine, N-methylpiperazine, oxazolidine, thiazolidine, thiomorpholine, azepane);
- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol,

butoxyethanol, benzyl alcohol, methoxy polyethylene glycol);

- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile).

Item 25. A precursor of formula (30) or (31):

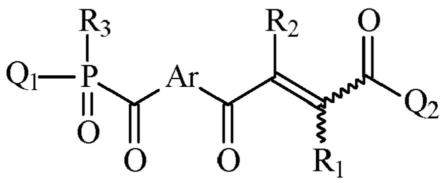

(30)

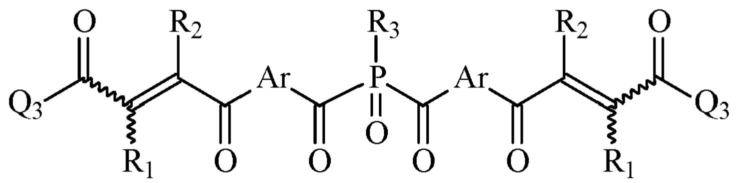

(31)

wherein Ar, $R_1$, $R_2$, $R_3$, $Q_1$, $Q_2$ and $Q_3$ are as defined in any one of Items 1 to 23.

Item 26. A process for the preparation of a precursor of formula (30) or (31) according to Item 25, wherein the process comprises reacting at least one precursor of formula (33) or (34) with at least one compound of formula (35) to (42):

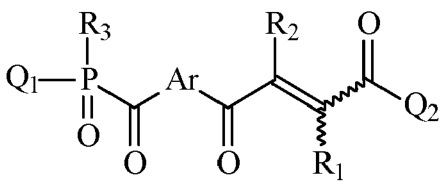

(30)

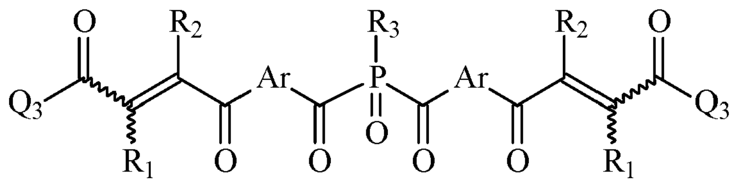

(31)

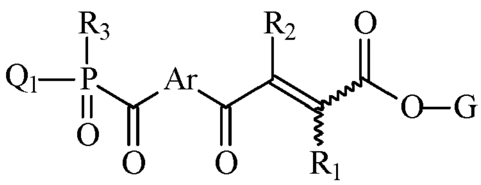

(33)

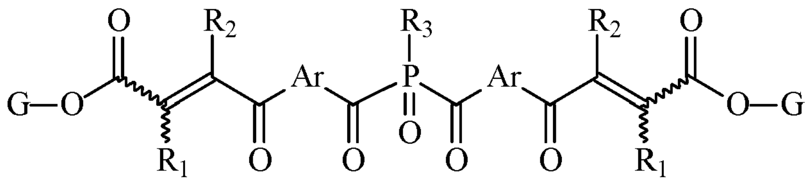

(34)

$R^{14}$-OH (35)

$R^{15}$-SH (36)

$NHR^{16}R^{17}$ (37)

$Z^{1a}$-OH (38)

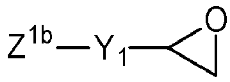

(39)

$Z^2$-SH (40)

$Z^3$-NH($R^{18}$) (41)

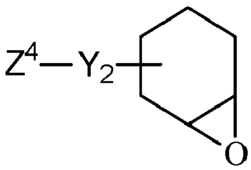

(42)

wherein:

- Ar, $R_1$, $R_2$, $R_3$, $Q_1$, $Y_1$ and $Y_2$ are as defined in any one of Items 1 to 3 and 9 to 10;
- G is H, a halogen atom or -C(=O)-J;
- J is alkyl or aryl, in particular tert-butyl;
- $R^{14}$ is as defined in Item 1 or 11;
- $R^{15}$ is as defined in Item 1 or 15;
- $R^{16}$ and $R^{17}$ are as defined in Item 1 or 17;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

Item 27. The process of Item 26, wherein the process comprises reacting at least one precursor of formula (33) or (34) with at least one compound of formula (38) and $Z^{1a}$ corresponds to formula (43):

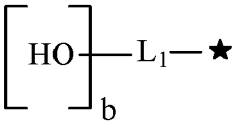

(43)

wherein $L_1$ and b are as defined in any one of Items 12 and 20 to 22;

preferably the compound of formula (38) is a polyol selected from ethylene glycol, 1,2- or 1,3-propylene glycol, 1,2-, 1,3- or 1,4-butylene glycol, 1,5-pentanediol, 1,6-hexanediol, 1,7-heptanediol, 1,8-octanediol, 1,9-nonanediol, 1,10-decanediol, 1,12-dodecanediol, 2-methyl-1,3-propanediol, 2,2-diethyl-1,3-propanediol, 3-methyl-1,5-pentanediol, 3,3-dimethyl-1,5-pentanediol, neopentyl glycol, 2,4-diethyl-1,5-pentanediol, 3,3-butylethyl-1,5-pentane diol, cyclohexanediol, cyclohexane-1,4-dimethanol, norbornene dimethanol, norbornane dimethanol, tricyclodecanediol, tricyclodecane dimethanol, dicyclopentadiene diol, hydroquinone bis(2-hydroxyethyl) ether, pyrocatechol, resorcinol, cardol, phloroglucinol, pyrogallol, tris(hydroxyphenyl)methane, tris(hydroxyphenyl)ethane, bisphenol A, B, F or S, hydrogenated bisphenol A, B, F or S, trimethylolmethane, trimethylolethane, trimethylolpropane, di(trimethylolpropane), triethylolpropane, pentaerythritol, di(pentaerythritol), glycerol, di-, tri- or tetraglycerol, a polyglycerol, di-, tri- or tetra(ethylene glycol), di-, tri- or tetra(1,2-propylene glycol), di-, tri- or tetra(1,3-propylene glycol), di-, tri- or tetra(1,4-butylene glycol), a polyethylene glycol), a polypropylene glycol), a poly(trimethylene glycol), a poly(tetramethylene glycol), a poly(ethylene glycol-co-propylene glycol), an alditol i.e. erythritol, threitol, arabitol, xylitol, ribitol, mannitol, sorbitol, glactitol, fucitol or iditol), a dianhydrohexitol (i.e. isosorbide, isomannide, isoidide), tris(2-hydroxyethyl)isocyanurate, a hydroxylated vegetable oil, $C_{36}$-dimer diol, a polybutadiene polyol, a polyester polyol, a polyether polyol, a polyorganosiloxane polyol, a polycarbonate polyol, as well as the alkoxylated (e.g., ethoxylated and/or propoxylated) derivatives thereof and the derivatives obtained by ring-opening polymerization of ε-caprolactone initiated with one of the aforementioned polyols, and combinations thereof.

Item 28. The process of Item 26, wherein the process comprises reacting at least one precursor of formula (33) or (34) with at least one compound of formula (39) and $Z^{1b}$ corresponds to formula (44):

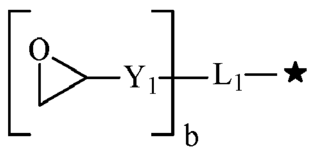

(44)

wherein:

- $Y_1$ is as defined in Item 1;
- $L_1$ and b are as defined in any one of Items 12 and 20 to 22;

preferably the compound of formula (39) is a polyepoxide selected from 1,2,3,4-diepoxybutane, 1,2,4,5-diepoxypentane, 1,2,5,6-diepoxyhexane, 1,2,7,8-diepoxyoctane, 1,2,9,10-diepoxydecane, ethylene glycol diglycidyl ether, 1,2- or 1,3-propylene glycol diglycidyl ether, 1,2-, 1,3- or 1,4-butanediol diglycidyl ether, 1,5-pentanediol diglycidyl ether, 1,6-hexanediol diglycidyl ether, 1,7-hexanediol diglycidyl ether, 1,8-octanediol diglycidyl ether, 1,9-nonanediol diglycidyl ether, 1,10-decanediol diglycidyl ether, 1,12-dodecanediol diglycidyl ether, 2-methyl-1,3-propanediol diglycidyl ether, neopentyl glycol diglycidyl ether, 2,2-diethyl-1,3-propane diol diglycidyl ether, 3-methyl-1,5-pentanediol diglycidyl ether, 3,3-dimethyl-1,5-pentanediol diglycidyl ether, 2,4-diethyl-1,5-pentanediol diglycidyl ether, 3,3-butylethyl-1,5-pentane diol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a poly(ethylene glycol) diglycidyl ether, a polypropylene glycol) diglycidyl ether, a poly(trimethylene glycol) diglycidyl ether, a poly(tetramethylene glycol) diglycidyl ether, a poly(ethylene glycol-co-propylene glycol) diglycidyl ether, glycerol triglycidyl ether, a polyglycerol polyglycidyl ether, trimethylolmethane triglycidyl ether, trimethylolethane triglycidyl ether, trimethylolpropane triglycidyl ether, di(trimethylolpropane) tetraglycidyl ether, pentaerythritol tetraglycidyl ether, diglycidyl cyclohexanedicarboxylate, cyclohexane diglycidyl ether, cyclohexane-1,4-dimethanol diglycidyl ether, tricyclodecane dimethanol diglycidyl ether, isosorbide diglycidyl ether, pyrocatechol diglycidyl ether, resorcinol diglycidyl ether, cardol diglycidyl ether, phloroglucinol triglycidyl ether, pyrogallol triglycidyl ether, tris(hydroxyphenyl)methane triglycidyl ether, tris(hydroxyphenyl)ethane triglycidyl ether, bisphenol A, B, F or S diglycidyl ether, hydrogenated bisphenol A, B, F or S diglycidyl ether, diglycidyl phthalate, diglycidyl terephthalate, diglycidyl isophthalate, limonene dioxide (4-vinyl-1-cyclohexene diepoxide), an epoxidized vegetable oil, triglycidyl isocyanurate, and combinations thereof.

Item 29. The process of Item 26, wherein the process comprises reacting at least one precursor of formula (33) or (34) with at least one compound of formula (40) and $Z^2$ corresponds to formula (45):

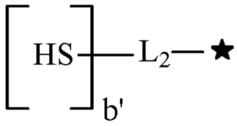

(45)

wherein $L_2$ and b' are as defined in any one of Item 16 and 20 to 22;

preferably the compound of formula (40) is a polythiol selected from ethane-1,2-dithiol, propane-1,3-dithiol, butane-1,4-dithiol, hexane-1.6-dithiol, octane-1,8-dithiol, decane-1,10-dithiol, 1,8-dimercapto-3,6-dioxaoctane (DMDO), di-, tri- or polyethylene glycol di(ethanethiol), ethylene glycol bis(mercaptoacetate), ethylene glycol bis(3-mercaptopropionate), ethylene glycol bis(3-mercaptobutyrate), 1,2-propylene glycol bis(mercaptoacetate), 1,2-propylene glycol bis(3-mercaptopropionate), 1,2-propylene glycol bis(3-mercaptobutyrate), 1,3-propylene glycol bis(mercaptoacetate), 1,3-propylene glycol bis(3-mercaptopropionate), 1,3-propylene glycol bis(3-mercaptobutyrate), 1,4-butanediol bis(mercaptoacetate), 1,4-butanediol bis(3-mercaptopropionate), 1,4-butanediol bis(3-mercaptobutyrate), 1,6-hexanediol bis(mercaptoacetate), 1,6-hexanediol bis(3-mercaptopropionate), 1,6-hexanediol bis(3-mercaptobutyrate), di-, tri- or polyethylene glycol bis(mercaptoacetate), di-, tri- or polyethylene glycol bis(3-mercaptopropionate), di-, tri- or polyethylene glycol bis(3-mercaptobutyrate), di-, tri- or polypropylene glycol bis(mercaptoacetate), di-, tri- or polypropylene glycol bis(3-mercaptopropionate), di-, tri- or polypropylene glycol bis(3-mercaptobutyrate), trimethylolpropane tris(mercaptoacetate), trimethylolpropane tris(3-mercaptopropionate), trimethylolpropane tris(3-mercaptobutyrate), pentaerythritol tetrakis(mercaptoacetate), pentaerythritol tetrakis(3-mercaptopropionate), pentaerythritol tetrakis(3-mercaptobutyrate), tris[2-(3-mercaptopropionyloxy)ethyl] isocyanurate, tris[2-(3-mercaptopropionyloxy)ethyl] isocyanurate, tris[2-(3-mercaptobutyryloxy)ethyl] isocyanurate, mercaptan-terminated polymers, as well as the alkoxylated (e.g., ethoxylated and/or propoxylated) derivatives thereof, and combinations thereof.

Item 30. The process of Item 26, wherein the process comprises reacting at least one precursor of formula (33) or (34) with at least one compound of formula (41) and $Z^3$ corresponds to formula (46):

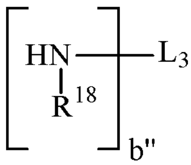

(46)

wherein:

- $R^{18}$ is as defined in Item 1;
- $L_3$ and b" are as defined in any one of Items 18 and 20 to 22;

preferably the compound of formula (41) is a polyamine selected from 1-amino-3-aminomethyl-3,5,5-trimethyl cyclohexane (IPDA), bis(4-aminocyclohexyl)methane, bis(4-amino-3-methylcyclohexyl)methane, 2-methyl pentamethylene diamine, ethylene diamine, 1,2- or 1,3-propanediamine, 2-methyl-1,2-propanediamine, 2,2-dimethyl-1,3-propanediamine, 1,3- or 1,4-butane diamine, 1,3- or 1,5-pentane diamine, 2-methyl-1,5-pentane diamine, 1,6-hexane diamine, 2,5-dimethyl-2,5-hexane diamine, 2,2,4- or 2,4,4-trimethyl-1,6-hexane diamine, 1,7-heptane diamine, 1,8-octane diamine, 1,9-nonane diamine, 1,10-decane diamine, 1,11-undecane diamine, 1,12-dodecane diamine, 2,4- or 2,6-hexahydrotoluylene diamine, 2,4'- or 4,4'-diamino-dicyclohexylmethane, 1,3- or 1,4-cyclohexane diamine, 1,3- or 1,4-bis(methylamino)cyclohexane, 1,8-p-menthane diamine, hydrazine, phenylene diamine, 2,3- 2,4- 3,4- or 2,6-toluylene diamine, o-, m- or p-xylylene diamine, 2,4'- or 4,4'-diaminodiphenyl methane, benzidine, N-(2-aminoethyl)-1,3-propane diamine, N,N'-di-(2-aminoethyl)piperazine, a polyetheramine (in particular a Jeffamine® such as Jeffamine® D-230, Jeffamine® D-400, Jeffamine® D-2000, Jeffamine® D-2010, Jeffamine® D-4000, Jeffamine® ED-600, Jeffamine® ED-900, Jeffamine® ED-2003, Jeffamine® EDR-148, Jeffamine® EDR-176, Jeffamine® THF-100, Jeffamine® THF-170, Jeffamine® T403, Jeffamine® T3000, Jeffamine® T5000, Jeffamine® RFD-270) and combinations thereof.

Item 31. The process of Item 26, wherein the process comprises reacting at least one precursor of formula (33) or (34) with at least one compound of formula (42) and $Z^{1b}$ corresponds to formula (47):

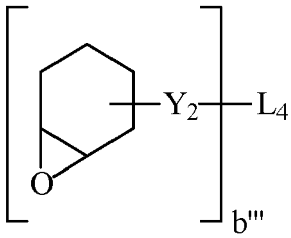

(47)

wherein:

- $Y_2$ is as defined in Item 1;
- $L_4$ and b‴ are as defined in any one of Items 19 to 22;

preferably the compound of formula (42) is a cycloaliphatic polyepoxide selected from 7-oxabicyclo[4.1.0]hept-3-ylmethyl 7-oxabicyclo[4.1.0]heptane-3-carboxylate (UviCure S105), bis((3,4-epoxycyclohexyl)methyl) adipate (UviCure S128), a compound of formula (47a), (47b) or (47c) and combinations thereof

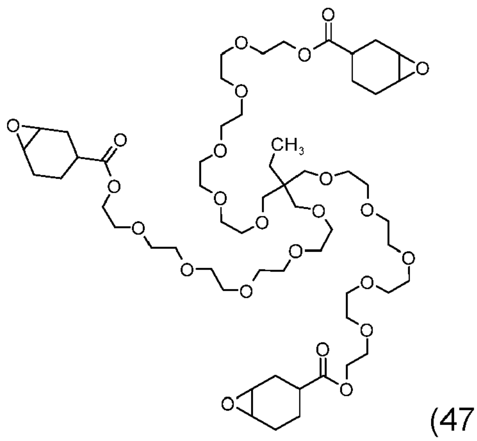

(47a)

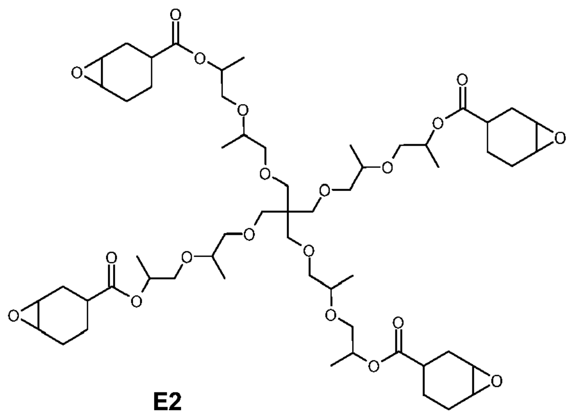

**E2**

(47b)

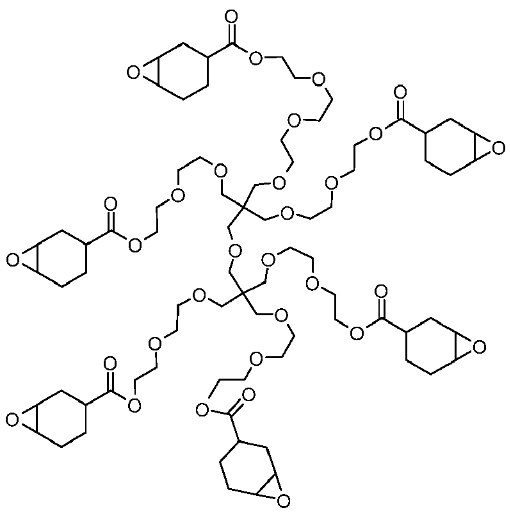

(47c).

Item 32. A precursor of formula (33) or (34)

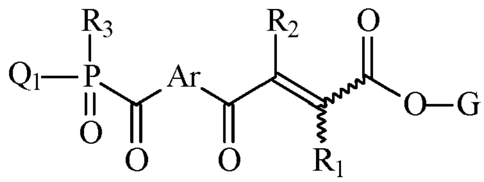

(33)

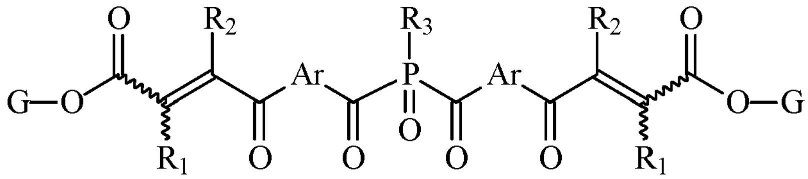

(34)

wherein:

- Ar, $R_1$, $R_2$, $R_3$, $Q_1$ are as defined in any one of Items 1 to 7 and 9 to 10;
- G is H, a halogen atom or -C(=O)-J;
- J is alkyl or aryl, in particular tert-butyl.

Item 33. A process for the preparation of a precursor of formula (33) or (34) according to Item 32, wherein the process comprises reacting at least one phosphine oxide of formula (48) or (49) with at least one cyclic anhydride of formula (50) to provide a precursor according to formula (33) or (34) wherein G is H:

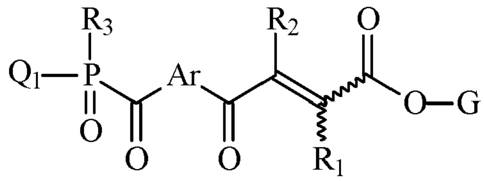

(33)

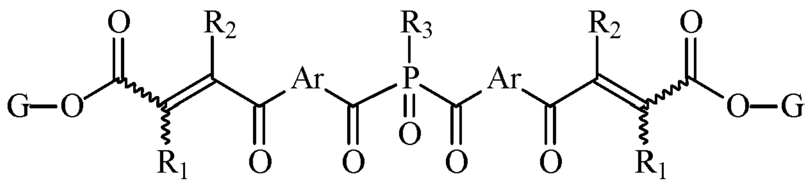

(34)

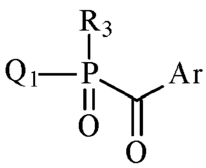

(48)

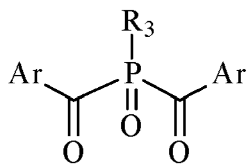

(49)

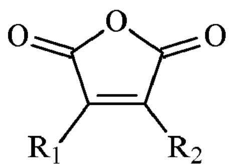

(50)

wherein Ar, $R_1$, $R_2$, $R_3$, $Q_1$ are as defined in any one of Items 1 to 7 and 9 to 10;
the process optionally comprising an additional step of:

- reacting the precursor according to formula (33) or (34) wherein G is H with an acyl halide of formula (51) to provide a precursor according to formula (33) or (34) wherein G is -C(=O)-J

Hal-C(=O)-J (51)

wherein Hal is a halogen atom and J is alkyl or aryl, in particular tert-butyl; or

- reacting the precursor according to formula (33) or (34) wherein G is H with a halogenating agent, in particular thionyl chloride, to provide a precursor according to formula (33) or (34) wherein G is a halogen atom.

Item 34. A process for the preparation of a photoinitiator of formula (1) or (2) according to any one of Items 1 to 7 and 9 to 23, wherein the process comprises reacting at least one precursor of formula (52) or (53) with at least one compound of formula (35) to (42):

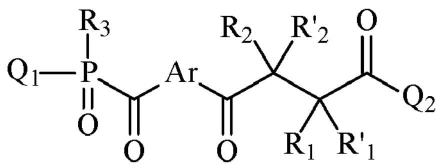

(1)

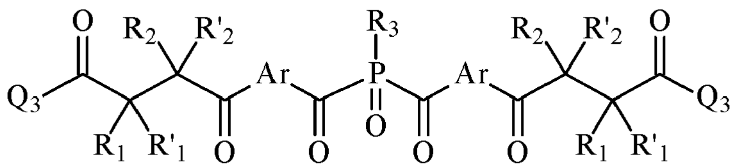

(2)

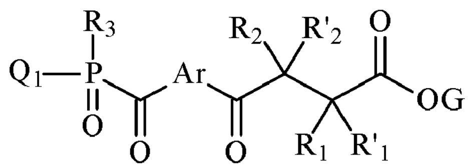

(52)

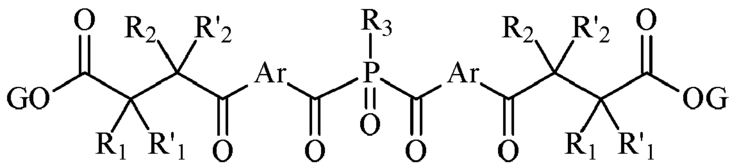

(53)

$R^{14}$-OH (35)

$R^{15}$-SH (36)

$NHR^{16}R^{17}$ (37)

$Z^{1a}$-OH (38)

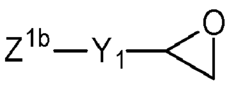

(39)

$Z^2$-SH (40)

$Z^3$-NH($R^{18}$) (41)

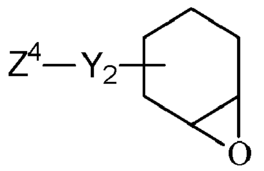

(42)

wherein:

- Ar, $R_1$, $R_2$, $R_3$, $R'_1$, $R'_2$, $Q_1$, $Y_1$ and $Y_2$ are as defined in any one of Items 1 to 7 and 9 to 10;
- G is H, a halogen atom or -C(=O)-J;
- J is alkyl or aryl, in particular tert-butyl;
- $R^{14}$ is as defined in Item 1 or 11;
- $R^{15}$ is as defined in Item 1 or 15;
- $R^{16}$ and $R^{17}$ are as defined in Item 1 or 17;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

Item 35. The process of Item 34, wherein the process comprises reacting at least one precursor of formula (52) or (53) with at least one compound of formula (38) and $Z^{1a}$ corresponds to formula (43):

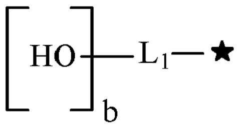

(43)

wherein $L_1$ and b are as defined in any one of Item 12 and 20 to 22;

preferably the compound of formula (38) is a polyol selected from ethylene glycol, 1,2- or 1,3-propylene glycol, 1,2-, 1,3- or 1,4-butylene glycol, 1,5-pentanediol, 1,6-hexanediol, 1,7-heptanediol, 1,8-octanediol, 1,9-nonanediol, 1,10-decanediol, 1,12-dodecanediol, 2-methyl-1,3-propanediol, 2,2-diethyl-1,3-propanediol, 3-methyl-1,5-pentanediol, 3,3-dimethyl-1,5-pentanediol, neopentyl glycol, 2,4-diethyl-1,5-pentanediol, 3,3-butylethyl-1,5-pentane diol, cyclohexanediol, cyclohexane-1,4-dimethanol, norbornene dimethanol, norbornane dimethanol, tricyclodecanediol, tricyclodecane dimethanol, dicyclopentadiene diol, hydroquinone bis(2-hydroxyethyl) ether, pyrocatechol, resorcinol, cardol, phloroglucinol, pyrogallol, tris(hydroxyphenyl)methane, tris(hydroxyphenyl)ethane, bisphenol A, B, F or S, hydrogenated bisphenol A, B, F or S, trimethylolmethane, trimethylolethane, trimethylolpropane, di(trimethylolpropane), triethylolpropane, pentaerythritol, di(pentaerythritol), glycerol, di-, tri- or tetraglycerol, a polyglycerol, di-, tri- or tetra(ethylene glycol), di-, tri- or tetra(1,2-propylene glycol), di-, tri- or tetra(1,3-propylene glycol), di-, tri- or tetra(1,4-butylene glycol), a polyethylene glycol), a polypropylene glycol), a poly(trimethylene glycol), a poly(tetramethylene glycol), a poly(ethylene glycol-co-propylene glycol), an alditol i.e. erythritol, threitol, arabitol, xylitol, ribitol, mannitol, sorbitol, glactitol, fucitol or iditol), a dianhydrohexitol (i.e. isosorbide, isomannide, isoidide), tris(2-hydroxyethyl)isocyanurate, a hydroxylated vegetable oil, $C_{36}$-dimer diol, a polybutadiene polyol, a polyester polyol, a polyether polyol, a polyorganosiloxane polyol, a polycarbonate polyol, as well as the alkoxylated (e.g., ethoxylated and/or propoxylated) derivatives thereof and the derivatives obtained by ring-opening polymerization of ε-caprolactone initiated with one of the aforementioned polyols, and combinations thereof.

Item 36. The process of Item 34, wherein the process comprises reacting at least one precursor of formula (52) or (53) with at least one compound of formula (39) and $Z^{1b}$ corresponds to formula (44):

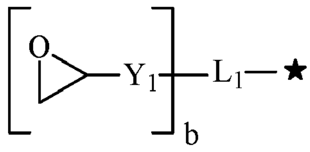

(44)

wherein:

- $Y_1$ is as defined in Item 1;
- $L_1$ and b are as defined in any one of Items 12 and 20 to 22;

preferably the compound of formula (39) is a polyepoxide selected from 1,2,3,4-diepoxybutane, 1,2,4,5-diepoxypentane, 1,2,5,6-diepoxyhexane, 1,2,7,8-diepoxyoctane, 1,2,9,10-diepoxydecane, ethylene glycol diglycidyl ether, 1,2- or 1,3-propylene glycol diglycidyl ether, 1,2-, 1,3- or 1,4-butanediol diglycidyl ether, 1,5-pentanediol diglycidyl ether, 1,6-hexanediol diglycidyl ether, 1,7-hexanediol diglycidyl ether, 1,8-octanediol diglycidyl ether, 1,9-nonanediol diglycidyl ether, 1,10-decanediol diglycidyl ether, 1,12-dodecanediol diglycidyl ether, 2-methyl-1,3-propanediol diglycidyl ether, neopentyl glycol diglycidyl ether, 2,2-diethyl-1,3-propane diol diglycidyl ether, 3-methyl-1,5-pentanediol diglycidyl ether, 3,3-dimethyl-1,5-pentanediol diglycidyl ether, 2,4-diethyl-1,5-pentanediol diglycidyl ether, 3,3-butylethyl-1,5-pentane diol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a poly(ethylene glycol) diglycidyl ether, a polypropylene glycol) diglycidyl ether, a poly(trimethylene glycol) diglycidyl ether, a poly(tetramethylene glycol) diglycidyl ether, a poly(ethylene glycol-co-propylene glycol) diglycidyl ether, glycerol triglycidyl ether, polyglycerol polyglycidyl ether, trimethylolmethane triglycidyl ether, trimethylolethane triglycidyl ether, trimethylolpropane triglycidyl ether, di(trimethylolpropane) tetraglycidyl ether, pentaerythritol tetraglycidyl ether, diglycidyl cyclohexanedicarboxylate, cyclohexane diglycidyl ether, cyclohexane-1,4-dimethanol diglycidyl ether, tricyclodecane dimethanol diglycidyl ether, isosorbide diglycidyl ether, pyrocatechol diglycidyl ether, resorcinol diglycidyl ether, cardol diglycidyl ether, phloroglucinol triglycidyl ether, pyrogallol triglycidyl ether, tris(hydroxyphenyl)methane triglycidyl ether, tris(hydroxyphenyl)ethane triglycidyl ether, bisphenol A, B, F or S diglycidyl ether, hydrogenated bisphenol A, B, F or S diglycidyl ether, diglycidyl phthalate, diglycidyl terephthalate, diglycidyl isophthalate, limonene dioxide (4-vinyl-1-cyclohexene diepoxide), an epoxidized vegetable oil, triglycidyl isocyanurate, and combinations thereof.

Item 37. The process of Item 34, wherein the process comprises reacting at least one precursor of formula (52) or (53) with at least one compound of formula (40) and $Z^2$ corresponds to formula (45):

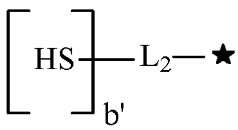

(45)

wherein $L_2$ and b' are as defined in any one of Items 16 and 20 to 22;

preferably the compound of formula (40) is a polythiol selected from ethane-1,2-dithiol, propane-1,3-dithiol, butane-1,4-dithiol, hexane-1,6-dithiol, octane-1,8-dithiol, decane-1,10-dithiol, 1,8-dimercapto-3,6-dioxaoctane (DMDO), di-, tri- or polyethylene glycol di(ethanethiol), ethylene glycol bis(mercaptoacetate), ethylene glycol bis(3-mercaptopropionate), ethylene glycol bis(3-mercaptobutyrate), 1,2-propylene glycol bis(mercaptoacetate), 1,2-propylene glycol bis(3-mercaptopropionate), 1,2-propylene glycol bis(3-mercaptobutyrate), 1,3-propylene glycol bis(mercaptoacetate), 1,3-propylene glycol bis(3-mercaptopropionate), 1,3-propylene glycol bis(3-mercaptobutyrate), 1,4-butanediol bis(mercaptoacetate), 1,4-butanediol bis(3-mercaptopropionate), 1,4-butanediol bis(3-mercaptobutyrate), 1,6-hexanediol bis(mercaptoacetate), 1,6-hexanediol bis(3-mercaptopropionate), 1,6-hexanediol bis(3-mercaptobutyrate), di-, tri- or polyethylene glycol bis(mercaptoacetate), di-, tri- or polyethylene glycol bis(3-mercaptopropionate), di-, tri- or polyethylene glycol bis(3-mercaptobutyrate), di-, tri- or polypropylene glycol bis(mercaptoacetate), di-, tri- or polypropylene glycol bis(3-mercaptopropionate), di-, tri- or polypropylene glycol bis(3-mercaptobutyrate), trimethylolpropane tris(mercaptoacetate), trimethylolpropane tris(3-mercaptopropionate), trimethylolpropane tris(3-mercaptobutyrate), pentaerythritol tetrakis(mercaptoacetate), pentaerythritol tetrakis(3-mercaptopropionate), pentaerythritol tetrakis(3-mercaptobutyrate),

tris[2-(3-mercaptopropionyloxy)ethyl] isocyanurate, tris[2-(3-mercaptopropionyloxy)ethyl] isocyanurate, tris[2-(3-mercaptobutyryloxy)ethyl] isocyanurate, mercaptan-terminated polymers, as well as the alkoxylated (e.g., ethoxylated and/or propoxylated) derivatives thereof, and combinations thereof.

Item 38. The process of Item 34, wherein the process comprises reacting at least one precursor of formula (52) or (53) with at least one compound of formula (41) and $Z^3$ corresponds to formula (46):

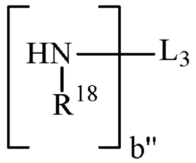

(46)

wherein:

- $R^{18}$ is as defined in Item 1;
- $L_3$ and b" are as defined in any one of Items 18 and 20 to 22;

preferably the compound of formula (41) is a polyamine selected from 1-amino-3-aminomethyl-3,5,5-trimethyl cyclohexane (IPDA), bis(4-aminocyclohexyl)methane, bis(4-amino-3-methylcyclohexyl)methane, 2-methyl pentamethylene diamine, ethylene diamine, 1,2- or 1,3-propanediamine, 2-methyl-1,2-propanediamine, 2,2-dimethyl-1,3-propanediamine, 1,3- or 1,4-butane diamine, 1,3- or 1,5-pentane diamine, 2-methyl-1,5-pentane diamine, 1,6-hexane diamine, 2,5-dimethyl-2,5-hexane diamine, 2,2,4- or 2,4,4-trimethyl-1,6-hexane diamine, 1,7-heptane diamine, 1,8-octane diamine, 1,9-nonane diamine, 1,10-decane diamine, 1,11-undecane diamine, 1,12-dodecane diamine, 2,4- or 2,6-hexahydrotoluylene diamine, 2,4'- or 4,4'-diamino-dicyclohexylmethane, 1,3- or 1,4-cyclohexane diamine, 1,3- or 1,4-bis(methylamino)cyclohexane, 1,8-p-menthane diamine, hydrazine, phenylene diamine, 2,3- 2,4- 3,4- or 2,6-toluylene diamine, o-, m- or p-xylylene diamine, 2,4'- or 4,4'-diaminodiphenyl methane, benzidine, N-(2-aminoethyl)-1,3-propane diamine, N,N'-di-(2-aminoethyl)piperazine, a polyetheramine (in particular a Jeffamine® such as Jeffamine® D-230, Jeffamine® D-400, Jeffamine® D-2000, Jeffamine® D-2010, Jeffamine® D-4000, Jeffamine® ED-600, Jeffamine® ED-900, Jeffamine® ED-2003, Jeffamine® EDR-148, Jeffamine® EDR-176, Jeffamine® THF-100, Jeffamine® THF-170, Jeffamine® T403, Jeffamine® T3000, Jeffamine® T5000, Jeffamine® RFD-270) and combinations thereof.

Item 39. The process of Item 34, wherein the process comprises reacting at least one precursor of formula (52) or (53) with at least one compound of formula (42) and $Z^4$ corresponds to formula (47):

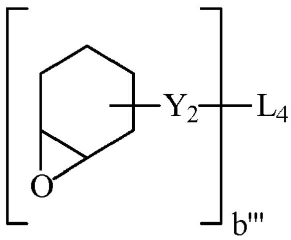

(47)

wherein:

- $Y_2$ is as defined in Item 1;
- $L_4$ and b‴ are as defined in any one of Items 19 to 22;

preferably the compound of formula (42) is a cycloaliphatic polyepoxide selected from 7-oxabicyclo[4.1.0]hept-3-ylmethyl 7-oxabicyclo[4.1.0]heptane-3-carboxylate (UviCure S105), bis((3,4-epoxycyclohexyl)methyl) adipate (UviCure S128), a compound of formula (47a), (47b) or (47c) and combinations thereof

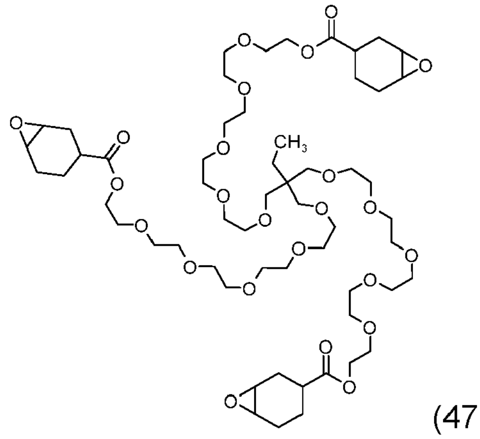

(47a)

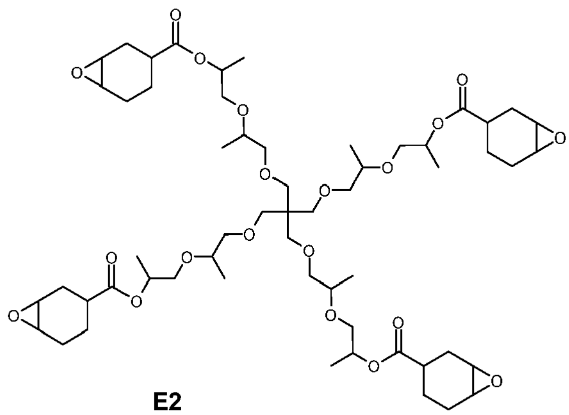

E2

(47b)

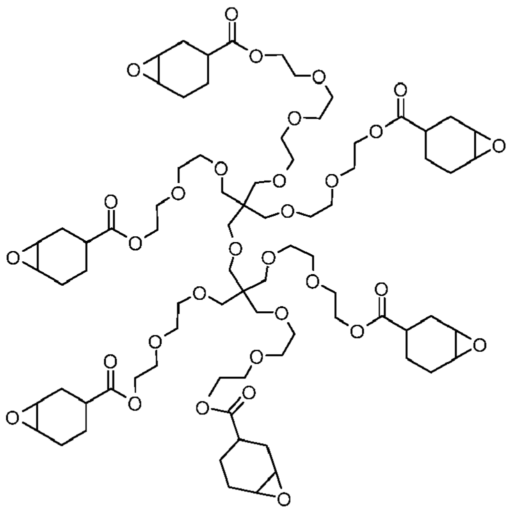

(47c).

Item 40. A precursor of formula (52) or (53):

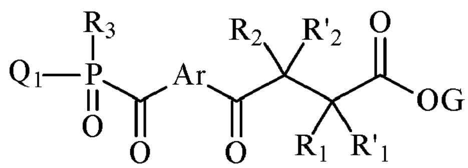

(52)

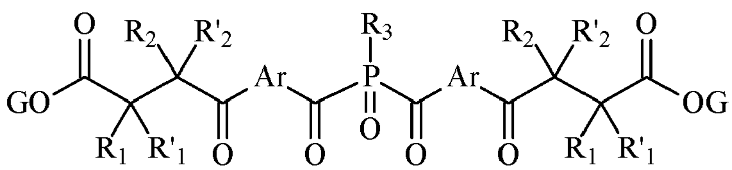

(53)

wherein:

- Ar, $R_1$, $R_2$, $R_3$, $R'_1$, $R'_2$ and $Q_1$ are as defined in any one of Items 1 to 7 and 9 to 10;
- G is H, a halogen atom or -C(=O)-J;
- J is alkyl or aryl, in particular tert-butyl.

Item 41. A process for the preparation of a precursor of formula (52) or (53) according to Item 40, wherein the

process comprises reacting at least one precursor of formula (33) or (34) with at least one product of formula (32) to provide a precursor of formula (52) or (53) wherein G is H:

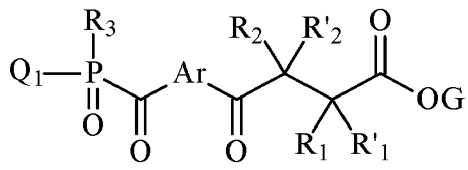

(52)

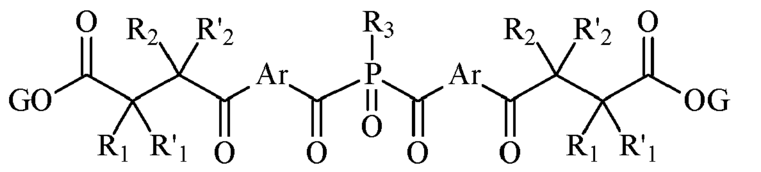

(53)

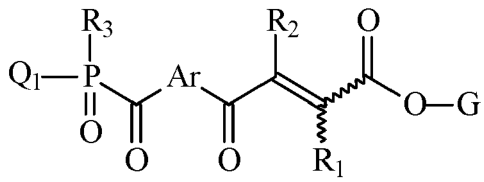

(33)

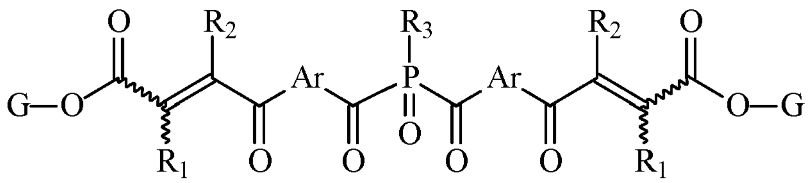

(34)

R'$_1$-R'$_2$ (32)

wherein

- Ar, $R_1$, $R_2$, $R_3$, R'$_1$, R'$_2$ and $Q_1$ are as defined in any one of Items 1 to 7 and 9 to 10;
- G is H;
- J is alkyl or aryl, in particular tert-butyl;

the process optionally comprising an additional step of:

- reacting the precursor according to formula (52) or (53) wherein G is H with an acyl halide of formula (51) to provide a precursor according to formula (52) or (53) wherein G is -C(=O)-J

  Hal-C(=O)-J (51)

  wherein Hal is a halogen atom and J is alkyl or aryl, in particular tert-butyl; or
- reacting the precursor according to formula (52) or (53) wherein G is H with a halogenating agent, in particular thionyl chloride, to provide a precursor according to formula (52) or (53) wherein G is a halogen atom.

Item 42. The process according to Item 41, wherein the product of formula (32) is selected from:

- an amine, in particular a secondary amine (for example sec-butylamine, isobutylamine, tert-butylamine, cyclohexylamine, 1,1,3,3-tetramethyl butylamine, morpholine, piperidine, pyrrolidine, N-methylpiperazine, oxazolidine, thiazolidine, thiomorpholine, azepane) more particularly a secondary cyclic amine (for example morpholine, piperidine, pyrrolidine, N-methylpiperazine, oxazolidine, thiazolidine, thiomorpholine, azepane);

- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);
- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile).

Item 43. A process for the preparation of a photoinitiator of formula (5) or (6) according to Item 8, wherein the process comprises reacting at least one precursor of formula (33) or (34) with at least one product of formula (54):

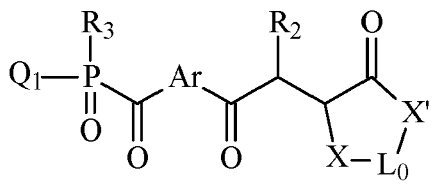

(5)

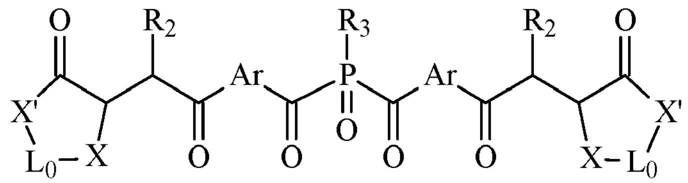

(6)

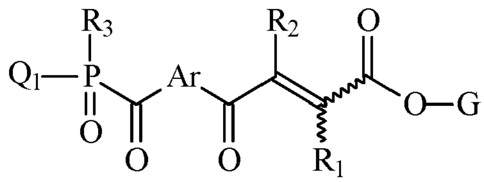

(33)

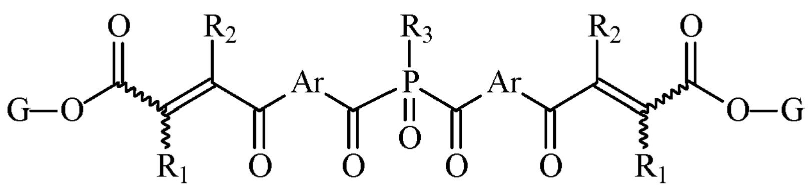

(34)

$HX-L_0-X'H$ (54)

wherein:

- Ar, $R_1$, $R_2$, $R_3$, $Q_1$, are as defined in any one of Items 1 to 7 and 9 to 23;
- X, X' and $L_0$ are as defined in Item 8,
- G is H, a halogen atom or -C(=O)-J;
- J is alkyl or aryl, in particular tert-butyl;

preferably the product of formula (54) is a compound bearing two functional groups independently selected from hydroxyl, amino and thiol,
more preferably the product of formula (54) is an aminoalcohol (for example 2-aminoethanol, 2-(methylamino)ethanol, 2-(ethylamino)ethanol, 3-methylamino-1-propanol) an aminothiol (for example 2-aminoethanethiol), a mercaptoalcohol (for example 2-hydroxyethanethiol), a diol (for example ethylene glycol, propylene glycol, 1,3-propanediol, 1,4-butanediol), a diamine (for example ethylenediamine, 1,2'-dimethylethylenediamine, 1,2'-diethylethylenediamine, N-methylethylenediamine, N-ethylethylenediamine, 1,2-diaminopropane, diethylenetriamine), an amino acid or an amino ester containing an amine group and an alcohol or thiol group (for example D/L-serine, D/L-cysteine, D/L-threonine, and esters thereof particularly methyl or ethyl esters thereof).

Item 44. A photoinitiator composition comprising:

- a mixture of at least two photoinitiators of formula (1) according to any one of Items 1 to 22;
- a mixture of at least two photoinitiators of formula (2) according to any one of Items 1 to 23;
- a mixture of at least one photoinitiator of formula (1) according to any one of Items 1 to 22 and at least one precursor of formula (30) according to Item 25; or
- a mixture of at least one photoinitiator of formula (2) according to any one of Items 1 to 23 and at least one precursor of formula (31) according to Item 25.

Item 45. A photoinitiator composition comprising a photoinitiator of formula (1) or (2) according to any one of Items 1 to 23 and a photoinitiator other than a photoinitiator of formula (1) or (2), in particular a photoinitiator selected from SpeedCure MBF (methyl benzoylformate), SpeedCure 73 (2-hydroxy-2-methyl-1-phenylpropanone), SpeedCure 7005 (polymeric benzophenone).

Item 46. A process for photopolymerizing one or more ethylenically unsaturated compounds comprising contacting one or more ethylenically unsaturated compounds with a photoinitiator of formula (1) or (2) according to any one of Items 1 to 23 or a photoinitiator composition according to Item 44 or 45, and irradiating the mixture, in particular with UV, near-UV, visible, infrared and/or near-infrared radiation.

Item 47. A curable composition comprising:

a) a photoinitiator of formula (1) or (2) according to any one of Items 1 to 23 or a photoinitiator composition according to Item 44 or 45; and
b) an ethylenically unsaturated compound.

Item 48. The curable composition of Item 47, wherein the composition further comprises a cationically-polymerizable compound, in particular a cationically polymerizable compound selected from epoxides, oxetanes, oxolanes, cyclic acetals, cyclic lactones, thiiranes, thiethanes, spiro orthoesters, derivatives thereof and mixtures thereof.

Item 49. The curable composition of Item 47 or 48, wherein the composition further comprises a polyol and/or polythiol.

Item 50. The curable composition of any one of Items 47 to 49, wherein the composition further comprises an additive, in particular an additive selected from sensitizers, amine synergists, stabilizers, antioxidants, light blockers, polymerization inhibitors, foam inhibitors, flow or leveling agents, colorants, pigments, dispersants (wetting agents, surfactants), slip additives, fillers, thixotropic agents, matting agents, impact modifiers, waxes and mixtures thereof.

Item 51. The curable composition of any one of Items 47 to 50, wherein the composition is an ink composition, a coating composition, an adhesive composition, a sealant composition, a molding composition, a dental composition, a nail polish composition or a 3D-printing composition.

Item 52. A process for the preparation of a cured product, comprising curing the curable composition according to any one of Items 47 to 51, preferably by exposing the curable composition to radiation such as UV, near-UV, visible, infrared and/or near-infrared radiation.

Item 53. A process of 3D printing comprising printing a 3D article with the composition according to any one of Items 47 to 51, in particular layer by layer or continuously.

Item 54. A process of inkjet printing comprising jetting the curable composition according to any one of Items 47 to 51 onto a substrate.

Item 55. A process of coating a nail, wherein the process comprises applying the curable composition according to

any one of Items 47 to 51 on a nail, and curing the composition on the nail.

Item 56. A use of a photoinitiator of formula (1) or (2) according to any one of Items 1 to 23 or a photoinitiator composition according to Item 44 or 45, as a photoinitiator or a photoinitiating system in a radiation curable composition, preferably in a UV or LED-curable composition.

Item 57. A use of a photoinitiator of formula (1) or (2) according to any one of Items 1 to 23 or a photoinitiator composition according to Item 44 or 45, to cure one or more ethylenically unsaturated compounds.

Item 58. A use of a photoinitiator of formula (1) or (2) according to any one of Items 1 to 23 or a photoinitiator composition according to Item 44 or 45, to obtain a cured product having a reduced amount of extractables.

## Claims

1. A photoinitiator according to formula (1) or (2):

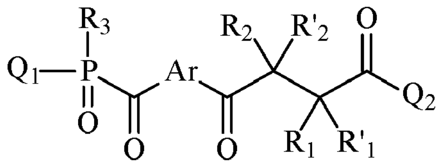

(1)

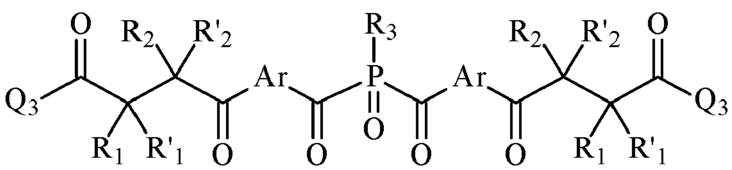

(2)

wherein:

- each Ar is independently an optionally substituted arylene;
- $R_1$ and $R_2$ are independently H or an optionally substituted group selected from alkyl and aryl; or $R_1$ and $R_2$, together with the carbon atoms to which they are attached, form a ring;
- one of $R'_1$ and $R'_2$ is H and the other of $R'_1$ and $R'_2$ is selected from $-OR^4$, $-SR^5$, $-NR^6R^7$, $-C(R^8)(CO-W^1-R^9)(CO-W^2-R^{10})$, $-C(R^{11})(CO-W^3-R^{12})(CN)$ and $-C(R^{13})(CN)_2$; or $R'_2$ is H and $R'_1$ and $Q_2$, together with the atoms to which they are attached, form a 5-7 membered ring; or $R'_2$ is H and $R'_1$ and $Q_3$, together with the atoms to which they are attached, form a 5-8 membered ring;
- each $R_3$ is independently an optionally substituted group selected from alkyl, aryl and alkoxy;
- $R^4$, $R^5$, $R^6$ and $R^7$ are independently H or an optionally substituted group selected from alkyl, a polyoxyalkylene, cycloalkyl, heterocycloalkyl, aryl and heteroaryl; or $R^6$ and $R^7$, together with the nitrogen atom to which they are attached, form a 5-7 membered ring;
- $R^8$, $R^{11}$ and $R^{13}$ are independently H or an optionally substituted alkyl group, preferably H;
- $R^9$, $R^{10}$ and $R^{12}$ are independently an optionally substituted group selected from alkyl, cycloalkyl, heterocycloalkyl, aryl and heteroaryl, or $R^9$ and $R^{10}$, together with the atoms to which they are attached, form a 5-7 membered ring,
- $W^1$, $W^2$ and $W^3$ are independently selected from a bond or an oxygen atom;
- $Q_1$ is an optionally substituted aryl or a group of formula (3):

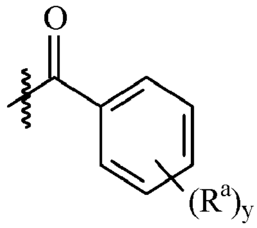

(3)

wherein:

- each $R^a$ is independently an optionally substituted group selected from alkyl, aryl, alkoxy, aryloxy, thioalkyl and thioaryl; and
- y is a number chosen from 0 to 5;

- $Q_2$ and $Q_3$ are independently $-OR^{14}$, $-SR^{15}$, $-NR^{16}R^{17}$, $-O-[CH_2-CH(OH)-Y_1]_a-Z^1$, $-S-Z^2$, $-N(R^{18})-Z^3$ or -O-Cyhex-$Y_2$-$Z^4$; or $Q_2$ and $R'_1$, together with the atoms to which they are attached, form a 5-7 membered ring; or $Q_3$ and $R'_1$, together with the atoms to which they are attached, form a 5-7 membered ring;
- $R^{14}$ and $R^{15}$ are independently H or an optionally substituted group selected from alkyl, cycloalkyl, heterocycloalkyl, aryl and heteroaryl;
- $R^{16}$, $R^{17}$ and $R^{18}$ are independently H, or an optionally substituted group selected from alkyl and aryl; or $R^{16}$ and $R^{17}$, together with the nitrogen atom to which they are attached, form a 5-7 membered ring;
- Cyhex is a cycloyhexylene substituted by a hydroxyl group, preferably represented by the following formula:

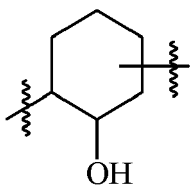

- $Y_1$ is a bond, $-CH_2-O-*$ or $-CH_2-C(=O)-O-*$;
- $Y_2$ is a bond, $-CH_2-O-C(=O))-^{\#}$ or $-C(=O)-O-^{\#}$;
- a is 0 or 1;
- $Z^1$, $Z^2$, $Z^3$ and $Z^4$ are independently a phosphine oxide-containing moiety;
- the symbol * represents a point of attachment to moiety $Z^1$;
- the symbol # represents a point of attachment to moiety $Z^4$.

**2.** The photoinitiator according to claim 1, wherein $Q_1$ is phenyl or a group of formula (3a):

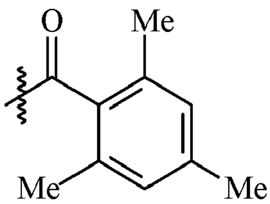

(3a).

**3.** The photoinitiator according to claim 1 or 2, wherein

- $Q_2$ and $Q_3$ are independently $-OR^{14}$;
- $R^{14}$ is an optionally substituted alkyl, preferably methyl or ethyl.

**4.** The photoinitiator according to claim 1 or 2, wherein

- $Q_2$ and $Q_3$ are independently $-O-[CH_2-CH(OH)-Y_1]_a-Z^1$;
- $Z^1$ is a group of formula (7);

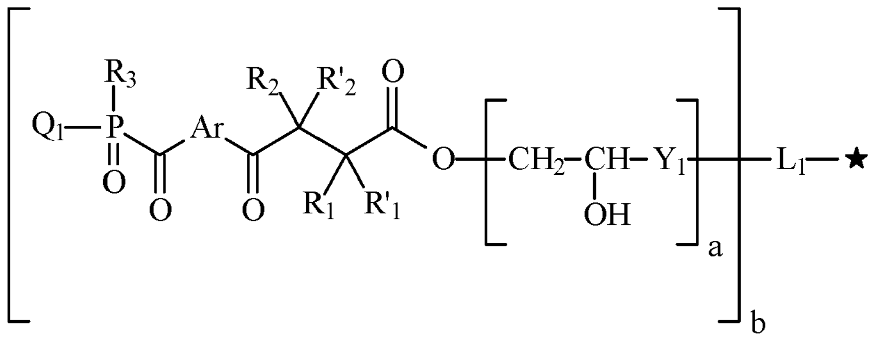

(7)

wherein:

- Ar, $Y_1$, $R_1$, $R_2$, $R'_1$, $R'_2$, $R_3$, $Q_1$ and a are as defined in claim 1 or 2;
- $L_1$ is a linker; and
- b is a number chosen from 1 to 15.

**5.** The photoinitiator according to claim 1 or 2, wherein

- $Q_2$ and $Q_3$ are independently $-NR^{16}R^{17}$;
- $R^{16}$ and $R^{17}$ are independently H, or an optionally substituted group selected from alkyl and aryl; or $R^{16}$ and $R^{17}$, together with the nitrogen atom to which they are attached, form a 5-7 membered ring.

**6.** The photoinitiator according to claim 1 or 2, wherein

- $Q_2$ and $Q_3$ are independently $-N(R^{18})-Z^3$;
- $R^{18}$ is H or an optionally substituted group selected from alkyl and aryl;
- $Z^3$ is a group of formula (9):

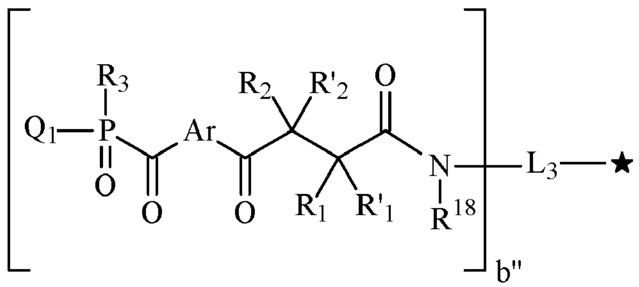

(9)

wherein:

- Ar, $R_1$, $R_2$, $R'_1$, $R'_2$, $R_3$, $R^{18}$ and $Q_1$ are as defined claim 1 or 2;
- $L_3$ is a linker; and
- b" is a number chosen from 1 to 15.

**7.** The photoinitiator according to claim 1 or 2, wherein

- $Q_2$ and $Q_3$ are independently -O-Cyhex-$Y_2$-$Z^4$;
- $Z^4$ is a group of formula (7) as defined in claim 4 or a group of formula (10);

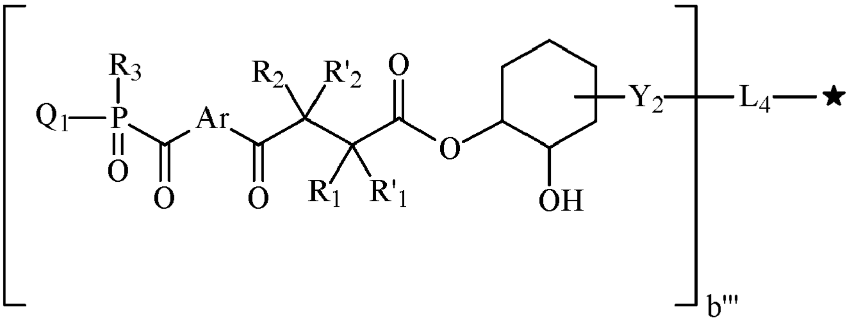

(10)

wherein :

- Ar, $Y_2$, $R_1$, $R_2$, $R'_1$, $R'_2$, $R_3$, $Q_1$ are as defined in claim 1 or 2;
- $L_4$ is a linker; and
- b''' is a number chosen from 1 to 15.

**8.** A process for the preparation of a photoinitiator of formula (1) or (2) according to any one of claims 1 to 7, wherein the process comprises reacting at least one precursor of formula (30) or (31) with at least one product of formula (32):

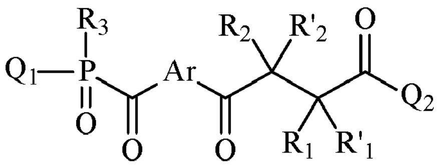

(1)

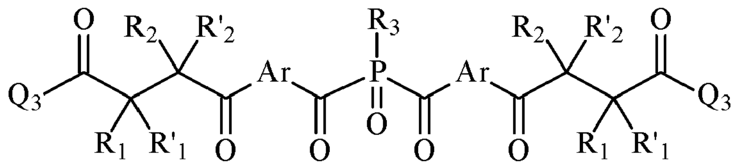

(2)

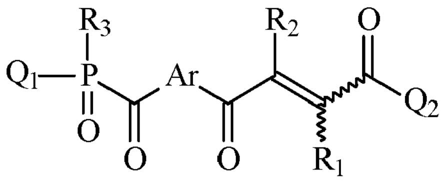

(30)

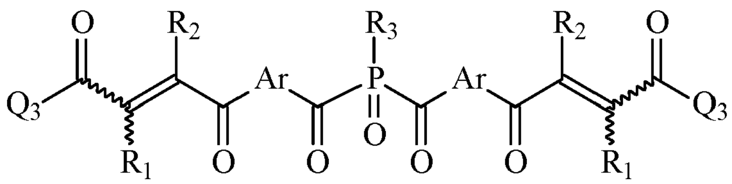

(31)

$R'_1$-$R'_2$ (32)

wherein Ar, $R_1$, $R_2$, $R_3$, $R'_1$, $R'_2$, $Q_1$, $Q_2$ and $Q_3$ are as defined in any one of claims 1 to 7; preferably the product of formula (32) is selected from:

- an amine, in particular a secondary amine (for example sec-butylamine, isobutylamine, tert-butylamine, cyclohexylamine, 1,1,3,3-tetramethylbutylamine, morpholine, piperidine, pyrrolidine, N-methylpiperazine,

oxazolidine, thiazolidine, thiomorpholine, azepane), more particularly a secondary cyclic amine (for example morpholine, piperidine, pyrrolidine, N-methylpiperazine, oxazolidine, thiazolidine, thiomorpholine, azepane);

- an alcohol, in particular a primary alcohol (for example methanol, ethanol, propan-1-ol, butan-1-ol, pentan-1-ol, 3-methylbutan-1-ol, 2,2-dimethylpropan-1-ol, hexan-1-ol, methylpentanol, 3-ethylbutan-1-ol, heptan-1-ol, octan-1-ol, 6-ethylhexa-1-nol, nonan-1-ol, decan-1-ol, dodecan-1-ol, tridecan-1-ol, isotridecan-1-ol, butoxyethanol, benzyl alcohol, methoxy polyethylene glycol);
- a thiol, in particular a primary thiol (for example 1-hexanethiol, 1-octanethiol, 1-decanethiol, 1-dodecanethiol, methyl thioglycolate, ethyl thioglycolate, methyl 3-mercaptopropionate, ethyl 3-mercaptopropionate);
- an active methylene compound, in particular a β-diester (for example dimethylmalonate, diethylmalonate, dipropylmalonate), a β-ketoester (for example ethylacetoacetate), a β-diketone (for example pentane-2,4-dione, cyclohexane-1,3-dione, 5,5-dimethylcyclohexane-1,3-dione), a β-ketonitrile (for example 3-oxobutanenitrile), a β-cyanoester (for example methyl cyanoacetate, ethyl cyanoacetate), a β-dinitrile (for example malononitrile).

**9.** A precursor of formula (30) or (31):

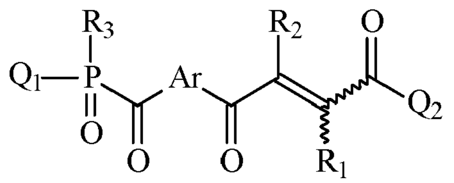

(30)

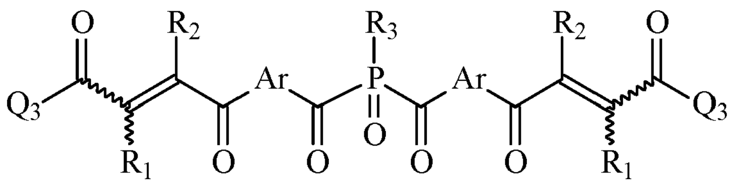

(31)

wherein Ar, $R_1$, $R_2$, $R_3$, $Q_1$, $Q_2$ and $Q_3$ are as defined in any one of claims 1 to 7.

**10.** A process for the preparation of a precursor of formula (30) or (31) according to claim 9, wherein the process comprises reacting at least one precursor of formula (33) or (34) with at least one compound of formula (35) to (42):

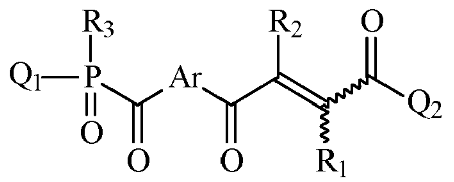

(30)

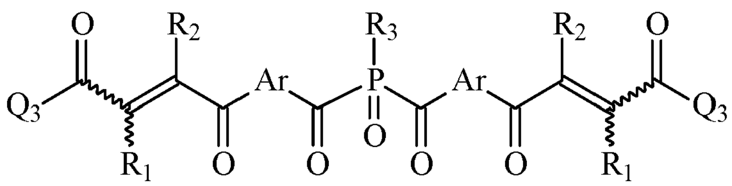

(31)

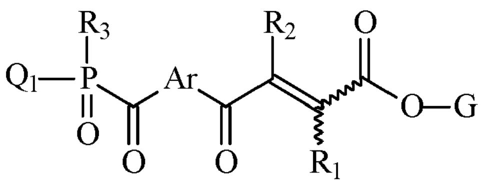

(33)

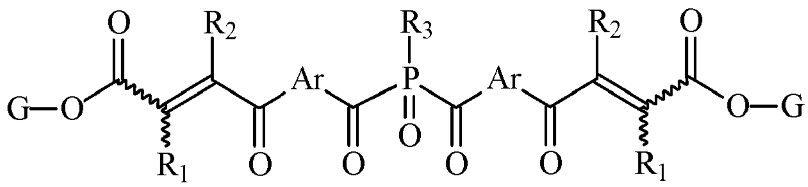

(34)

$R^{14}$-OH (35)

$R^{15}$-SH (36)

$NHR^{16}R^{17}$ (37)

$Z^{1a}$-OH (38)

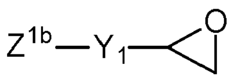

(39)

$Z^2$-SH (40)

$Z^3$-$NH(R^{18})$ (41)

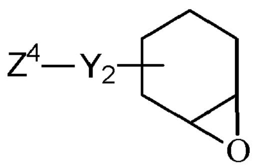

(42)

wherein:

- Ar, $R_1$, $R_2$, $R_3$, $Q_1$, $Y_1$ and $Y_2$ are as defined in claim 1 or 2;
- G is H, a halogen atom or -C(=O)-J;
- J is alkyl or aryl, in particular tert-butyl;
- $R^{14}$ is as defined in claim 1 or 3;
- $R^{15}$ is as defined in claim 1;
- $R^{16}$ and $R^{17}$ are as defined in claim 1 or 5;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

**11.** A precursor of formula (33) or (34)

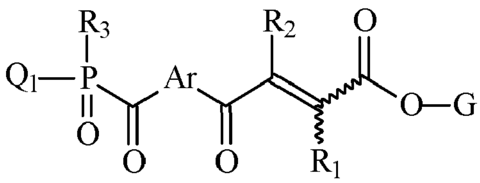

(33)

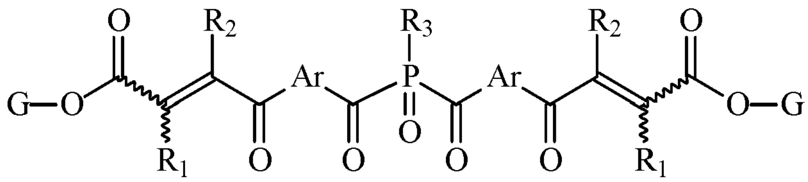

(34)

wherein:

- Ar, $R_1$, $R_2$, $R_3$, $Q_1$ are as defined in claim 1 or 2;
- G is H, a halogen atom or -C(=O)-J;
- J is alkyl or aryl, in particular tert-butyl.

**12.** A process for the preparation of a precursor of formula (33) or (34) according to claim 11, wherein the process comprises reacting at least one phosphine oxide of formula (48) or (49) with at least one cyclic anhydride of formula (50) to provide a precursor according to formula (33) or (34) wherein G is H:

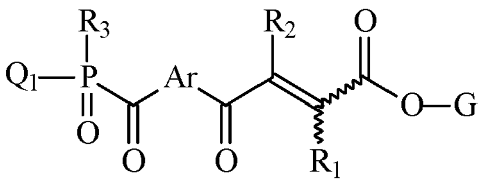

(33)

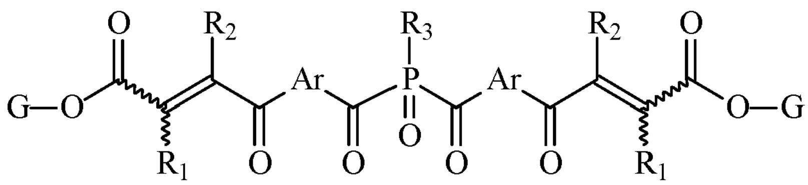

(34)

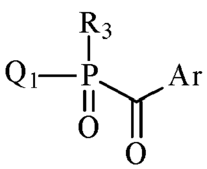

(48)

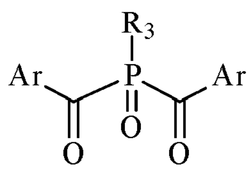

(49)

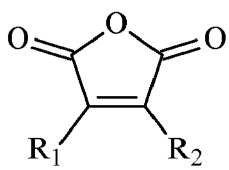

(50)

wherein Ar, $R_1$, $R_2$, $R_3$, $Q_1$ are as defined in claim 1 or 2;
the process optionally comprising an additional step of:

- reacting the precursor according to formula (33) or (34) wherein G is H with an acyl halide of formula (51) to provide a precursor according to formula (33) or (34) wherein G is -C(=O)-J

Hal-C(=O)-J (51)

wherein Hal is a halogen atom and J is alkyl or aryl, in particular tert-butyl; or
- reacting the precursor according to formula (33) or (34) wherein G is H with a halogenating agent, in particular thionyl chloride, to provide a precursor according to formula (33) or (34) wherein G is a halogen atom.

**13.** A process for the preparation of a photoinitiator of formula (1) or (2) according to any one of claims 1 to 7, wherein the process comprises reacting at least one precursor of formula (52) or (53) with at least one compound of formula (35) to (42):

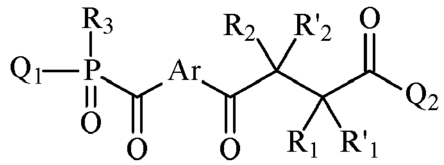
(1)

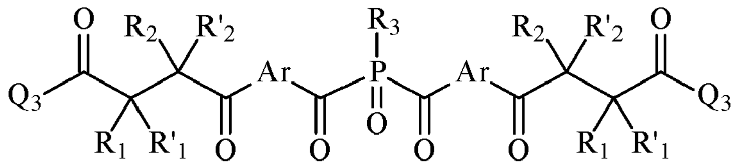
(2)

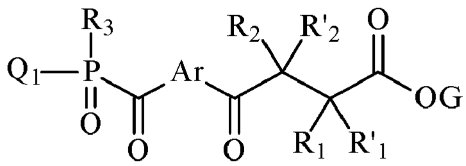
(52)

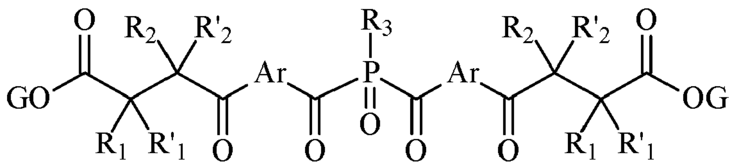
(53)

$R^{14}$-OH (35)

$R^{15}$-SH (36)

$NHR^{16}R^{17}$ (37)

$Z^{1a}$-OH (38)

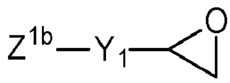
(39)

$Z^2$-SH (40)

$Z^3$-NH($R^{18}$) (41)

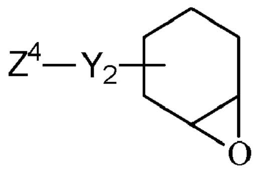

(42)

wherein:

- Ar, $R_1$, $R_2$, $R_3$, $R'_1$, $R'_2$, $Q_1$, $Y_1$ and $Y_2$ are as defined in claim 1 or 2;
- G is H, a halogen atom or -C(=O)-J;
- J is alkyl or aryl, in particular tert-butyl;
- $R^{14}$ is as defined in claim 1 or 3;
- $R^{15}$ is as defined in claim 1;
- $R^{16}$ and $R^{17}$ are as defined in claim 1 or 5;
- $Z^{1a}$ is a hydroxyl-containing moiety;
- $Z^{1b}$ is an epoxide-containing moiety;
- $Z^2$ is a thiol-containing moiety;
- $Z^3$ is an amine-containing moiety;
- $Z^4$ is an epoxide-containing moiety.

**14.** A precursor of formula (52) or (53):

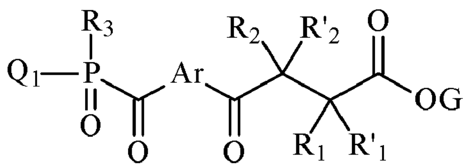

(52)

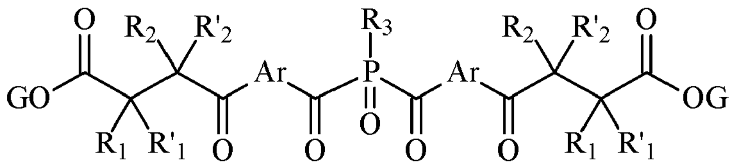

(53)

wherein:

- Ar, $R_1$, $R_2$, $R_3$, $R'_1$, $R'_2$ and $Q_1$ are as defined in claim 1 or 2;
- G is H, a halogen atom or -C(=O)-J;
- J is alkyl or aryl, in particular tert-butyl.

**15.** A process for the preparation of a precursor of formula (52) or (53) according to claim 14, wherein the process comprises reacting at least one precursor of formula (33) or (34) with at least one product of formula (32) to provide a precursor of formula (52) or (53) wherein G is H:

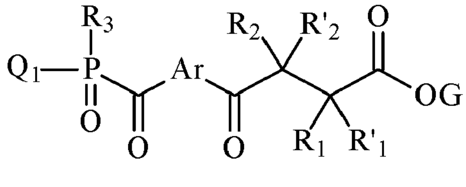

(52)

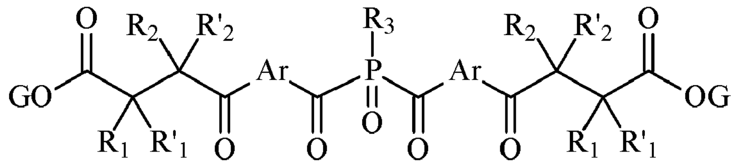

(53)

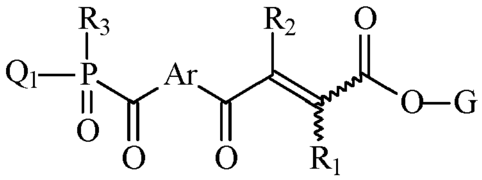

(33)

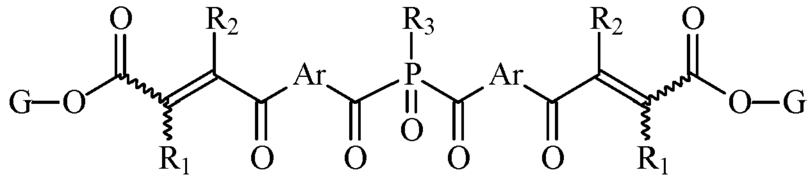

(34)

$R'_1$-$R'_2$ (32)

wherein

- Ar, $R_1$, $R_2$, $R_3$, $R'_1$, $R'_2$ and $Q_1$ are as defined in claim 1 or 2;
- G is H;
- J is alkyl or aryl, in particular tert-butyl;

the process optionally comprising an additional step of:

- reacting the precursor according to formula (52) or (53) wherein G is H with an acyl halide of formula (51) to provide a precursor according to formula (52) or (53) wherein G is -C(=O)-J

Hal-C(=O)-J (51)

wherein Hal is a halogen atom and J is alkyl or aryl, in particular tert-butyl; or
- reacting the precursor according to formula (52) or (53) wherein G is H with a halogenating agent, in particular thionyl chloride, to provide a precursor according to formula (52) or (53) wherein G is a halogen atom.

**16.** A photoinitiator composition comprising:

- a mixture of at least two photoinitiators of formula (1) according to any one of claims 1 to 7;
- a mixture of at least two photoinitiators of formula (2) according to any one of claims 1 to 7;
- a mixture of at least one photoinitiator of formula (1) according to any one of claims 1 to 7 and at least one precursor of formula (30) according to claim 9; or
- a mixture of at least one photoinitiator of formula (2) according to any one of claims 1 to 7 and at least one precursor of formula (31) according to claim 9.

**17.** A photoinitiator composition comprising a photoinitiator of formula (1) or (2) according to any one of claims 1 to 7 and a photoinitiator other than a photoinitiator of formula (1) or (2), in particular a photoinitiator selected from SpeedCure MBF (methyl benzoylformate), SpeedCure 73 (2-hydroxy-2-methyl-1-phenylpropanone), SpeedCure 7005 (polymeric benzophenone).

**18.** A process for photopolymerizing one or more ethylenically unsaturated compounds comprising contacting one or more ethylenically unsaturated compounds with a photoinitiator of formula (1) or (2) according to any one of claims

1 to 7 or a photoinitiator composition according to claim 16 or 17, and irradiating the mixture, in particular with UV, near-UV, visible, infrared and/or near-infrared radiation.

**19.** A curable composition comprising:

a) a photoinitiator of formula (1) or (2) according to any one of claims 1 to 7 or a photoinitiator composition according to claim 16 or 17; and
b) an ethylenically unsaturated compound.

**20.** A process for the preparation of a cured product, comprising curing the curable composition according to claim 19, preferably by exposing the curable composition to radiation such as UV, near-UV, visible, infrared and/or near-infrared radiation.

**21.** A process of 3D printing comprising printing a 3D article with the composition according to claim 19, in particular layer by layer or continuously.

**22.** A process of coating a nail, wherein the process comprises applying the curable composition according to claim 19 on a nail, and curing the composition on the nail.

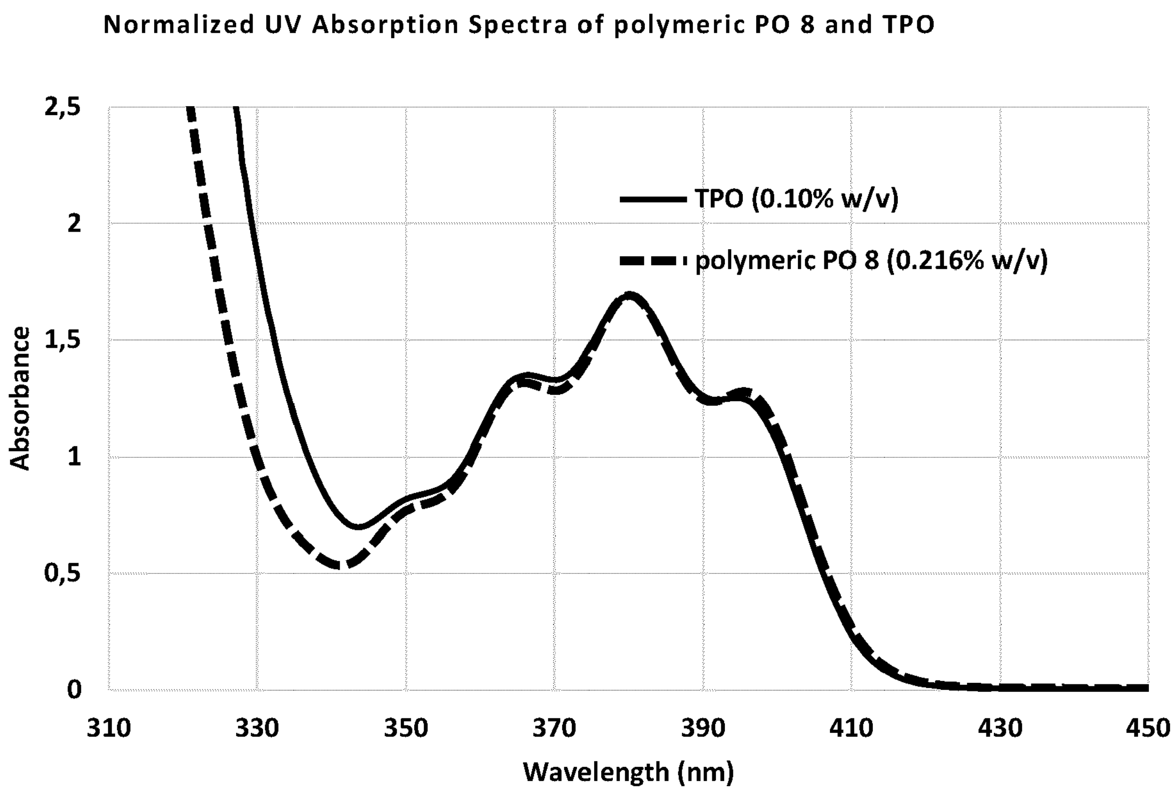
Normalized UV Absorption Spectra of polymeric PO 8 and TPO
2,5
2
1,5
1
0,5
0
Absorbance
310
330
350
370
390
410
430
450
Wavelength (nm)
TPO (0.10% w/v)
polymeric PO 8 (0.216% w/v)

Figure 1

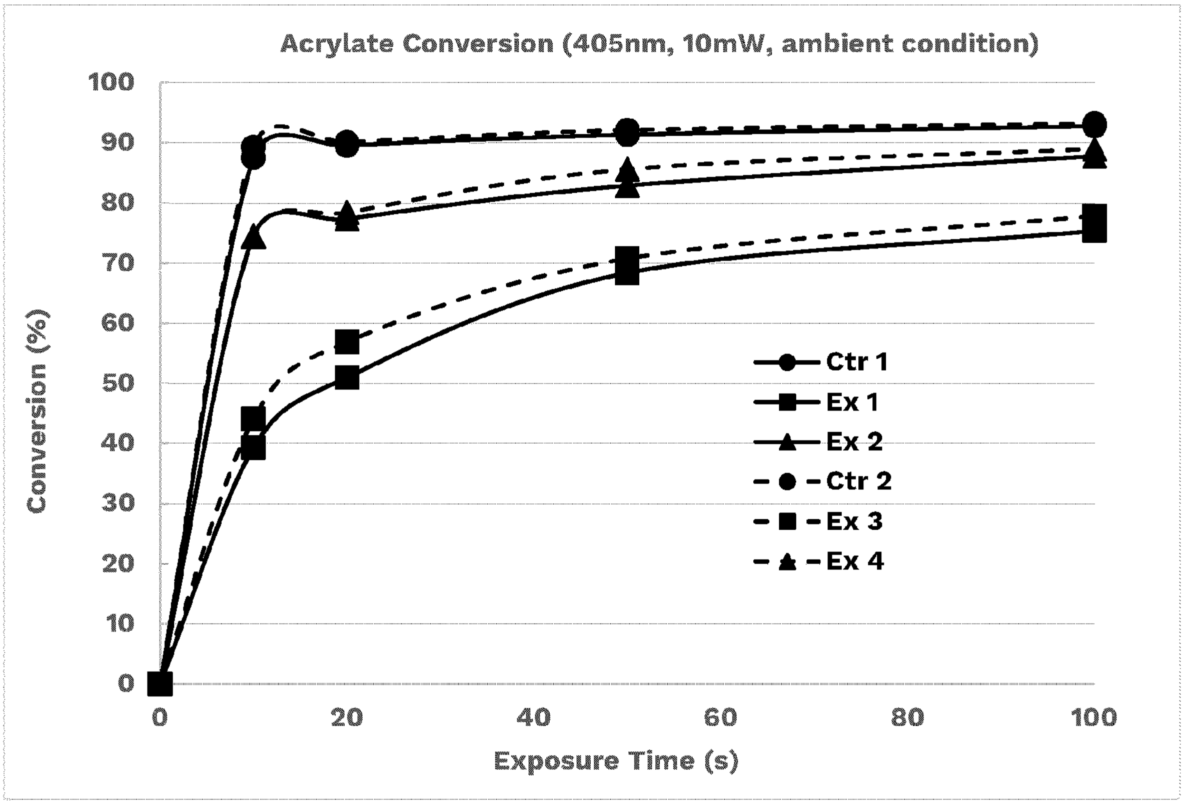


Figure 2A

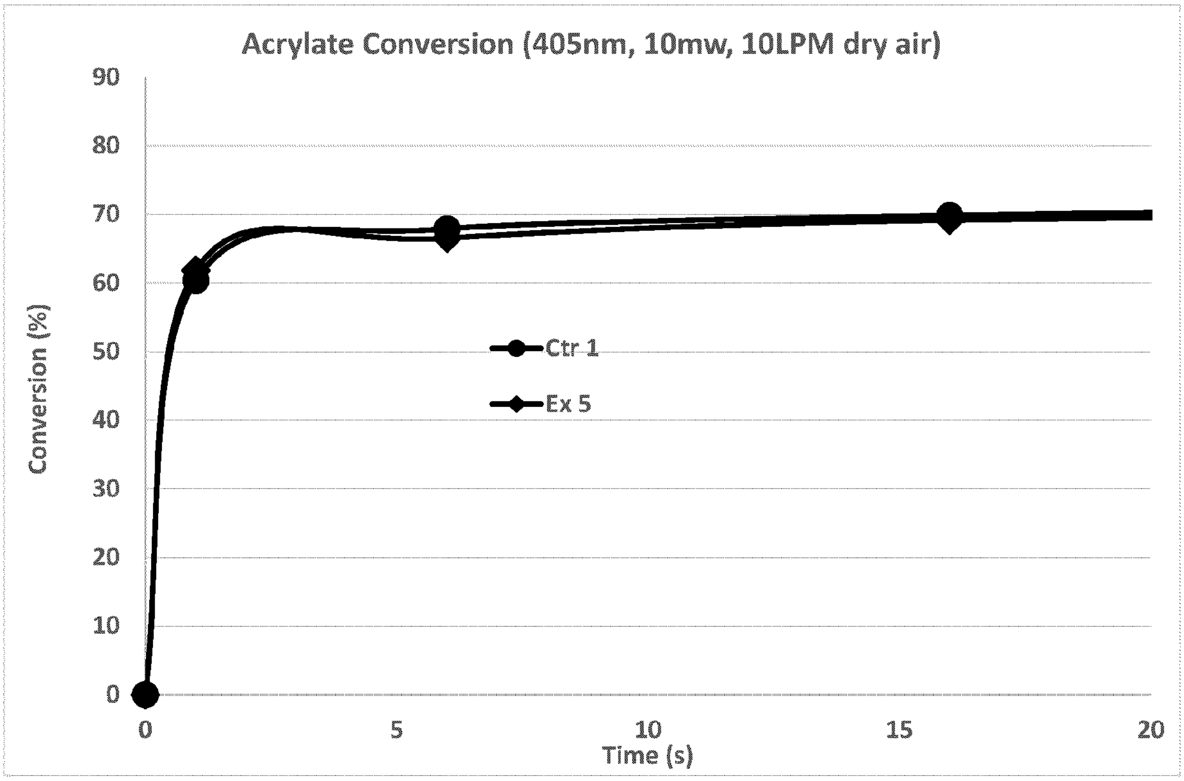


Figure 2B

Europäisches Patentamt
European Patent Office
Office européen des brevets

# EUROPEAN SEARCH REPORT

Application Number
EP 22 30 7068

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | EP 3 378 875 A1 (FUJIFILM CORP [JP]) 26 September 2018 (2018-09-26) * claims 1-20 * * examples 1-82 * * tables 1-6 * * paragraph [0113] * ----- | 1-22 | INV. B41M7/00 C08F2/00 C08K5/00 C09D11/38 G03F7/00 C07F9/53 C07F9/6509 C07F9/6533 |

TECHNICAL FIELDS SEARCHED (IPC)

C08F
C09D
B41M
G03F
C08K
C07F

The present search report has been drawn up for all claims

1

| Place of search | Date of completion of the search | Examiner |
|---|---|---|
| The Hague | 11 May 2023 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 30 7068

This annex lists the patent family members relating to the patent documents cited in the above-mentioned European search report. The members are as contained in the European Patent Office EDP file on
The European Patent Office is in no way liable for these particulars which are merely given for the purpose of information.

11-05-2023

| Patent document cited in search report | Publication date | Patent family member(s) | Publication date |
| --- | --- | --- | --- |
| EP 3378875 A1 | 26-09-2018 | CN 108350109 A | 31-07-2018 |
| | | EP 3378875 A1 | 26-09-2018 |
| | | JP 6563028 B2 | 21-08-2019 |
| | | JP WO2017086224 A1 | 11-10-2018 |
| | | US 2018244942 A1 | 30-08-2018 |
| | | US 2021147700 A1 | 20-05-2021 |
| | | WO 2017086224 A1 | 26-05-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3378875 A
- US 10590264 B
- EP 3149013 A
- WO 2014126830 A
- WO 2014126834 A
- WO 2014126837 A


### Non-patent literature cited in the description


- **HERBST, WILLY et al.** Industrial Organic Pigments, Production, Properties, Applications. Wiley - VCH, 2004
- **TUMBLESTON et al.** Continuous Liquid Interface Production of 3D Objects. *Science,* 20 March 2015, vol. 347 (6228), 1349-1352
- **P.F. JACOBS.** Fundamentals of stereolithography. *Proc. Solid Free. Fabr. Symp.,* 1992, 87-89